(19) Europäisches Patentamt

European Patent Office

Office européen des brevets

(11) **EP 1 401 031 A1**

(12) **EUROPEAN PATENT APPLICATION**
published in accordance with Art. 158(3) EPC

(43) Date of publication:
**24.03.2004 Bulletin 2004/13**

(51) Int Cl.7: **H01L 43/08**, H01L 43/12, G11B 5/39, G01R 33/09, H01F 10/16, H01F 10/30, H01F 10/32

(21) Application number: **02738796.8**

(22) Date of filing: **25.06.2002**

(86) International application number:
**PCT/JP2002/006344**

(87) International publication number:
**WO 2003/001614 (03.01.2003 Gazette 2003/01)**

(84) Designated Contracting States:
**AT BE CH CY DE DK ES FI FR GB GR IE IT LI LU MC NL PT SE TR**

(30) Priority: **26.06.2001 JP 2001192217**

(71) Applicant: **Matsushita Electric Industrial Co., Ltd. Kadoma-shi, Osaka-fu, 571-8501 (JP)**

(72) Inventors:
• **MATSUKAWA, Nozomu**
  **Nara-shi, Nara 631-0015 (JP)**
• **ODAGAWA, Akihiro**
  **Nara-shi, Nara 631-0032 (JP)**

• **SUGITA, Yasunari**
  **Osaka-shi, Osaka 538-0032 (JP)**
• **SATOMI, Mitsuo**
  **Katano-shi, Osaka 576-0052 (JP)**
• **KAWASHIMA, Yoshio**
  **Neyagawa-shi, Osaka 572-0055 (JP)**
• **HIRAMOTO, Masayoshi**
  **Ikoma-shi, Nara 630-0243 (JP)**

(74) Representative: **Tothill, John Paul**
  **Frank B. Dehn & Co.**
  **179 Queen Victoria Street**
  **London EC4V 4EL (GB)**

(54) **MAGNETORESISTIVE DEVICE AND ITS PRODUCING METHOD**

(57)    The present invention provides a magnetoresistive element that has excellent magnetoresistance characteristics over a conventional magnetoresistive element. The magnetoresistive element is produced by a method including heat treatment at 330°C or more and characterized in that the longest distance from a centerline (10) of a non-magnetic layer (4) to the interfaces between a pair of ferromagnetic layers (3, 5) and the non-magnetic layer (4) is not more than 10 nm. This element can be produced, e.g., by forming an underlying film on a substrate (1), heat-treating the underlying film at 400°C or more, decreasing surface roughness by irradiating the surface of the underlying film with an ion beam, and forming the ferromagnetic layers (3, 5) and the non-magnetic layer (4). The longest distance is reduced relatively even when $M^1$ (at least one element selected from Tc, Re, Ru, Os, Rh, Ir, Pd, Pt, Cu, Ag and Au) is present in the ferromagnetic layers (3, 5) in the range of 2 nm from the interfaces with the non-magnetic layer (4).

FIG. 3

## Description

<u>Technical Field</u>

The present invention relates to a magnetoresistive element used in a magnetic head for magnetic recording such as a hard disk drive (HDD) and a magnetic random access memory (MRAM), and to a method for manufacturing the magnetoresistive element.

<u>Background Art</u>

A multi-layer film with a basic structure of ferromagnetic layer/non-magnetic layer/ferromagnetic layer can provide a magnetoresistance effect when current flows across the non-magnetic layer. A spin tunnel effect can be obtained when using a tunnel insulating layer as the non-magnetic layer, and a CPP (current perpendicular to the plane) GMR effect can be obtained when using a conductive metal layer of Cu or the like as the non-magnetic layer. Both magnetoresistance effects (MR effects) depend on the magnitude of a relative angle between magnetizations of the ferromagnetic layers that sandwich the non-magnetic layer. The spin tunnel effect is derived from a change in transition probability of tunnel electrons flowing between the two magnetic layers with the relative angle of magnetizations. The CPP-GMR effect is derived from a change in spin-dependent scattering.

When a magnetoresistive element is used in a device, particularly in a magnetic memory such as MRAM, a monolithic structure combining the magnetoresistive element and a conventional Si semiconductor is necessary in view of the cost and the degree of integration.

To remove defects in wiring, a Si semiconductor process includes heat treatment at high temperatures. This heat treatment is performed, e.g., in hydrogen at about $400°C$ to $450°C$. However, the MR characteristics of the magnetoresistive element are degraded under heat treatment at $300°C$ to $350°C$ or more.

A method for incorporating the magnetoresistive element after formation of the semiconductor element also has been proposed. However, this method requires that wiring or the like for applying a magnetic field to the magnetoresistive element should be formed after producing the magnetoresistive element. Therefore, heat treatment is needed eventually, or a variation in wiring resistance is caused, degrading the reliability and stability of the element.

<u>Disclosure of the Invention</u>

A first magnetoresistive element of the present invention includes a substrate and a multi-layer film formed on the substrate. The multi-layer film includes a pair of ferromagnetic layers and a non-magnetic layer sandwiched between the pair of ferromagnetic layers. A resistance value depends on a relative angle formed by the magnetization directions of the pair of ferromagnetic layers. The magnetoresistive element is produced by a method including heat treatment of the substrate and the multi-layer film at $330°C$ or more, in some cases $350°C$ or more, and in other cases $400°C$ or more. In this magnetoresistive element, when a centerline is defined so as to divide the non-magnetic layer into equal parts in the thickness direction, the longest distance R1 from the centerline to the interfaces between the pair of ferromagnetic layers and the non-magnetic layer is not more than 20 nm, and preferably not more than 10 nm.

Here, the longest distance R1 is determined by defining ten centerlines, each of which has a length of 50 nm, measuring the distances from the ten centerlines to the interfaces so as to find the longest distance for each of the ten centerlines, taking eight values excluding the maximum and the minimum values from the ten longest distances, and calculating an average of the eight values.

The present invention also provides a method suitable for manufacturing the first magnetoresistive element. This method includes the following steps: forming a part of the multi-layer film other than the ferromagnetic layers and the non-magnetic layer on the substrate as an underlying film; heat-treating the underlying film at $400°C$ or more; decreasing the roughness of the surface of the underlying film by irradiating the surface with an ion beam; forming the remaining part of the multi-layer film including the ferromagnetic layers and the non-magnetic layer on the surface; and heat-treating the substrate and the multi-layer film at $330°C$ or more, in some cases $350°C$ or more, and in other cases $400°C$ or more.

A second magnetoresistive element of the present invention includes a substrate and a multi-layer film formed on the substrate. The multi-layer film includes a pair of ferromagnetic layers and a non-magnetic layer sandwiched between the pair of ferromagnetic layers. A resistance value depends on a relative angle formed by the magnetization directions of the pair of ferromagnetic layers. The magnetoresistive element is produced by a method including heat treatment of the substrate and the multi-layer film at $330°C$ or more, in some cases $350°C$ or more, and in other cases $400°C$ or more. In this magnetoresistive element, a composition in the range that extends by 2 nm from at least one of the interfaces between the pair of ferromagnetic layers and the non-magnetic layer in the direction opposite to the non-magnetic layer is expressed by

$$(Fe_xCo_yNi_z)_pM^1{}_qM^2{}_rM^3{}_sA_t$$

where $M^1$ is at least one element selected from the group consisting of Tc, Re, Ru, Os, Rh, Ir, Pd, Pt, Cu, Ag and Au, $M^2$ is at least one element selected from the group consisting of Mn and Cr, $M^3$ is at least one element selected from the group consisting of Ti, Zr, Hf, V, Nb, Ta, Mo, W, Al, Si, Ga, Ge, In and Sn, A is at least one element selected from the group consisting of B, C, N, O, P and S, and x, y, z, p, q, r, s, and t satisfy the following formulas: $0 \leq x \leq 100$, $0 \leq y \leq 100$, $0 \leq z \leq 100$, $x + y + z = 100$, $40 \leq p \leq 99.7$, $0.3 \leq q \leq 60$, $0 \leq r \leq 20$, $0 \leq s \leq 30$, $0 \leq t \leq 20$, and $p + q + r + s + t = 100$.

Brief Description of Drawings

FIGS. 1A to 1C are cross-sectional views illustrating the longest distance R1.

FIG. 2 is a plan view showing an embodiment of a magnetoresistive element of the present invention.

FIG. 3 is a cross-sectional view showing an embodiment of a magnetoresistive element of the present invention.

FIG. 4 is a cross-sectional view showing an example of the basic configuration of a magnetoresistive element of the present invention.

FIG. 5 is a cross-sectional view showing another example of the basic configuration of a magnetoresistive element of the present invention.

FIG. 6 is a cross-sectional view showing yet another example of the basic configuration of a magnetoresistive element of the present invention.

FIG. 7 is a cross-sectional view showing still another example of the basic configuration of a magnetoresistive element of the present invention.

FIG. 8 is a cross-sectional view showing still another example of the basic configuration of a magnetoresistive element of the present invention.

FIG. 9 is a cross-sectional view showing still another example of the basic configuration of a magnetoresistive element of the present invention.

FIG. 10 is a cross-sectional view showing still another example of the basic configuration of a magnetoresistive element of the present invention.

FIG. 11 is a cross-sectional view showing still another example of the basic configuration of a magnetoresistive element of the present invention.

FIGS. 12A to 12D are cross-sectional views each showing a portion of a magnetoresistive element produced in examples.

Embodiments of the Invention

The experiments proved that heat treatment at high temperatures degrades the flatness of the interfaces of a non-magnetic layer, and there is a correlation between the flatness and the MR characteristics of an element. When an underlying film is processed and/or the composition in the vicinity of either of the interfaces is adjusted so as to reduce roughness of the interfaces of the non-magnetic layer after heat treatment, the MR characteristics of the element can be improved.

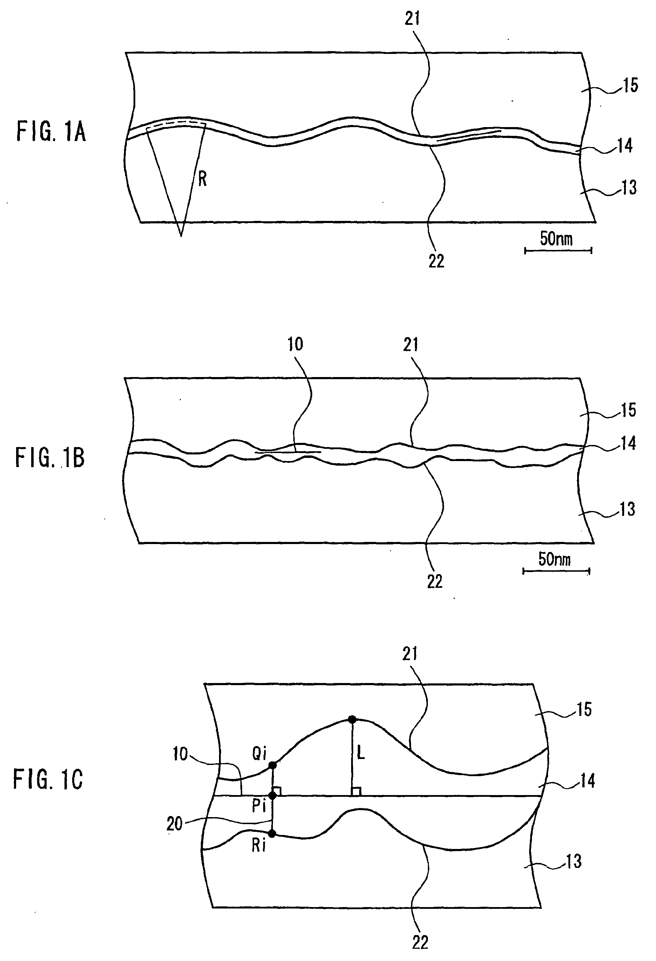

Among the types of "roughness" of the interfaces of the non-magnetic layer, the "roughness" that occurs in a relatively short period exerts a large effect on the MR characteristics. As shown in FIG. 1A, "waviness" may be generated on interfaces 21, 22 between ferromagnetic layers 13, 15 and a non-magnetic layer 14. The waviness can be expressed by a large radius of curvature R. However, the "waviness" as illustrated in FIG. 1A hardly affects the MR characteristics because of its long pitch. For more clear understanding of the relationship with the MR characteristics of an element, it is desirable to evaluate the state of the interfaces in the range of about 50 nm.

As shown in FIG. 1B, this specification defines a centerline 10 so as to divide the non-magnetic layer 14 into equal parts in the thickness direction and uses this centerline 10 as a reference line to understand the relationship with the MR characteristics. This method makes it possible to evaluate the state of the two interfaces 21, 22 at the same time. Specifically, the centerline 10 can be defined by a least-square method. As enlarged in FIG. 1C, this method takes into account a distance PiQi between a point Pi on the centerline 10 and an intersection point Qi of a normal 20 to the centerline 10 that goes through the point Pi and the interface 21, and a distance PiRi between the point Pi and an intersection point Ri of the normal 20 and the interface 22. The centerline 10 is defined so as to minimize $\int (PiQi)^2 dx$ under the condition that the sum of the square of PiQi is equal to that of PiRi ($\int (PiQi)^2 dx = \int (PiRi)^2 dx$).

By defining the centerline 10 in this manner, the longest distance L between the centerline 10 and the interfaces 21, 22 can be determined in accordance with the centerline 10. To eliminate measurement errors as much as possible, this specification determines ten longest distances L for each of ten arbitrarily defined centerlines, takes eight distances L, i.e., excluding the maximum and the minimum values ($L_{max}$, $L_{min}$), calculates an average of the eight distances L, and uses this average as a measure R1 of evaluation.

This measurement may be performed based on a cross-sectional image obtained with a transmission electron microscope (TEM). Simple evaluation also can be performed in the following manner: a model film is prepared by stopping the film forming process after the non-magnetic layer is deposited; the model film is subjected to in-situ heat treatment in the atmosphere of a reduced pressure; and the surface shape is observed with an atomic force microscope while maintaining the state of the film.

So far as we studied, the evaluation with R1 is most suitable for understanding the relationship between the MR characteristics and the flatness of the non-magnetic layer. However, this relation may be explained better by the evaluation based on the minimum radius of curvature of the interfaces. At present, there is a limit to controlling the thickness of a sample for TEM observation. Therefore, except for a portion having a sufficiently small thickness, the interfaces tend to be overlapped in the thickness direction. Thus, it is impossible to clearly specify the minimum radius of curvature of a sample having a particularly small minimum radius of curvature. Depending on the progress in technique of producing samples for TEM observation, however, more appropriate evaluation criteria may be provided. For example, the minimum radius of curvature is measured at ten portions in the range of 50 to 100 nm, and eight values excluding the maximum and the minimum values are taken to calculate an average in the same manner as described above.

The flatness of the non-magnetic layer is affected by the state of an underlying film on which a multi-layer structure is formed. In the multi-layer structure, the non-magnetic layer is positioned between the ferromagnetic layers (ferromagnetic layer/non-magnetic layer/ferromagnetic layer). When the multi-layer film further includes lower and upper electrodes that sandwich a pair of ferromagnetic layers, the underlying film includes the lower electrode. The lower electrode often has a relatively large thickness, e.g., about 100 nm to 2 μm. Therefore, the thickness of the underlying film, which has at least a portion formed with the lower electrode, is increased. The surface flatness of the underlying film with an increased thickness and the distortion in layers tend to affect the flatness of the non-magnetic layer to be formed on the underlying film.

The lower electrode is not limited to a single-layer film and may be a multi-layer film formed with a plurality of conductive films.

It is preferable that the underlying film is heat-treated at 400°C or more and preferably 500°C or less. This heat treatment can reduce the distortion of the underlying film. The heat treatment is not particularly limited and may be performed in the atmosphere of a reduced pressure or inert gas such as Ar.

The surface roughness of the underlying film can be suppressed by ion-milling the surface at a low angle or irradiating it with a gas cluster ion beam. The ion beam irradiation may be performed so that the angle of incidence of the ion beam at the surface of the underlying film is 5° to 25°. Here, the angle of incidence is 90° when the ion beam is oriented perpendicular to the surface and is 0° when it is oriented parallel to the surface.

Considering, e.g., the growth of crystal grains due to heat treatment, the process of decreasing roughness by ion beam irradiation should be performed after the heat treatment. The surface irradiated with the ion beam preferably is a plane on which the ferromagnetic layer is formed directly. However, it can be a plane for supporting the ferromagnetic layer via other layers.

The use of a single-crystal substrate makes it easy to produce an element having a low R1. There are some cases where an element having a small R1 can be obtained, e.g., by irradiating the lower electrode layer with an ion beam even if the single-crystal substrate is not used.

The flatness of the non-magnetic layer is affected also by the composition of the ferromagnetic layers in the vicinity of either of the interfaces of the non-magnetic layer.

Specifically, in the range of 2 nm, preferably in the range of 4 nm, from at least one of the interfaces between a pair of ferromagnetic layers and the non-magnetic layer, the composition of the ferromagnetic layer in contact with the at least one of the interfaces is expressed by

$$(Fe_xCo_yNi_z)_pM^1{}_qM^2{}_rM^3{}_sA_t$$

where $M^1$ is at least one element selected from the group consisting of Tc, Re, Ru, Os, Rh, Ir, Pd, Pt, Cu, Ag and Au, preferably Ir, Pd and Pt, $M^2$ is at least one element selected from the group consisting of Mn and Cr, $M^3$ is at least one element selected from the group consisting of Ti, Zr, Hf, V, Nb, Ta, Mo, W, Al, Si, Ga, Ge, In and Sn, and A is at least one element selected from the group consisting of B, C, N, O, P and S.

Also, x, y, z, p, q, r, s, and t satisfy $0 \leq x \leq 100$, $0 \leq y \leq 100$, $0 \leq z \leq 100$, $x + y + z = 100$, $40 \leq p \leq 99.7$, $0.3 \leq q \leq 60$, $0 \leq r \leq 20$, $0 \leq s \leq 30$, $0 \leq t \leq 20$, and $p + q + r + s + t = 100$.

In the above formulas, p, q, and r may satisfy $p + q + r = 100$ (s = 0, t = 0), and also p and q may satisfy p + q = 100 (s = 0, t = 0, r = 0).

When the element $M^1$ is included in the vicinity of either of the interfaces with the non-magnetic layer, a small R1 can be achieved easily. There are some cases where the MR characteristics after heat treatment at 330°C or more are even more improved than those before the heat treatment by addition of the element $M^1$. The effects of the element $M^1$ are not clarified fully at present. Since these elements have a catalytic effect on oxygen or the like, the state of bonding between non-magnetic compounds that constitute the non-magnetic layer is enhanced, which may lead to an improvement in barrier characteristics.

When the content of the element $M^1$ is more than 60 at% (q > 60), the function as a ferromagnetic material in the ferromagnetic layer is reduced, thus degrading the MR characteristics. The preferred content of the element $M^1$ is 3 to 30 at% ($3 \leq q \leq 30$).

The element $M^2$ is oxidized easily and becomes an oxide having magnetism after oxidation. The element $M^2$ may be used for an antiferromagnetic layer. When the element $M^2$ is diffused to the vicinity of either of the interfaces with the non-magnetic layer by heat treatment, it forms an oxide in the vicinity of either of the interfaces. This may cause degradation of the characteristics. However, when the element $M^2$ is not more than 20 at% ($r \leq 20$) and is present with the element $M^1$, the MR characteristics are not degraded significantly. In particular, when the content of the element $M^2$ is smaller than that of the element $M^1$ (q > r), there are some cases where the MR characteristics are improved rather than degraded. When added with the element $M^1$ (q > 0, r > 0), the element $M^2$ may contribute to the improvement in MR characteristics after heat treatment.

When the magnetoresistive element is used in a device, the magnetic characteristics, such as soft magnetic properties and high-frequency properties, become more important than the MR characteristics. In this case, the element $M^3$ and the element A should be added appropriately within the above range.

The ratio of Fe, Co, and Ni is not particularly limited, as long as the total content is 40 to 99.7 at%. However, in the presence of all the three elements, it is preferable to establish 0 < x 100, 0 < y < 100, $0 < z \leq 90$ (particularly, $0 < z \leq 65$). In the case of a two-component system of Fe and Co (z = 0), it is preferable to establish $5 \leq x < 100$ and $0 < y \leq 95$. In the case of a two-component system of Fe and Ni (y = 0), it is preferable to establish $5 \leq x < 100$ and $0 < z \leq 95$.

To analyze the composition, a local composition analysis using, e.g., TEM may be preformed. A model film obtained by stopping the film forming process after the non-magnetic layer is deposited may be used as the ferromagnetic layer located below the non-magnetic layer. In this case, the model film is heat-treated at a predetermined temperature, then the non-magnetic layer is removed appropriately by milling, and thus the composition is measured with surface analysis such as Auger electron spectroscopy and XPS composition analysis.

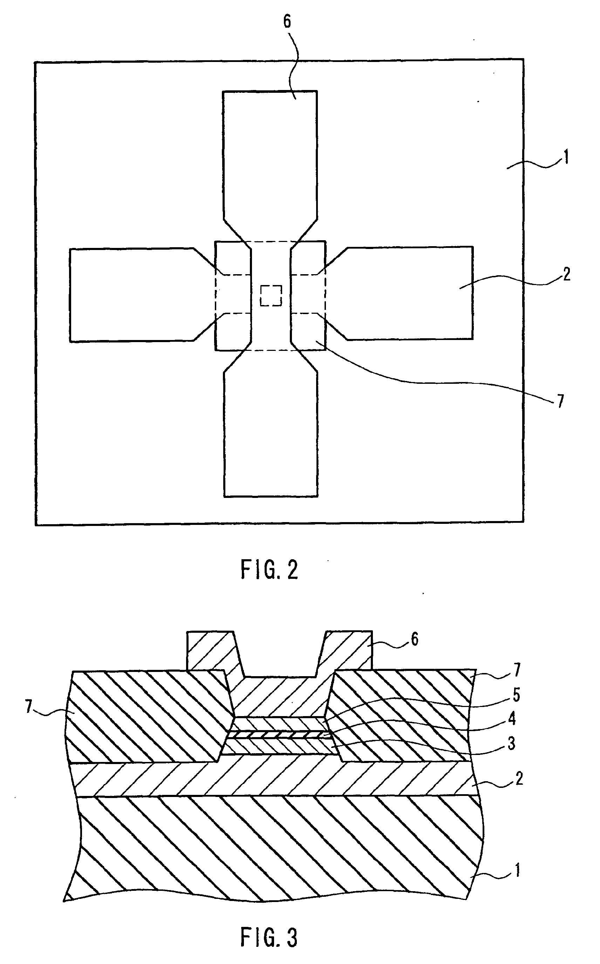

FIGS. 2 and 3 show the basic configuration of a magnetoresistive element. This element includes a lower electrode 2, a first ferromagnetic layer 3, a non-magnetic layer 4, a second ferromagnetic layer 5, and an upper electrode 6 in this order on a substrate 1. A pair of electrodes 2, 6 that sandwich a laminate of ferromagnetic layer/non-magnetic layer/ferromagnetic layer are isolated by an interlayer insulating film 7.

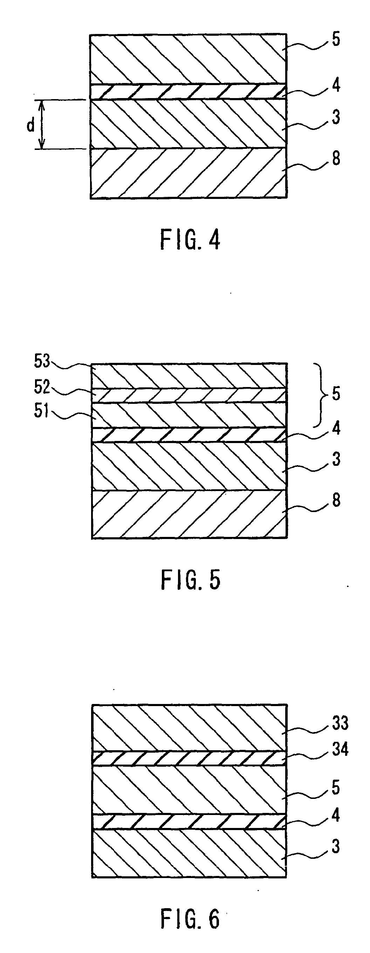

The film configuration of the magnetoresistive element is not limited to the above, and other layers can be added further as shown in FIGS. 4 to 11. If necessary, lower and upper electrodes are arranged respectively below and above the laminate shown, though these drawings omit both electrodes. Other layers that are not illustrated in the drawings (e.g., an underlying layer and a protective layer) also can be added.

As shown in FIG. 4, an antiferromagnetic layer 8 is formed in contact with a ferromagnetic layer 3. In this element, the ferromagnetic layer 3 shows unidirectional anisotropy due to an exchange bias magnetic field with the antiferromagnetic layer 8, and thus the reversing magnetic field becomes larger. By adding the antiferromagnetic layer 8, the element becomes a spin-valve type element, in which the ferromagnetic layer 3 functions as a pinned magnetic layer and the ferromagnetic layer 5 functions as a free magnetic layer.

As shown in FIG. 5, a laminated ferrimagnetic material may be used as a free magnetic layer 5. The laminated ferrimagnetic material includes a pair of ferromagnetic layers 51, 53 and a non-magnetic metal film 52 sandwiched between the ferromagnetic layers.

As shown in FIG. 6, the element may be formed as a dual spin-valve type element. In this element, two pinned magnetic layers 3, 33 are arranged so as to sandwich a free magnetic layer 5, and non-magnetic layers 4, 34 are located between the free magnetic layer 5 and the pinned magnetic layers 3, 33.

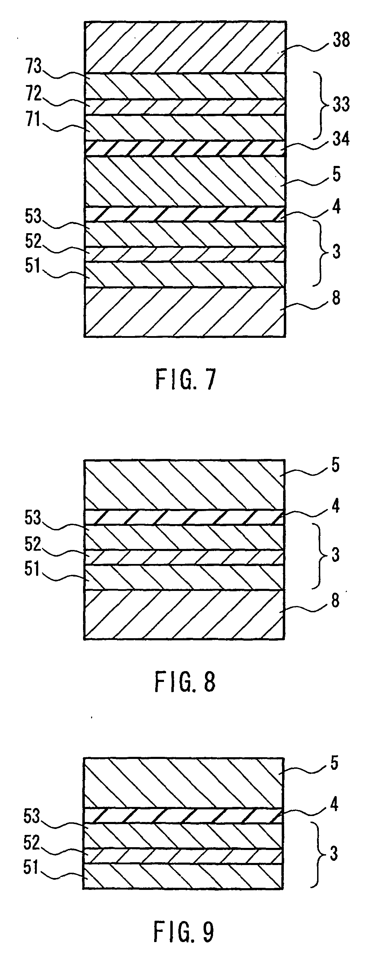

As shown in FIG. 7, laminated ferrimagnetic materials 51, 52, 53; 71, 72, 73 may be used as pinned magnetic layers 3, 33 in the dual spin-valve type element. In this element, antiferromagnetic layers 8, 38 are arranged in contact with the pinned magnetic layers 3, 33.

As shown in FIG. 8, a laminated ferrimagnetic material may be used as the pinned magnetic layer 3 of the element in FIG. 4. The laminated ferrimagnetic material includes a pair of ferromagnetic layers 51, 53 and a non-magnetic metal film 52 sandwiched between the ferromagnetic layers.

As shown in FIG. 9, the element may be formed as a differential coercive force type element that does not include an antiferromagnetic layer. In this element, a laminated ferrimagnetic material 51, 52, 53 is used as a pinned magnetic layer 3.

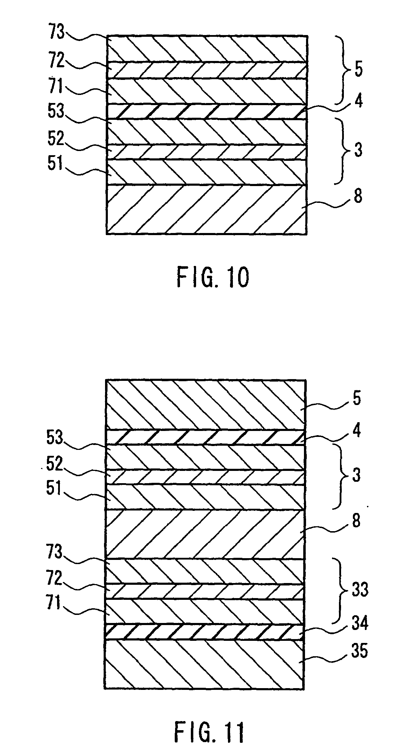

As shown in FIG. 10, a laminated ferrimagnetic material 71, 72, 73 may be used as the free magnetic layer 5 of the element in FIG. 8.

As shown in FIG. 11, a pinned magnetic layer 3(33), a non-magnetic layer 4(34), and a free magnetic layer 5(35) may be arranged on both sides of an antiferromagnetic layer 8. In this element, a laminated ferrimagnetic material 51(71), 52(72), 53(73) is used as the pinned magnetic layer 3(33).

As the substrate 1, a plate with an insulated surface, e.g., a Si substrate obtained by thermal oxidation, a quartz substrate, and a sapphire substrate can be used. Since the substrate surface should be smoother, a smoothing process, e.g., chemomechanical polishing (CMP) may be performed as needed. A switching element such as a MOS transistor may be produced on the substrate surface beforehand. In this case, it is preferable that an insulating layer is formed on the switching element, and then contact holes are provided in the insulating layer to make an electrical connection between the switching element and the magnetoresistive element to be formed on the top.

As the antiferromagnetic layer 8, a Mn-containing antiferromagnetic material or a Cr-containing material can be used. Examples of the Mn-containing antiferromagnetic material include PtMn, PdPtMn, FeMn, IrMn, and NiMn. The element $M^2$ may diffuse from these antiferromagnetic materials by heat treatment. Therefore, considering the preferred content (20 at% or less) of the element $M^2$ in the vicinity of the interface with the non-magnetic layer, an appropriate distance between the non-magnetic layer and the antiferromagnetic layer (indicated by d in FIG. 4) is 3nm to 50nm.

The conventionally known various materials also can be used for other layers of the multi-layer film without any limitation.

For example, a material with conductive or insulating properties can be used as the non-magnetic layer 2 in accordance with the type of the element. A conductive non-magnetic layer used in a CPP-GMR element can be made, e.g., of Cu, Au, Ag, Ru, Cr, and an alloy of these elements. The preferred thickness of the non-magnetic layer in the CPP-GMR element is 1 to 10 nm. The material for a tunnel insulating layer used in a TMR element is not particularly limited as well, and various insulators or semiconductors can be used. An oxide, a nitride, or an oxynitride of Al is suitable for the tunnel insulating layer. The preferred thickness of the non-magnetic layer in the TMR element is 0.8 to 3 nm.

Examples of a material for the non-magnetic film that constitutes the laminated ferrimagnetic material include Cr, Cu, Ag, Au, Ru, Ir, Re, Os, and an alloy and an oxide of these elements. The preferred thickness of this non-magnetic film is 0.2 to 1.2 nm, though it varies depending on the material.

A method for forming each layer of the multi-layer film is not particularly limited, and a thin film producing method may be employed, e.g., sputtering, molecular beam epitaxy (MBE), chemical vapor deposition (CVD), pulse laser deposition, and ion beam sputtering. As a micro-processing method, well-known micro-processing methods, such as photolithography using a contact mask or stepper, EB lithography and focused ion beam (FIB) processing, may be employed.

For etching, well-known methods, such as ion milling and reactive ion etching (RIE), may be employed.

Even with a conventional magnetoresistive element, the MR characteristics after heat treatment sometimes is improved if the temperature is up to about 300°C. However, the MR characteristics are degraded after heat treatment at 300 to 350°C or more. A magnetoresistive element of the present invention is superior to the conventional element in characteristics after heat treatment at 330°C or more. However, such a difference in characteristics between the two elements is even more conspicuous with increasing heat treatment temperatures to 350°C or more, and 400°C or more.

Considering that the element is combined with a Si semiconductor process, the heat treatment temperature should be about 400°C. The present invention can provide an element that exhibits practical characteristics even for heat treatment at 400°C.

As described above, the present invention can provide a magnetoresistive element in which the MR characteristics are improved by heat treatment at 330°C or more and also 350°C or more, compared with the MR characteristics without heat treatment.

The reason for an improvement in MR characteristics by heat treatment is not clarified fully. However, the heat treatment may improve the barrier characteristics of the non-magnetic layer. This is because favorable MR characteristics can be obtained generally by reducing defects in a barrier or increasing the height of the barrier. Another possible reason is a change in chemical bond at the interfaces between the non-magnetic layer and the ferromagnetic layers. In either case, it is very important to achieve the effect of improving the MR characteristics even after heat treatment at 300°C or more, considering the application of a magnetoresistive element to a device.

A composition that forms a single phase at heat treatment temperatures is suitable for the composition of the ferromagnetic layer in the vicinity of the interface.

An alloy having the same composition as that at the interfaces was molded by general molding, which then was heat-treated in inert gas at 350°C to 450°C for 24 hours. This alloy was cut substantially in half, and then the cutting planes were polished and etched. The state of particles on the surface was observed with a metallurgical microscope and an electron microscope. Moreover, the composition distribution was evaluated by the above composition analysis or EDX. The result confirmed that when a composition showed a nonuniform phase at heat treatment temperatures used, there was a high probability of degradation in MR characteristics after heat treatment for a long time.

A bulk material differs from a thin film in phase stability depending on the effect of the interfaces. However, it is preferable that the composition of the ferromagnetic layers in the vicinity of each of the interfaces, specifically the composition given by the above equation, forms a single phase at predetermined heat treatment temperatures of 330°C or more.

Examples

Example 1-1

A Pt film having a thickness of 100 nm was evaporated on a single-crystal MgO (100) substrate as a lower electrode with MBE, which then was heat-treated in vacuum at 400°C for 3 hours. The substrate was irradiated with Ar ions at an incidence angle of 10° to 15° by using an ion gun, thus cleaning the surface and decreasing the roughness on the surface.

Next, a NiFe film having a thickness of 8 nm was formed on the Pt film with RF magnetron sputtering. Further, an Al film formed by DC magnetron sputtering was oxidized by introducing pure oxygen into a vacuum chamber so as to produce an AlOx barrier. Subsequently, a $Fe_{50}Co_{50}$ film having a thickness of 10 nm was formed by RF magnetron sputtering. Thus, a laminate of ferromagnetic layer/non-magnetic layer/ferromagnetic layer (NiFe(8)/AlOx(1.2)/ $Fe_{50}Co_{50}$(10)) was formed on the lower electrode. Here, the figures in parentheses denote the film thickness in nm (the film thickness is expressed in the same manner in the following).

With patterning by photolithography and ion milling etching, a plurality of magnetoresistive elements having the same configuration as that shown in FIGS. 1 and 2 were produced. A Cu film was formed as an upper electrode with DC magnetron sputtering, and a $SiO_2$ film was formed as an interlayer insulating film with ion beam sputtering.

The MR ratio of each of the magnetoresistive elements was measured by measuring a resistance with a DC four-terminal method while applying a magnetic field. The MR ratio was measured after each of the heat treatments at 260°C for 1 hour, at 300°C for 1 hour, at 350°C for 1 hour, and at 400°C for 1 hour. After measurement of the MR ratio, R1 was measured for each element. Table 1A shows the results.

TABLE 1A

| No heat treatment | R1 | R1≤3 | 3<R1≤10 | 10<R1≤20 | 20<R1 |
|---|---|---|---|---|---|
| | MR(%) (average/max) | 12/13.5 | 11.9/13.2 | 10.5/12.8 | 8.2/- |
| | Number of corresponding samples | 80 | 12 | 6 | 1 |
| 260°C | R1 | R1≤3 | 3<R1≤10 | 10<R1≤20 | 20<R1 |
| | MR(%) (average/max) | 14.1/15.2 | 13.8/14.8 | 12.5/13.2 | 8.5/9.2 |
| | Number of corresponding samples | 82 | 12 | 3 | 3 |
| 300°C | R1 | R1≤3 | 3<R1≤10 | 10<R1≤20 | 20<R1 |
| | MR(%) (average/max) | 15.8/16.0 | 15.5/15.9 | 14.5/14.9 | 2.1/9.2 |
| | Number of corresponding samples | 62 | 15 | 9 | 12 |
| 350°C | R1 | R1≤3 | 3<R1≤10 | 10<R1≤20 | 20<R1 |
| | MR(%) (average/max) | 16.2/16.4 | 15.7/16.0 | 14.5/14.9 | 1.9/5.2 |
| | Number of corresponding samples | 17 | 14 | 26 | 33 |
| 400°C | R1 | R1≤3 | 3<R1≤10 | 10<R1≤20 | 20<R1 |
| | MR(%) (average/max) | 16.4/16.6 | 15.9/16.1 | 14.5/14.9 | 1.8/2.3 |
| | Number of corresponding samples | 3 | 6 | 15 | 51 |
| The total number of samples varies depending on a heat treatment temperature. | | | | | |

Example 1-2

A plurality of magnetoresistive elements were produced in the same manner as Example 1-1 except that a laminate of a NiFe film having a thickness of 6 nm and a $Fe_{80}Pt_{20}$ film having a thickness of 2 nm was used instead of the NiFe film. These elements included a laminate expressed by $NiFe(6)/Fe_{80}Pt_{20}(2)/AlOx(1.2)/Fe_{50}Co_{50}(10)$. The MR ratio and R1 were measured for each magnetoresistive element in the same manner as the above. Table 1B shows the results.

TABLE 1B

| No heat treatment | R1 | $R1{\leq}3$ | $3{<}R1{\leq}10$ | $10{<}R1{\leq}20$ | $20{<}R1$ |
|---|---|---|---|---|---|
| | MR(%) (average/max) | 21.1/25.1 | 20.2/22.7 | 15.2/- | -/- |
| | Number of corresponding samples | 87 | 12 | 1 | 0 |
| 260°C | R1 | $R1{\leq}3$ | $3{<}R1{\leq}10$ | $10{<}R1{\leq}20$ | $20{<}R1$ |
| | MR(%) (average/max) | 23.4/26.3 | 21.9/24.6 | 14.9/15.3 | -/- |
| | Number of corresponding samples | 87 | 10 | 3 | 0 |
| 300°C | R1 | $R1{\leq}3$ | $3{<}R1{\leq}10$ | $10{<}R1{\leq}20$ | $20{<}R1$ |
| | MR(%) (average/max) | 24.6/26.5 | 23.2/25.2 | 14.5/15.1 | 6.8/- |
| | Number of corresponding samples | 87 | 8 | 2 | 1 |
| 350°C | R1 | $R1{\leq}3$ | $3{<}R1{\leq}10$ | $10{<}R1{\leq}20$ | $20{<}R1$ |
| | MR(%) (average/max) | 25.9/26.4 | 24.8/25.3 | 14.7/14.9 | 5.9/- |
| | Number of corresponding samples | 85 | 5 | 2 | 1 |
| 400°C | R1 | $R1{\leq}3$ | $3{<}R1{\leq}10$ | $10{<}R1{\leq}20$ | $20{<}R1$ |
| | MR(%) (average/max) | 26.6/26.9 | 25.1/25.2 | 14.1/14.6 | 6.2/6.6 |
| | Number of corresponding samples | 80 | 4 | 3 | 2 |
| The total number of samples varies depending on a heat treatment temperature. | | | | | |

Comparative example

For comparison, a plurality of magnetoresistive elements were produced in the same manner as Example 1-1 except for the heat treatment of electrodes and the irradiation with an ion gun. The MR ratio and R1 were measured for each magnetoresistive element in the same manner as the above. Table 1C shows the results.

TABLE 1C

| No heat treatment | R1 | $R1{\leq}3$ | $3{<}R1{\leq}10$ | $10{<}R1{\leq}20$ | $20{<}R1$ |
|---|---|---|---|---|---|
| | MR(%) (average/max) | -/- | 11.8/12.5 | 10.4/12.6 | 8.1/9.1 |
| | Number of corresponding samples | 0 | 3 | 35 | 62 |
| 260°C | R1 | $R1{\leq}3$ | $3{<}R1{\leq}10$ | $10{<}R1{\leq}20$ | $20{<}R1$ |
| | MR(%) (average/max) | -/- | 13.8/14.1 | 12.2/13.2 | 8.3/9.0 |
| | Number of corresponding samples | 0 | 2 | 25 | 73 |

TABLE 1C   (continued)

| 300°C | R1 | R1≤3 | 3<R1≤10 | 10<R1≤20 | 20<R1 |
|---|---|---|---|---|---|
| | MR(%) (average/max) | -/- | -/- | 14.1/14.7 | 1.9/7.3 |
| | Number of corresponding samples | 0 | 0 | 5 | 91 |
| 350°C | R1 | R1≤3 | 3<R1≤10 | 10<R1≤20 | 20<R1 |
| | MR(%) (average/max) | -/- | -/- | -/- | 1.7/4.8 |
| | Number of corresponding samples | 0 | 0 | 0 | 89 |
| 400°C | R1 | R1≤3 | 3<R1≤10 | 10<R1≤20 | 20<R1 |
| | MR(%) (average/max) | -/- | -/- | -/- | 1.2/1.9 |
| | Number of corresponding samples | 0 | 0 | 0 | 75 |
| The total number of samples varies depending on a heat treatment temperature. | | | | | |

In a conventional method (Table 1C) that did not include the surface treatment of a lower electrode, all values of R1 were more than 20 nm after heat treatment at temperatures in excess of 300°C.

Table 1B shows that the presence of Pt in the magnetic layers in the vicinity of the non-magnetic layer can suppress an increase in R1 caused by heat treatment as compared with Table 1A, in which Pt is not added. Even if R1 is in the same range, the MR ratio can be improved by the addition of Pt.

Example 1-3

A plurality of magnetoresistive elements were produced in the same manner as Example 1-1 except that a Si substrate obtained by thermal oxidation was used as a substrate, a Cu film having a thickness of 100 nm and a Ta film having a thickness of 5 nm were used as a lower electrode, and NiFe(8)/$Co_{75}Fe_{25}$(2)/BN(2.0)/$Fe_{50}Co_{50}$(5) was used as a laminate of ferromagnetic layer/non-magnetic layer/ferromagnetic layer. Both Cu and Ta films were formed by RF magnetron sputtering, the NiFe film was formed by DC magnetron sputtering, the $Co_{75}Fe_{25}$ film was formed by RF magnetron sputtering, the BN film was formed by reactive evaporation, and the $Fe_{50}Co_{50}$ film was formed by RF magnetron sputtering.

The MR ratio and R1 were measured for each magnetoresistive element in the same manner as the above. Table 2 shows the results.

TABLE 2

| No heat treatment | R1 | R1≤3 | 3<R1≤10 | 10<R1≤20 | 20<R1 |
|---|---|---|---|---|---|
| | MR(%) (average/max) | 18.1/20.0 | 17.9/19.5 | 15.5/17.8 | 10.2/13.2 |
| | Number of corresponding samples | 67 | 22 | 7 | 4 |
| 260°C | R1 | R1≤3 | 3<R1≤10 | 10<R1≤20 | 20<R1 |
| | MR(%) (average/max) | 18.2/20.1 | 18.0/19.7 | 16.5/17.9 | 12.1/13.5 |
| | Number of corresponding samples | 69 | 21 | 5 | 5 |
| 300°C | R1 | R1≤3 | 3<R1≤10 | 10<R1≤20 | 20<R1 |
| | MR(%) (average/max) | 19.5/20.3 | 19.1/19.9 | 17.5/18.8 | 11.8/13.5 |
| | Number of corresponding samples | 36 | 36 | 9 | 15 |

TABLE 2 (continued)

| 350°C | R1 | R1≤3 | 3<R1≤10 | 10<R1≤20 | 20<R1 |
|---|---|---|---|---|---|
| | MR(%) (average/max) | 19.7/20.5 | 19.2/20.2 | 17.5/18.8 | 5.8/11.8 |
| | Number of corresponding samples | 15 | 16 | 21 | 36 |
| 400°C | R1 | R1≤3 | 3<R1≤10 | 10<R1≤20 | 20<R1 |
| | MR(%) (average/max) | 19.9/20.6 | 19.2/20.0 | 16.8/18.5 | 2.8/5.6 |
| | Number of corresponding samples | 1 | 8 | 13 | 52 |
| The total number of samples varies depending on a heat treatment temperature. | | | | | |

Example 1-4

A plurality of magnetoresistive elements were produced in the same manner as Example 1-1 except that a Si substrate obtained by thermal oxidation was used as a substrate, a Cu film having a thickness of 200 nm and a TiN film having a thickness of 3 nm were used as a lower electrode, and $NiFe(8)/Co_{75}Fe_{25}(2)/AlOx(2.0)/Fe_{50}Co_{50}(5)$ was used as a laminate of ferromagnetic layer/non-magnetic layer/ferromagnetic layer. The AlOx film was oxidized by plasma oxidation.

The MR ratio and R1 were measured for each magnetoresistive element in the same manner as the above. Table 3 shows the results.

TABLE 3

| No heat treatment | R1 | R1≤3 | 3<R1≤10 | 10<R1≤20 | 20<R1 |
|---|---|---|---|---|---|
| | MR(%) (average/max) | 22.1/24.2 | 21.5/24.1 | 20.1/22.8 | 15.5/17.9 |
| | Number of corresponding samples | 66 | 23 | 6 | 5 |
| 260°C | R1 | R1≤3 | 3<R1≤10 | 10<R1≤20 | 20<R1 |
| | MR(%) (average/max) | 23.1/24.5 | 22.8/24.3 | 21.8/23.0 | 16.0/17.2 |
| | Number of corresponding samples | 67 | 20 | 6 | 7 |
| 300°C | R1 | R1≤3 | 3<R1≤10 | 10<R1≤20 | 20<R1 |
| | MR(%) (average/max) | 24.1/24.7 | 23.5/24.3 | 22.0/22.8 | 12.5/15.1 |
| | Number of corresponding samples | 31 | 34 | 11 | 18 |
| 350°C | R1 | R1≤3 | 3<R1≤10 | 10<R1≤20 | 20<R1 |
| | MR(%) (average/max) | 24.3/24.7 | 23.8/24.1 | 21.8/22.2 | 3.2/8.1 |
| | Number of corresponding samples | 3 | 7 | 14 | 58 |
| 400°C | R1 | R1≤3 | 3<R1≤10 | 10<R1≤20 | 20<R1 |
| | MR(%) (average/max) | -/- | 23.8/23.9 | 21.6/21.6 | 2.6/3.6 |
| | Number of corresponding samples | 0 | 2 | 3 | 61 |
| The total number of samples varies depending on a heat treatment temperature. | | | | | |

Basically the same results were obtained in both cases where $Co_{70}Fe_{30}$, $Co_{90}Fe_{10}$, $Ni_{60}Fe_{40}$, sendust, $Fe_{50}Co_{25}Ni_{25}$, $Co_{70}Fe_5Si_{15}B_{10}$, or the like was used as the ferromagnetic layers in the form of a single-layer or a multi-layer and where an $Al_2O_3$ film formed by reactive evaporation, an AlN film formed by plasma reaction, and a film of TaO, TaN or AlN formed by natural oxidation or nitridation was used as the non-magnetic layer.

Basically the same results also were obtained from the magnetoresistive elements having the configurations as shown in FIGS. 4 to 11. For the element that included a plurality of junctions (tunnel junctions) due to the non-magnetic layer, the maximum R1 was used as R1 of the element. In these elements, CrMnPt (thickness: 20 to 30 nm), $Tb_{25}Co_{75}$ (10 to 20 nm), PtMn (20 to 30 nm), IrMn (10 to 30 nm), or PdPtMn (15 to 30 nm) was used as the antiferromagnetic layer, and Ru (thickness: 0.7 to 0.9 nm), Ir (0.3 to 0.5 nm), or Rh (0.4 to 0.9 nm) was used as the non-magnetic metal film.

Example 2

Example 1 confirmed that the MR ratio changed with the composition of the magnetic layers in the vicinity of the non-magnetic layer. In this example, the relationship between the composition of the ferromagnetic layer and the MR ratio was measured by using magnetoresistive elements that were produced by the same methods of film forming and processing as those in Example 1.

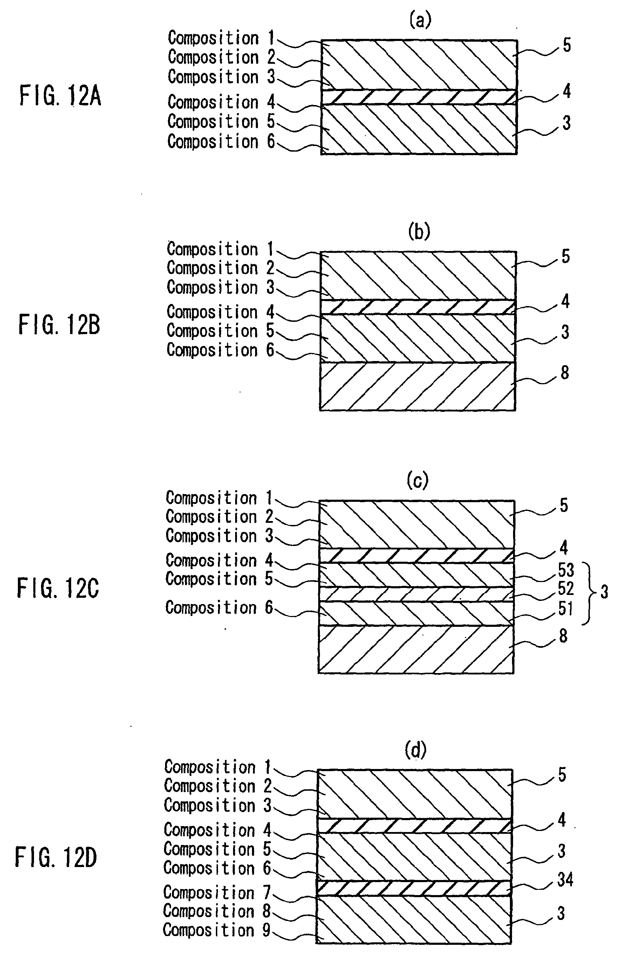

The composition of the ferromagnetic layer was analyzed by Auger electron spectroscopy, SIMS, and XPS. As shown in FIGS. 12A to 12D, the composition was measured in the vicinity of the interface and in the middle of the layer. In the vicinity of the interface, the composition in the range of 2 nm from the interface was measured. In the middle of the layer, the composition in the range of 2 nm, which extended in the thickness direction with the middle included, was measured. "Composition 1" to "Composition 9" in FIGS. 12A to 12D correspond to the items in each table below. The configurations of the elements in FIGS. 12A to 12D also correspond to the element types of a) to d) in each table.

An $Al_2O_3$ film (thickness: 1.0 to 2 nm) was used as the non-magnetic layer. The $Al_2O_3$ film was produced by forming an Al film by ICP magnetron sputtering and oxidizing the Al film in a chamber filled with a mixed gas of pure oxygen and high purity Ar. A Ru film (0.7 to 0.9 nm) was used as the non-magnetic metal layer, and PdPtMn (15 to 30 nm) was used as the antiferromagnetic layer.

In some magnetoresistive elements, the ferromagnetic layers were formed so that their compositions or composition ratios were changed in the thickness direction. This film formation was performed by adjusting an applied voltage to each of the targets.

TABLE 4a)-1

| Sample No. | Element type | Heat treatment temperature (°C) | MR (%) | Composition 1 | Composition 2 | Composition 3 | Composition 4 | Composition 5 | Composition 6 |
|---|---|---|---|---|---|---|---|---|---|
| 1 | a) | r.t. | 22.2 | $Co_{75}Fe_{25}$ | $Co_{75}Fe_{25}$ | $Co_{75}Fe_{25}$ | $Co_{75}Fe_{25}$ | $Ni_{80}Fe_{20}$ | $Ni_{80}Fe_{20}$ |
| | | 260 | 24.5 | | | | | | |
| | | 300 | 24.3 | | | | | | |
| | | 350 | 15.3 | | | | | | |
| | | 400 | 10.1 | | | | | | |
| 2 | a) | r.t. | 22.3 | $(Co_{75}Fe_{25})_{99.8}Pt_{0.2}$ | $(Co_{75}Fe_{25})_{99.8}Pt_{0.2}$ | $(Co_{75}Fe_{25})_{99.8}Pt_{0.2}$ | $(Co_{75}Fe_{25})_{99.8}Pt_{0.2}$ | $Ni_{80}Fe_{20}$ | $Ni_{80}Fe_{20}$ |
| | | 260 | 23.8 | | | | | | |
| | | 300 | 23.2 | | | | | | |
| | | 350 | 14.9 | | | | | | |
| | | 400 | 10.2 | | | | | | |
| 3 | a) | r.t. | 23.1 | $(Co_{75}Fe_{25})_{99.7}Pt_{0.3}$ | $(Co_{75}Fe_{25})_{99.7}Pt_{0.3}$ | $(Co_{75}Fe_{25})_{99.7}Pt_{0.3}$ | $(Co_{75}Fe_{25})_{99.7}Pt_{0.3}$ | $Ni_{80}Fe_{20}$ | $Ni_{80}Fe_{20}$ |
| | | 260 | 24.7 | | | | | | |
| | | 300 | 24.7 | | | | | | |
| | | 350 | 24 | | | | | | |
| | | 400 | 21.1 | | | | | | |
| 4 | a) | r.t. | 24.2 | $(Co_{75}Fe_{25})_{97}Pt_{3}$ | $(Co_{75}Fe_{25})_{97}Pt_{3}$ | $(Co_{75}Fe_{25})_{97}Pt_{3}$ | $(Co_{75}Fe_{25})_{97}Pt_{3}$ | $Ni_{80}Fe_{20}$ | $Ni_{80}Fe_{20}$ |
| | | 260 | 25.2 | | | | | | |
| | | 300 | 25.4 | | | | | | |
| | | 350 | 26.3 | | | | | | |
| | | 400 | 25.4 | | | | | | |

TABLE 4a)-2

| Sample No. | Element type | Heat treatment temperature (°C) | MR (%) | Composition 1 | Composition 2 | Composition 3 | Composition 4 | Composition 5 | Composition 6 |
|---|---|---|---|---|---|---|---|---|---|
| 5 | a) | r.t. | 23.8 | $(Co_{75}Fe_{25})_{85}Pt_{15}$ | $(Co_{75}Fe_{25})_{85}Pt_{15}$ | $(Co_{75}Fe_{25})_{85}Pt_{15}$ | $(Co_{75}Fe_{25})_{85}Pt_{15}$ | $Ni_{80}Fe_{20}$ | $Ni_{80}Fe_{20}$ |
| | | 260 | 24.9 | | | | | | |
| | | 300 | 25.5 | | | | | | |
| | | 350 | 30.1 | | | | | | |
| | | 400 | 33.2 | | | | | | |
| 6 | a) | r.t. | 23.9 | $(Co_{75}Fe_{25})_{71}Pt_{29}$ | $(Co_{75}Fe_{25})_{71}Pt_{29}$ | $(Co_{75}Fe_{25})_{71}Pt_{29}$ | $(Co_{75}Fe_{25})_{71}Pt_{29}$ | $Ni_{80}Fe_{20}$ | $Ni_{80}Fe_{20}$ |
| | | 260 | 25.1 | | | | | | |
| | | 300 | 25.3 | | | | | | |
| | | 350 | 25 | | | | | | |
| | | 400 | 24.8 | | | | | | |
| 7 | a) | r.t. | 18.9 | $(Co_{75}Fe_{25})_{41}Pt_{59}$ | $(Co_{75}Fe_{25})_{41}Pt_{59}$ | $(Co_{75}Fe_{25})_{41}Pt_{59}$ | $(Co_{75}Fe_{25})_{41}Pt_{59}$ | $Ni_{80}Fe_{20}$ | $Ni_{80}Fe_{20}$ |
| | | 260 | 19.4 | | | | | | |
| | | 300 | 20.1 | | | | | | |
| | | 350 | 20.5 | | | | | | |
| | | 400 | 20.2 | | | | | | |
| 8 | a) | r.t. | 12.5 | $(Co_{75}Fe_{25})_{38}Pt_{62}$ | $(Co_{75}Fe_{25})_{38}Pt_{62}$ | $(Co_{75}Fe_{25})_{38}Pt_{62}$ | $(Co_{75}Fe_{25})_{38}Pt_{62}$ | $Ni_{80}Fe_{20}$ | $Ni_{80}Fe_{20}$ |
| | | 260 | 17.8 | | | | | | |
| | | 300 | 15.3 | | | | | | |
| | | 350 | 12.2 | | | | | | |
| | | 400 | 11.2 | | | | | | |

TABLE 4b)-1

| Sample No. | Element type | Heat treatment temperature (°C) | MR (%) | Composition 1 | Composition 2 | Composition 3 | Composition 4 | Composition 5 | Composition 6 |
|---|---|---|---|---|---|---|---|---|---|
| 9 | a) | r.t. | 19.1 | $Ni_{60}Fe_{40}$ | $Ni_{60}Fe_{40}$ | $Ni_{60}Fe_{40}$ | $Ni_{60}Fe_{40}$ | $Ni_{80}Fe_{20}$ | $Ni_{80}Fe_{20}$ |
| | | 260 | 21.2 | | | | | | |
| | | 300 | 22.1 | | | | | | |
| | | 350 | 15.1 | | | | | | |
| | | 400 | 10.2 | | | | | | |
| 10 | a) | r.t. | 18.5 | $(Ni_{60}Fe_{40})_{99.8}Pt_{0.13}Pd_{0.07}$ | $(Ni_{60}Fe_{40})_{99.8}Pt_{0.13}Pd_{0.07}$ | $(Ni_{60}Fe_{40})_{99.8}Pt_{0.13}Pd_{0.07}$ | $(Ni_{60}Fe_{40})_{99.8}Pt_{0.13}Pd_{0.07}$ | $Ni_{80}Fe_{20}$ | $Ni_{80}Fe_{20}$ |
| | | 260 | 19.9 | | | | | | |
| | | 300 | 18.1 | | | | | | |
| | | 350 | 15.8 | | | | | | |
| | | 400 | 11.2 | | | | | | |
| 11 | a) | r.t. | 19.1 | $(Ni_{60}Fe_{40})_{99.7}Pt_{0.2}Pd_{0.1}$ | $(Ni_{60}Fe_{40})_{99.7}Pt_{0.2}Pd_{0.1}$ | $(Ni_{60}Fe_{40})_{99.7}Pt_{0.2}Pd_{0.1}$ | $(Ni_{60}Fe_{40})_{99.7}Pt_{0.2}Pd_{0.1}$ | $Ni_{80}Fe_{20}$ | $Ni_{80}Fe_{20}$ |
| | | 260 | 20.9 | | | | | | |
| | | 300 | 21.1 | | | | | | |
| | | 350 | 19.9 | | | | | | |
| | | 400 | 19.7 | | | | | | |
| 12 | a) | r.t. | 19.8 | $(Ni_{60}Fe_{40})_{97}Pt_{2}Pd_{1}$ | $(Ni_{60}Fe_{40})_{97}Pt_{2}Pd_{1}$ | $(Ni_{60}Fe_{40})_{97}Pt_{2}Pd_{1}$ | $(Ni_{60}Fe_{40})_{97}Pt_{2}Pd_{1}$ | $Ni_{80}Fe_{20}$ | $Ni_{80}Fe_{20}$ |
| | | 260 | 22.1 | | | | | | |
| | | 300 | 22.3 | | | | | | |
| | | 350 | 22.2 | | | | | | |
| | | 400 | 22.1 | | | | | | |

14

TABLE 4b)-2

| Sample No. | Element type | Heat treatment temperature (°C) | MR (%) | Composition 1 | Composition 2 | Composition 3 | Composition 4 | Composition 5 | Composition 6 |
|---|---|---|---|---|---|---|---|---|---|
| 13 | a) | r.t. | 18.8 | $(Ni_{60}Fe_{40})_{85}Pt_{10}Pd_5$ | $(Ni_{60}Fe_{40})_{85}Pt_{10}Pd_5$ | $(Ni_{60}Fe_{40})_{85}Pt_{10}Pd_5$ | $(Ni_{60}Fe_{40})_{85}Pt_{10}Pd_5$ | $Ni_{80}Fe_{20}$ | $Ni_{80}Fe_{20}$ |
| | | 260 | 19.9 | | | | | | |
| | | 300 | 19.8 | | | | | | |
| | | 350 | 26.2 | | | | | | |
| | | 400 | 28.8 | | | | | | |
| 14 | a) | r.t. | 18.7 | $(Ni_{60}Fe_{40})_{71}Pt_{19}Pd_{10}$ | $(Ni_{60}Fe_{40})_{71}Pt_{19}Pd_{10}$ | $(Ni_{60}Fe_{40})_{71}Pt_{19}Pd_{10}$ | $(Ni_{60}Fe_{40})_{71}Pt_{19}Pd_{10}$ | $Ni_{80}Fe_{20}$ | $Ni_{80}Fe_{20}$ |
| | | 260 | 19.8 | | | | | | |
| | | 300 | 20.1 | | | | | | |
| | | 350 | 22.5 | | | | | | |
| | | 400 | 23.1 | | | | | | |
| 15 | a) | r.t. | 18.7 | $(Ni_{60}Fe_{40})_{41}Pt_{39}Pd_{20}$ | $(Ni_{60}Fe_{40})_{41}Pt_{39}Pd_{20}$ | $(Ni_{60}Fe_{40})_{41}Pt_{39}Pd_{20}$ | $(Ni_{60}Fe_{40})_{41}Pt_{39}Pd_{20}$ | $Ni_{80}Fe_{20}$ | $Ni_{80}Fe_{20}$ |
| | | 260 | 18.8 | | | | | | |
| | | 300 | 19.1 | | | | | | |
| | | 350 | 19.9 | | | | | | |
| | | 400 | 19.6 | | | | | | |
| 16 | a) | r.t. | 16.4 | $(Ni_{60}Fe_{40})_{38}Pt_{41}Pd_{21}$ | $(Ni_{60}Fe_{40})_{38}Pt_{41}Pd_{21}$ | $(Ni_{60}Fe_{40})_{38}Pt_{41}Pd_{21}$ | $(Ni_{60}Fe_{40})_{38}Pt_{41}Pd_{21}$ | $Ni_{80}Fe_{20}$ | $Ni_{80}Fe_{20}$ |
| | | 260 | 16.8 | | | | | | |
| | | 300 | 15.9 | | | | | | |
| | | 350 | 12.3 | | | | | | |
| | | 400 | 9.8 | | | | | | |

EP 1 401 031 A1

15

TABLE 4c)-1

| Sample No. | Element type | Heat treatment temperature (°C) | MR (%) | Composition 1 | Composition 2 | Composition 3 |
|---|---|---|---|---|---|---|
| 17 | a) | r.t. | 22.5 | $Co_{90}Fe_{10}$ | $Co_{90}Fe_{10}$ | $Co_{75}Fe_{25}$ |
| | | 260 | 24.5 | | | |
| | | 300 | 24.1 | | | |
| | | 350 | 15.2 | | | |
| | | 400 | 9.9 | | | |
| 18 | a) | r.t. | 21.8 | $Co_{90}Fe_{10}$ | $Co_{90}Fe_{10}$ | $(Co_{75}Fe_{25})_{99.8}Ir_{0.1}Pd_{0.05}Rh_{0.05}$ |
| | | 260 | 23.7 | | | |
| | | 300 | 23.4 | | | |
| | | 350 | 15.3 | | | |
| | | 400 | 11.3 | | | |
| 19 | a) | r.t. | 22.2 | $Co_{90}Fe_{10}$ | $Co_{90}Fe_{10}$ | $(Co_{75}Fe_{25})_{99.7}Ir_{0.15}Pd_{0.07}Rh_{0.08}$ |
| | | 260 | 24.2 | | | |
| | | 300 | 24.1 | | | |
| | | 350 | 23.9 | | | |
| | | 400 | 23.8 | | | |
| 20 | a) | r.t. | 20.6 | $Co_{90}Fe_{10}$ | $Co_{90}Fe_{10}$ | $(Co_{75}Fe_{25})_{97}Ir_{1.5}Pd_{0.75}Rh_{0.75}$ |
| | | 260 | 22.9 | | | |
| | | 300 | 23.3 | | | |
| | | 350 | 24.2 | | | |
| | | 400 | 24.5 | | | |

16

TABLE 4c)-2

| Sample No. | Element type | Heat treatment temperature (°C) | MR (%) | Composition 4 | Composition 5 | Composition 6 |
|---|---|---|---|---|---|---|
| 17 | a) | r.t. | 22.5 | $Co_{75}Fe_{25}$ | $Co_{75}Fe_{25}$ | $Co_{75}Fe_{25}$ |
|  |  | 260 | 24.5 |  |  |  |
|  |  | 300 | 24.1 |  |  |  |
|  |  | 350 | 15.2 |  |  |  |
|  |  | 400 | 9.9 |  |  |  |
| 18 | a) | r.t. | 21.8 | $(Co_{75}Fe_{25})_{99.8}Ir_{0.1}Pd_{0.05}Rh_{0.05}$ | $(Co_{75}Fe_{25})_{99.8}Ir_{0.1}Pd_{0.05}Rh_{0.05}$ | $(Co_{75}Fe_{25})_{99.8}Ir_{0.1}Pd_{0.05}Rh_{0.05}$ |
|  |  | 260 | 23.7 |  |  |  |
|  |  | 300 | 23.4 |  |  |  |
|  |  | 350 | 15.3 |  |  |  |
|  |  | 400 | 11.3 |  |  |  |
| 19 | a) | r.t. | 22.2 | $(Co_{75}Fe_{25})_{99.7}Ir_{0.15}Pd_{0.07}Rh_{0.08}$ | $(Co_{75}Fe_{25})_{99.7}Ir_{0.15}Pd_{0.07}Rh_{0.08}$ | $(Co_{75}Fe_{25})_{99.7}Ir_{0.15}Pd_{0.07}Rh_{0.08}$ |
|  |  | 260 | 24.2 |  |  |  |
|  |  | 300 | 24.1 |  |  |  |
|  |  | 350 | 23.9 |  |  |  |
|  |  | 400 | 23.8 |  |  |  |
| 20 | a) | r.t. | 20.6 | $(Co_{75}Fe_{25})_{97}Ir_{1.5}Pd_{0.75}Rh_{0.75}$ | $(Co_{75}Fe_{25})_{97}Ir_{1.5}Pd_{0.75}Rh_{0.75}$ | $(Co_{75}Fe_{25})_{97}Ir_{1.5}Pd_{0.75}Rh_{0.75}$ |
|  |  | 260 | 22.9 |  |  |  |
|  |  | 300 | 23.3 |  |  |  |
|  |  | 350 | 24.2 |  |  |  |
|  |  | 400 | 24.5 |  |  |  |

TABLE 4c)-3

| Sample No. | Element type | Heat treatment temperature (°C) | MR (%) | Composition 1 | Composition 2 | Composition 3 |
|---|---|---|---|---|---|---|
| 21 | a) | r.t. | 20.5 | $Co_{90}Fe_{10}$ | $Co_{90}Fe_{10}$ | $(Co_{75}Fe_{25})_{85}Ir_{7.5}Pd_{3.7}Rh_{3.8}$ |
|    |    | 260  | 21.4 |                  |                  |                  |
|    |    | 300  | 22.6 |                  |                  |                  |
|    |    | 350  | 26.8 |                  |                  |                  |
|    |    | 400  | 27.3 |                  |                  |                  |
| 22 | a) | r.t. | 20.4 | $Co_{90}Fe_{10}$ | $Co_{90}Fe_{10}$ | $(Co_{75}Fe_{25})_{71}Ir_{14.5}Pd_{7.2}Rh_{7.3}$ |
|    |    | 260  | 21.1 |                  |                  |                  |
|    |    | 300  | 22.2 |                  |                  |                  |
|    |    | 350  | 25.2 |                  |                  |                  |
|    |    | 400  | 25.5 |                  |                  |                  |
| 23 | a) | r.t. | 15.3 | $Co_{90}Fe_{10}$ | $Co_{90}Fe_{10}$ | $(Co_{75}Fe_{25})_{41}Ir_{29.5}Pd_{14.7}Rh_{14.8}$ |
|    |    | 260  | 20.2 |                  |                  |                  |
|    |    | 300  | 21.4 |                  |                  |                  |
|    |    | 350  | 23.2 |                  |                  |                  |
|    |    | 400  | 23.1 |                  |                  |                  |
| 24 | a) | r.t. | 15.1 | $Co_{90}Fe_{10}$ | $Co_{90}Fe_{10}$ | $(Co_{75}Fe_{25})_{38}Ir_{31}Pd_{15.5}Rh_{15.5}$ |
|    |    | 260  | 20.1 |                  |                  |                  |
|    |    | 300  | 19.7 |                  |                  |                  |
|    |    | 350  | 15.1 |                  |                  |                  |
|    |    | 400  | 10.2 |                  |                  |                  |

TABLE 4c)-4

| Sample No. | Element type | Heat treatment temperature (°C) | MR (%) | Composition 4 | Composition 5 | Composition 6 |
|---|---|---|---|---|---|---|
| 21 | a) | r.t. | 20.5 | $(Co_{75}Fe_{25})_{85}Ir_{7.5}Pd_{3.7}Rh_{3.8}$ | $(Co_{75}Fe_{25})_{85}Ir_{7.5}Pd_{3.7}Rh_{3.8}$ | $(Co_{75}Fe_{25})_{85}Ir_{7.5}Pd_{3.7}Rh_{3.8}$ |
| | | 260 | 21.4 | | | |
| | | 300 | 22.6 | | | |
| | | 350 | 26.8 | | | |
| | | 400 | 27.3 | | | |
| 22 | a) | r.t. | 20.4 | $(Co_{75}Fe_{25})_{71}Ir_{14.5}Pd_{7.2}Rh_{7.3}$ | $(Co_{75}Fe_{25})_{71}Ir_{14.5}Pd_{7.2}Rh_{7.3}$ | $(Co_{75}Fe_{25})_{71}Ir_{14.5}Pd_{7.2}Rh_{7.3}$ |
| | | 260 | 21.1 | | | |
| | | 300 | 22.2 | | | |
| | | 350 | 25.2 | | | |
| | | 400 | 25.5 | | | |
| 23 | a) | r.t. | 15.3 | $(Co_{75}Fe_{25})_{41}Ir_{29.5}Pd_{14.7}Rh_{14.8}$ | $(Co_{75}Fe_{25})_{41}Ir_{29.5}Pd_{14.7}Rh_{14.8}$ | $(Co_{75}Fe_{25})_{41}Ir_{29.5}Pd_{14.7}Rh_{14.8}$ |
| | | 260 | 20.2 | | | |
| | | 300 | 21.4 | | | |
| | | 350 | 23.2 | | | |
| | | 400 | 23.1 | | | |
| 24 | a) | r.t. | 15.1 | $(Co_{75}Fe_{25})_{38}Ir_{31}Pd_{15.5}Rh_{15.5}$ | $(Co_{75}Fe_{25})_{38}Ir_{31}Pd_{15.5}Rh_{15.5}$ | $(Co_{75}Fe_{25})_{38}Ir_{31}Pd_{15.5}Rh_{15.5}$ |
| | | 260 | 20.1 | | | |
| | | 300 | 19.7 | | | |
| | | 350 | 15.1 | | | |
| | | 400 | 10.2 | | | |

TABLE 4d)-1

| Sample No. | Element type | Heat treatment temperature (°C) | MR (%) | Composition 1 | Composition 2 | Composition 3 | Composition 4 | Composition 5 | Composition 6 |
|---|---|---|---|---|---|---|---|---|---|
| 25 | b) | r.t. | 22.5 | $Ni_{80}Fe_{20}$ | $Ni_{80}Fe_{20}$ | $Co_{75}Fe_{25}$ | $Co_{75}Fe_{25}$ | $Co_{75}Fe_{25}$ | $Co_{75}Fe_{25}$ |
| | | 260 | 34.2 | | | | | | |
| | | 300 | 36.1 | | | | | $(Co_{75}Fe_{25})_{99}Mn_1$ | $(Co_{75}Fe_{25})_{95}Mn_5$ |
| | | 350 | 22.2 | | | | | $(Co_{75}Fe_{25})_{98}Mn_2$ | $(Co_{75}Fe_{25})_{90}Mn_{10}$ |
| | | 400 | 14.8 | | | | | | |
| 26 | b) | r.t. | 21.8 | $Ni_{80}Fe_{20}$ | $Ni_{80}Fe_{20}$ | $(Co_{75}Fe_{25})_{99.8}Pt_{0.2}$ | $(Co_{75}Fe_{25})_{99.8}Pt_{0.2}$ | $(Co_{75}Fe_{25})_{99.8}Pt_{0.2}$ | $(Co_{75}Fe_{25})_{99.8}Pt_{0.2}$ |
| | | 260 | 33.8 | | | | | | |
| | | 300 | 35.5 | | | | | | |
| | | 350 | 18.9 | | | | | $(Co_{75}Fe_{25})_{98.8}Pt_{0.2}Mn_1$ | $(Co_{75}Fe_{25})_{94.8}Pt_{0.2}Mn_5$ |
| | | 400 | 15.1 | | | | | $(Co_{75}Fe_{25})_{97.3}Pt_{0.7}Mn_2$ | $(Co_{75}Fe_{25})_{89.8}Pt_{0.2}Mn_{10}$ |
| 27 | b) | r.t. | 22.2 | $Ni_{80}Fe_{20}$ | $Ni_{80}Fe_{20}$ | $(Co_{75}Fe_{25})_{99.7}Pt_{0.3}$ | $(Co_{75}Fe_{25})_{99.7}Pt_{0.3}$ | $(Co_{75}Fe_{25})_{99.7}Pt_{0.3}$ | $(Co_{75}Fe_{25})_{99.7}Pt_{0.3}$ |
| | | 260 | 34.1 | | | | | | |
| | | 300 | 35.7 | | | | | | |
| | | 350 | 35.5 | | | | | $(Co_{75}Fe_{25})_{98.8}Pt_{0.3}Mn_{0.9}$ | $(Co_{75}Fe_{25})_{95.7}Pt_{0.3}Mn_4$ |
| | | 400 | 32.2 | | | | | $(Co_{75}Fe_{25})_{97.9}Pt_{0.3}Mn_{1.8}$ | $(Co_{75}Fe_{25})_{90.7}Pt_{0.3}Mn_9$ |
| 28 | b) | r.t. | 20.6 | $Ni_{80}Fe_{20}$ | $Ni_{80}Fe_{20}$ | $(Co_{75}Fe_{25})_{97}Pt_3$ | $(Co_{75}Fe_{25})_{97}Pt_3$ | $(Co_{75}Fe_{25})_{97}Pt_3$ | $(Co_{75}Fe_{25})_{97}Pt_3$ |
| | | 260 | 33.3 | | | | | | |
| | | 300 | 34.4 | | | | | | |
| | | 350 | 35 | | | | | $(Co_{75}Fe_{25})_{96.2}Pt_3Mn_{0.8}$ | $(Co_{75}Fe_{25})_{93.1}Pt_{2.9}Mn_4$ |
| | | 400 | 34.9 | | | | | $(Co_{75}Fe_{25})_{95.4}Pt_3Mn_{1.6}$ | $(Co_{75}Fe_{25})_{89.2}Pt_{2.8}Mn_8$ |

TABLE 4d)-2

| Sample No. | Element type | Heat treatment temperature (°C) | MR (%) | Composition 1 | Composition 2 | Composition 3 | Composition 4 | Composition 5 | Composition 6 |
|---|---|---|---|---|---|---|---|---|---|
| 29 | b) | r.t. | 20.5 | $Ni_{80}Fe_{20}$ | $Ni_{80}Fe_{20}$ | $(Co_{75}Fe_{25})_{85}Pt_{15}$ | $(Co_{75}Fe_{25})_{85}Pt_{15}$ | $(Co_{75}Fe_{25})_{85}Pt_{15}$ $(Co_{75}Fe_{25})_{84.6}Pt_{14.9}Mn_{0.5}$ $(Co_{75}Fe_{25})_{84.2}Pt_{14.3}Mn_{1}$ | $(Co_{75}Fe_{25})_{85}Pt_{15}$ $(Co_{75}Fe_{25})_{83.3}Pt_{14.7}Mn_{2}$ $(Co_{75}Fe_{25})_{81.6}Pt_{14.4}Mn_{4}$ |
| | | 260 | 33.5 | | | | | | |
| | | 300 | 35.1 | | | | | | |
| | | 350 | 36.5 | | | | | | |
| | | 400 | 41.1 | | | | | | |
| 30 | b) | r.t. | 20.4 | $Ni_{80}Fe_{20}$ | $Ni_{80}Fe_{20}$ | $(Co_{75}Fe_{25})_{71}Pt_{29}$ | $(Co_{75}Fe_{25})_{71}Pt_{29}$ | $(Co_{75}Fe_{25})_{71}Pt_{29}$ $(Co_{75}Fe_{25})_{70.6}Pt_{28.9}Mn_{0.5}$ $(Co_{75}Fe_{25})_{70.3}Pt_{28.7}Mn_{1}$ | $(Co_{75}Fe_{25})_{71}Pt_{29}$ $(Co_{75}Fe_{25})_{69.6}Pt_{28.4}Mn_{2}$ $(Co_{75}Fe_{25})_{68.2}Pt_{27.8}Mn_{4}$ |
| | | 260 | 33.8 | | | | | | |
| | | 300 | 34.9 | | | | | | |
| | | 350 | 36.2 | | | | | | |
| | | 400 | 36.5 | | | | | | |
| 31 | b) | r.t. | 15.3 | $Ni_{80}Fe_{20}$ | $Ni_{80}Fe_{20}$ | $(Co_{75}Fe_{25})_{41}Pt_{59}$ | $(Co_{75}Fe_{25})_{41}Pt_{59}$ | $(Co_{75}Fe_{25})_{41}Pt_{59}$ $(Co_{75}Fe_{25})_{40.8}Pt_{58.7}Mn_{0.5}$ $(Co_{75}Fe_{25})_{40.3}Pt_{58.4}Mn_{1}$ | $(Co_{75}Fe_{25})_{41}Pt_{59}$ $(Co_{75}Fe_{25})_{40.2}Pt_{57.8}Mn_{2}$ $(Co_{75}Fe_{25})_{39.4}Pt_{56.6}Mn_{4}$ |
| | | 260 | 29.5 | | | | | | |
| | | 300 | 31.1 | | | | | | |
| | | 350 | 33.2 | | | | | | |
| | | 400 | 30.2 | | | | | | |
| 32 | b) | r.t. | 12.4 | $Ni_{80}Fe_{20}$ | $Ni_{80}Fe_{20}$ | $(Co_{75}Fe_{25})_{38}Pt_{62}$ | $(Co_{75}Fe_{25})_{38}Pt_{62}$ | $(Co_{75}Fe_{25})_{38}Pt_{62}$ $(Co_{75}Fe_{25})_{37.8}Pt_{61.7}Mn_{0.5}$ $(Co_{75}Fe_{25})_{37.6}Pt_{61.4}Mn_{1}$ | $(Co_{75}Fe_{25})_{38}Pt_{62}$ $(Co_{75}Fe_{25})_{37.2}Pt_{60.8}Mn_{2}$ $(Co_{75}Fe_{25})_{36.5}Pt_{59.5}Mn_{4}$ |
| | | 260 | 15.2 | | | | | | |
| | | 300 | 16.8 | | | | | | |
| | | 350 | 14.6 | | | | | | |
| | | 400 | 12.1 | | | | | | |

The samples 1 to 8 in Table 4a) indicate that the addition of 0.3 to 60 at% Pt improves the MR characteristics after heat treatment at 300°C or more as compared with the sample that does not include Pt. In particular, the MR characteristics after heat treatment at 300°C or more tend to be improved by adding Pt in an amount of about 3 to 30 at%. The same tendency can be confirmed in each of the cases where $Co_{75}Fe_{25}$ in Table 4a) is replaced by $Co_{90}Fe_{10}$, $Co_{50}Fe_{50}$, $Ni_{60}Fe_{40}$ or $Fe_{50}Co_{25}Ni_{25}$, where $Ni_{80}Fe_{20}$ is replaced by sendust or $Co_{90}Fe_{10}$, and where Pt is replaced by Re, Ru, Os, Rh, Ir, Pd or Au.

The samples 9 to 16 in Table 4b) indicate that the addition of Pt and Pd in a ratio of 2 : 1 in a total amount of 0.3 to 60 at%, particularly 3 to 30 at%, improves the MR characteristics after heat treatment at 300°C or more as compared with the sample that does not include Pt and Pd.

The same tendency can be obtained when the ratio of the elements added is changed from 2 : 1 to 10 : 1, 6 : 1, 3 : 1, 1 : 1, 1 : 2, 1 : 3, 1 : 6, or 1 : 10. Moreover, the same tendency can be obtained by replacing Pt of (Pt, Pd) with Tc, Re, Ru, Rh, Cu or Ag and replacing Pd with Os, Ir or Au, i.e., a total of 28 combinations of the elements including (Pt, Pd). Further, the same tendency can be obtained in both cases where $Ni_{60}Fe_{40}$ is replaced by $Co_{75}Fe_{25}$ or $Fe_{50}Co_{25}Ni_{25}$ and where $Ni_{80}Fe_{20}$ is replaced by sendust or $Co_{90}Fe_{10}$.

The samples 17 to 24 in Table 4c) indicate that the addition of Ir, Pd and Rh in a ratio of 2 : 1 : 1 also improves the MR characteristics, like Tables 4a) and 4b). The same tendency can be confirmed when Ir is set to 1 and the contents of Pd and Rh are each changed in the range of 0.01 to 100. Moreover, the same tendency can be obtained in both cases where $Co_{90}Fe_{10}$ is replaced by $Ni_{80}Fe_{20}$, $Ni_{65}Fe_{25}Co_{10}$ or $Co_{60}Fe_{20}Ni_{20}$ and where $Co_{75}Fe_{25}$ is replaced by $Co_{50}Fe_{50}$, $Fe_{60}Ni_{40}$ or $Fe_{50}Ni_{50}$.

Further, the same tendency can be obtained by using the following combinations of the elements instead of (Ir, Pd, Rh): (Tc, Re, Ag), (Ru, Os, Ir), (Rh, Ir, Pt), (Pd, Pt, Cu), (Cu, Ag, Au), (Re, Ru, Os), (Ru, Rh, Pd), (Ir, Pt, Cu), and (Re, Ir, Ag).

The samples 25 to 32 in Table 4d) have the same tendency as that in Tables 4a) to 4c). Some samples show that Mn is diffused from the antiferromagnetic layer after heat treatment. However, the Mn diffusion can be suppressed by adding Pt. This indicates that the addition of Pt makes it possible to control the concentration of Mn at the interfaces of the non-magnetic layer. The same tendency can be obtained by replacing Pt with Tc, Ru, Os, Rh, Ir, Pd, Cu or Ag. Moreover, the same tendency can be obtained by modifying the ferromagnetic layers to the above compositions.

TABLE 5a)-1

| Sample No. | Element type | Heat treatment temperature (°C) | MR (%) | Composition 1 | Composition 2 | Composition 3 | Composition 4 | Composition 5 | Composition 6 |
|---|---|---|---|---|---|---|---|---|---|
| 33 | b) | r.t. | 22.9 | $Co_{90}Fe_{10}$ | $Co_{90}Fe_{10}$ | $Co_{90}Fe_{10}$ | $Co_{75}Fe_{25}$ | $Co_{75}Fe_{25}$ | $Co_{75}Fe_{25}$ |
| | | 260 | 34.1 | | | | | | |
| | | 300 | 34.3 | | | | | | |
| | | 350 | 23.5 | | | | | $(Co_{75}Fe_{25})_{99}Mn_1$ | $(Co_{75}Fe_{25})_{95}Mn_5$ |
| | | 400 | 10.4 | | | | | $(Co_{75}Fe_{25})_{98}Mn_2$ | $(Co_{75}Fe_{25})_{90}Mn_{10}$ |
| 34 | b) | r.t. | 22.8 | $Co_{90}Fe_{10}$ | $(Co_{90}Fe_{10})_{99.9}Re_{0.1}$ | $(Co_{90}Fe_{10})_{99.8}Re_{0.2}$ | $(Co_{75}Fe_{25})_{99.8}Re_{0.2}$ | $(Co_{75}Fe_{25})_{99.9}Re_{0.1}$ | $Co_{75}Fe_{25}$ |
| | | 260 | 34.3 | | | | | | |
| | | 300 | 34.7 | | | | | | |
| | | 350 | 23.4 | | | | | $(Co_{75}Fe_{25})_{99}Re_{0.1}Mn_{0.9}$ | $(Co_{75}Fe_{25})_{95}Mn_5$ |
| | | 400 | 11.8 | | | | | $(Co_{75}Fe_{25})_{98.1}Re_{0.1}Mn_{1.8}$ | $(Co_{75}Fe_{25})_{90}Mn_{10}$ |
| 35 | b) | r.t. | 21.9 | $Co_{90}Fe_{10}$ | $(Co_{90}Fe_{10})_{99.85}Re_{0.15}$ | $(Co_{90}Fe_{10})_{99.7}Re_{0.3}$ | $(Co_{75}Fe_{25})_{99.7}Re_{0.3}$ | $(Co_{75}Fe_{25})_{99.85}Re_{0.15}$ | $Co_{75}Fe_{25}$ |
| | | 260 | 33.6 | | | | | | |
| | | 300 | 34.5 | | | | | | |
| | | 350 | 35.1 | | | | | $(Co_{75}Fe_{25})_{99.05}Re_{0.15}Mn_{0.8}$ | $(Co_{75}Fe_{25})_{95}Mn_5$ |
| | | 400 | 33.6 | | | | | $(Co_{75}Fe_{25})_{98.25}Re_{0.15}Mn_{1.6}$ | $(Co_{75}Fe_{25})_{90}Mn_{10}$ |
| 36 | b) | r.t. | 20.5 | $Co_{90}Fe_{10}$ | $(Co_{90}Fe_{10})_{98.5}Re_{1.5}$ | $(Co_{90}Fe_{10})_{97}Re_3$ | $(Co_{75}Fe_{25})_{97}Re_3$ | $(Co_{75}Fe_{25})_{98.5}Re_{1.5}$ | $Co_{75}Fe_{25}$ |
| | | 260 | 32.7 | | | | | | |
| | | 300 | 33.9 | | | | | | |
| | | 350 | 35.2 | | | | | $(Co_{75}Fe_{25})_{97.8}Re_{0.15}Mn_{0.7}$ | $(Co_{75}Fe_{25})_{95}Mn_5$ |
| | | 400 | 35.3 | | | | | $(Co_{75}Fe_{25})_{97.1}Re_{1.5}Mn_{1.4}$ | $(Co_{75}Fe_{25})_{90}Mn_{10}$ |

23

TABLE 5a)-2

| Sample No. | Element type | Heat treatment temperature (°C) | MR (%) | Composition 1 | Composition 2 | Composition 3 | Composition 4 | Composition 5 | Composition 6 |
|---|---|---|---|---|---|---|---|---|---|
| 37 | b) | r.t. | 20.1 | $Co_{90}Fe_{10}$ | $(Co_{90}Fe_{10})_{92.5}Re_{7.5}$ | $(Co_{90}Fe_{10})_{85}Re_{15}$ | $(Co_{75}Fe_{25})_{85}Re_{15}$ | $(Co_{75}Fe_{25})_{92.5}Re_{7.5}$ | $Co_{75}Fe_{25}$ |
|  |  | 260 | 30.7 |  |  |  |  |  |  |
|  |  | 300 | 33.4 |  |  |  |  |  |  |
|  |  | 350 | 35.3 |  |  |  |  | $(Co_{75}Fe_{25})_{92}Re_{7.5}Mn_{0.5}$ | $(Co_{75}Fe_{25})_{95}Mn_5$ |
|  |  | 400 | 37.6 |  |  |  |  | $(Co_{75}Fe_{25})_{91.6}Re_{7.4}Mn_1$ | $(Co_{75}Fe_{25})_{90}Mn_{10}$ |
| 38 | b) | r.t. | 22.4 | $Co_{90}Fe_{10}$ | $(Co_{90}Fe_{10})_{85.5}Re_{14.5}$ | $(Co_{90}Fe_{10})_{71}Re_{29}$ | $(Co_{75}Fe_{25})_{71}Re_{29}$ | $(Co_{75}Fe_{25})_{85.5}Re_{14.5}$ | $Co_{75}Fe_{25}$ |
|  |  | 260 | 32.9 |  |  |  |  |  |  |
|  |  | 300 | 34.3 |  |  |  |  |  |  |
|  |  | 350 | 35.1 |  |  |  |  | $(Co_{75}Fe_{25})_{85.1}Re_{14.4}Mn_{0.5}$ | $(Co_{75}Fe_{25})_{95}Mn_5$ |
|  |  | 400 | 35.1 |  |  |  |  | $(Co_{75}Fe_{25})_{84.6}Re_{14.4}Mn_1$ | $(Co_{75}Fe_{25})_{90}Mn_{10}$ |
| 39 | b) | r.t. | 18.3 | $Co_{90}Fe_{10}$ | $(Co_{90}Fe_{10})_{70.5}Re_{29.5}$ | $(Co_{90}Fe_{10})_{41}Re_{59}$ | $(Co_{75}Fe_{25})_{41}Re_{59}$ | $(Co_{75}Fe_{25})_{70.5}Re_{29.5}$ | $Co_{75}Fe_{25}$ |
|  |  | 260 | 31.2 |  |  |  |  |  |  |
|  |  | 300 | 32.6 |  |  |  |  |  |  |
|  |  | 350 | 33 |  |  |  |  | $(Co_{75}Fe_{25})_{70.1}Re_{29.4}Mn_{0.5}$ | $(Co_{75}Fe_{25})_{95}Mn_5$ |
|  |  | 400 | 32.5 |  |  |  |  | $(Co_{75}Fe_{25})_{69.8}Re_{29.2}Mn_1$ | $(Co_{75}Fe_{25})_{90}Mn_{10}$ |
| 40 | b) | r.t. | 13.8 | $Co_{90}Fe_{10}$ | $(Co_{90}Fe_{10})_{69}Re_{31}$ | $(Co_{90}Fe_{10})_{38}Re_{62}$ | $(Co_{75}Fe_{25})_{38}Re_{62}$ | $(Co_{75}Fe_{25})_{69}Re_{31}$ | $Co_{75}Fe_{25}$ |
|  |  | 260 | 24.9 |  |  |  |  |  |  |
|  |  | 300 | 26.2 |  |  |  |  |  |  |
|  |  | 350 | 15.4 |  |  |  |  | $(Co_{75}Fe_{25})_{68.7}Re_{30.8}Mn_{0.5}$ | $(Co_{75}Fe_{25})_{95}Mn_5$ |
|  |  | 400 | 9.7 |  |  |  |  | $(Co_{75}Fe_{25})_{68.3}Re_{30.7}Mn_1$ | $(Co_{75}Fe_{25})_{90}Mn_{10}$ |

EP 1 401 031 A1

TABLE 5b)-1

| Sample No. | Element type | Heat treatment temperature (°C) | MR (%) | Composition 1 | Composition 2 | Composition 3 | Composition 4 | Composition 5 | Composition 6 |
|---|---|---|---|---|---|---|---|---|---|
| 41 | c) | r.t. | 18 | $Ni_{80}Fe_{20}$ | $Ni_{80}Fe_{20}$ | $Ni_{60}Fe_{40}$ | $Ni_{60}Fe_{40}$ | $Co_{70}Fe_{30}$ | $Co$ |
| | | 260 | 37.8 | | | | | | |
| | | 300 | 40.3 | | | | | | |
| | | 350 | 24.6 | | | | | | |
| | | 400 | 12.2 | | | | | | |
| 42 | c) | r.t. | 16.8 | $Ni_{80}Fe_{20}$ | $(Ni_{80}Fe_{20})_{99.9}Ru_{0.1}$ | $(Ni_{60}Fe_{40})_{99.8}Ru_{0.2}$ | $(Ni_{60}Fe_{40})_{99.8}Os_{0.2}$ | $(Co_{70}Fe_{30})_{99.8}Os_{0.2}$ | $Co_{99.8}Os_{0.2}$ |
| | | 260 | 36.5 | | | | | | |
| | | 300 | 37.7 | | | | | | |
| | | 350 | 25.4 | | | | | $(Co_{70}Fe_{30})_{99}Os_{0.2}Mn_{0.8}$ | $Co_{95.8}Os_{0.2}Mn_4$ |
| | | 400 | 12.9 | | | | | $(Co_{70}Fe_{30})_{98}Os_{0.2}Mn_{1.8}$ | $Co_{90.8}Os_{0.2}Mn_9$ |
| 43 | c) | r.t. | 16.5 | $Ni_{80}Fe_{20}$ | $(Ni_{80}Fe_{20})_{99.85}Ru_{0.15}$ | $(Ni_{60}Fe_{40})_{99.7}Ru_{0.3}$ | $(Ni_{60}Fe_{40})_{99.7}Os_{0.3}$ | $(Co_{70}Fe_{30})_{99.7}Os_{0.3}$ | $Co_{99.7}Os_{0.3}$ |
| | | 260 | 36.4 | | | | | | |
| | | 300 | 38.1 | | | | | | |
| | | 350 | 35.9 | | | | | $(Co_{70}Fe_{30})_{98.9}Os_{0.3}Mn_{0.8}$ | $Co_{95.7}Os_{0.3}Mn_4$ |
| | | 400 | 30.5 | | | | | $(Co_{70}Fe_{30})_{97.9}Os_{0.3}Mn_{1.8}$ | $Co_{90.7}Os_{0.3}Mn_9$ |
| 44 | c) | r.t. | 16.3 | $Ni_{80}Fe_{20}$ | $(Ni_{80}Fe_{20})_{98.5}Ru_{1.5}$ | $(Ni_{60}Fe_{40})_{97}Ru_3$ | $(Ni_{60}Fe_{40})_{97}Os_3$ | $(Co_{70}Fe_{30})_{97}Os_3$ | $Co_{97}Os_3$ |
| | | 260 | 35.1 | | | | | | |
| | | 300 | 35.9 | | | | | | |
| | | 350 | 38.2 | | | | | $(Co_{70}Fe_{30})_{96.3}Os_3Mn_{0.7}$ | $Co_{93.3}Os_{2.9}Mn_{3.8}$ |
| | | 400 | 37.9 | | | | | $(Co_{70}Fe_{30})_{95.4}Os_{2.9}Mn_{1.7}$ | $Co_{88.5}Os_{2.7}Mn_{8.8}$ |

TABLE 5b)-2

| Sample No. | Element type | Heat treatment temperature (°C) | MR (%) | Composition 1 | Composition 2 | Composition 3 | Composition 4 | Composition 5 | Composition 6 |
|---|---|---|---|---|---|---|---|---|---|
| 45 | c) | r.t. | 15.5 | $Ni_{80}Fe_{20}$ | $(Ni_{80}Fe_{20})_{92.5}Ru_{7.5}$ | $(Ni_{60}Fe_{40})_{85}Ru_{15}$ | $(Ni_{60}Fe_{40})_{85}Os_{15}$ | $(Co_{70}Fe_{30})_{85}Os_{15}$ | $Co_{85}Os_{15}$ |
| | | 260 | 30.6 | | | | | | |
| | | 300 | 32.3 | | | | | | |
| | | 350 | 35.4 | | | | | $(Co_{70}Fe_{30})_{84.6}Os_{14.9}Mn_{0.5}$ | $Co_{81.9}Os_{14.5}Mn_{3.6}$ |
| | | 400 | 38.3 | | | | | $(Co_{70}Fe_{30})_{83.9}Os_{14.8}Mn_{1.3}$ | $Co_{77.9}Os_{13.7}Mn_{8.4}$ |
| 46 | c) | r.t. | 17.6 | $Ni_{80}Fe_{20}$ | $(Ni_{80}Fe_{20})_{85.5}Ru_{14.5}$ | $(Ni_{60}Fe_{40})_{71}Ru_{29}$ | $(Ni_{60}Fe_{40})_{71}Os_{29}$ | $(Co_{70}Fe_{30})_{71}Os_{29}$ | $Co_{71}Os_{29}$ |
| | | 260 | 32 | | | | | | |
| | | 300 | 33.1 | | | | | | |
| | | 350 | 34.3 | | | | | $(Co_{70}Fe_{30})_{70.6}Os_{28.9}Mn_{0.5}$ | $Co_{68.4}Os_{28}Mn_{3.6}$ |
| | | 400 | 35.1 | | | | | $(Co_{70}Fe_{30})_{70.1}Os_{28.6}Mn_{1.3}$ | $Co_{65}Os_{26.6}Mn_{8.4}$ |
| 47 | c) | r.t. | 11.7 | $Ni_{80}Fe_{20}$ | $(Ni_{80}Fe_{20})_{70.5}Ru_{29.5}$ | $(Ni_{60}Fe_{40})_{41}Ru_{59}$ | $(Ni_{60}Fe_{40})_{41}Os_{59}$ | $(Co_{70}Fe_{30})_{41}Os_{59}$ | $Co_{41}Os_{59}$ |
| | | 260 | 30.3 | | | | | | |
| | | 300 | 32.4 | | | | | | |
| | | 350 | 32.2 | | | | | $(Co_{70}Fe_{30})_{40.8}Os_{58.7}Mn_{0.5}$ | $Co_{39.5}Os_{56.9}Mn_{3.6}$ |
| | | 400 | 30.8 | | | | | $(Co_{70}Fe_{30})_{40.5}Os_{58.2}Mn_{1.3}$ | $Co_{37.6}Os_{54}Mn_{8.4}$ |
| 48 | c) | r.t. | 9.5 | $Ni_{80}Fe_{20}$ | $(Ni_{80}Fe_{20})_{69}Ru_{31}$ | $(Ni_{60}Fe_{40})_{38}Ru_{62}$ | $(Ni_{60}Fe_{40})_{38}Os_{62}$ | $(Co_{70}Fe_{30})_{38}Os_{62}$ | $Co_{38}Os_{62}$ |
| | | 260 | 15.2 | | | | | | |
| | | 300 | 18.1 | | | | | | |
| | | 350 | 15.6 | | | | | $(Co_{70}Fe_{30})_{37.8}Os_{61.7}Mn_{0.5}$ | $Co_{36.6}Os_{59.8}Mn_{3.6}$ |
| | | 400 | 11.7 | | | | | $(Co_{70}Fe_{30})_{37.5}Os_{61.2}Mn_{1.3}$ | $Co_{34.8}Os_{56.8}Mn_{8.4}$ |

TABLE 5c)-1

| Sample No. | Element type | Heat treatment temperature (°C) | MR (%) | Composition 1 | Composition 2 | Composition 3 | Composition 4 | Composition 5 | Composition 6 |
|---|---|---|---|---|---|---|---|---|---|
| 49 | c) | r.t. | 21.7 | $Co_{90}Fe_{10}$ | $Co_{90}Fe_{10}$ | $Co_{90}Fe_{10}$ | $Co_{75}Fe_{25}$ | $Co_{75}Fe_{25}$ | $Co_{90}Fe_{10}$ |
| | | 260 | 36.3 | | | | | | |
| | | 300 | 38.1 | | | | | | |
| | | 350 | 24.5 | | | | | $(Co_{75}Fe_{25})_{99}Mn_1$ | $(Co_{75}Fe_{25})_{95}Mn_5$ |
| | | 400 | 11.6 | | | | | $(Co_{75}Fe_{25})_{98}Mn_2$ | $(Co_{75}Fe_{25})_{90}Mn_{10}$ |
| 50 | c) | r.t. | 22.2 | $Co_{90}Fe_{10}$ | $Co_{90}Fe_{10}$ | $Co_{90}Fe_{10}$ | $(Co_{75}Fe_{25})_{99.8}Pt_{0.1}Cu_{0.1}$ | $(Co_{75}Fe_{25})_{99.8}Pt_{0.1}Cu_{0.1}$ | $(Co_{75}Fe_{25})_{99.8}Pt_{0.1}Cu_{0.1}$ |
| | | 260 | 35.4 | | | | | | |
| | | 300 | 36.8 | | | | | | |
| | | 350 | 22.3 | | | | | $(Co_{75}Fe_{25})_{98.8}Pt_{0.1}Cu_{0.1}Mn_1$ | $(Co_{75}Fe_{25})_{94.8}Pt_{0.1}Cu_{0.1}Mn_5$ |
| | | 400 | 13.2 | | | | | $(Co_{75}Fe_{25})_{97.8}Pt_{0.1}Cu_{0.1}Mn_2$ | $(Co_{75}Fe_{25})_{89.8}Pt_{0.1}Cu_{0.1}Mn_{10}$ |
| 51 | c) | r.t. | 21.9 | $Co_{90}Fe_{10}$ | $Co_{90}Fe_{10}$ | $Co_{90}Fe_{10}$ | $(Co_{75}Fe_{25})_{99.7}Pt_{0.15}Cu_{0.15}$ | $(Co_{75}Fe_{25})_{99.7}Pt_{0.15}Cu_{0.15}$ | $(Co_{75}Fe_{25})_{99.7}Pt_{0.15}Cu_{0.15}$ |
| | | 260 | 35.1 | | | | | | |
| | | 300 | 36.6 | | | | | | |
| | | 350 | 35.4 | | | | | $(Co_{75}Fe_{25})_{98.8}Pt_{0.15}Cu_{0.15}Mn_{0.9}$ | $(Co_{75}Fe_{25})_{94.9}Pt_{0.15}Cu_{0.15}Mn_{4.8}$ |
| | | 400 | 33.8 | | | | | $(Co_{75}Fe_{25})_{97.9}Pt_{0.15}Cu_{0.15}Mn_{1.8}$ | $(Co_{75}Fe_{25})_{90.1}Pt_{0.15}Cu_{0.15}Mn_{9.6}$ |
| 52 | c) | r.t. | 20.2 | $Co_{90}Fe_{10}$ | $Co_{90}Fe_{10}$ | $Co_{90}Fe_{10}$ | $(Co_{75}Fe_{25})_{97}Pt_{1.5}Cu_{1.5}$ | $(Co_{75}Fe_{25})_{97}Pt_{1.5}Cu_{1.5}$ | $(Co_{75}Fe_{25})_{97}Pt_{1.5}Cu_{1.5}$ |
| | | 260 | 32.8 | | | | | | |
| | | 300 | 35.3 | | | | | | |
| | | 350 | 37.7 | | | | | $(Co_{75}Fe_{25})_{96.2}Pt_{1.5}Cu_{1.5}Mn_{0.8}$ | $(Co_{75}Fe_{25})_{92.5}Pt_{1.5}Cu_{1.4}Mn_{4.6}$ |
| | | 400 | 38.1 | | | | | $(Co_{75}Fe_{25})_{95.4}Pt_{1.5}Cu_{1.5}Mn_{1.6}$ | $(Co_{75}Fe_{25})_{88.1}Pt_{1.4}Cu_{1.3}Mn_{9.2}$ |

TABLE 5c)-2

| Sample No. | Element type | Heat treatment temperature (°C) | MR (%) | Composition 1 | Composition 2 | Composition 3 | Composition 4 | Composition 5 | Composition 6 |
|---|---|---|---|---|---|---|---|---|---|
| 53 | c) | r.t. | 19 | $Co_{90}Fe_{10}$ | $Co_{90}Fe_{10}$ | $Co_{90}Fe_{10}$ | $(Co_{75}Fe_{25})_{85}Pt_{7.5}Cu_{7.5}$ | $(Co_{75}Fe_{25})_{85}Pt_{7.5}Cu_{7.5}$ | $(Co_{75}Fe_{25})_{85}Pt_{7.5}Cu_{7.5}$ |
|  |  | 260 | 31.6 |  |  |  |  |  |  |
|  |  | 300 | 34.5 |  |  |  |  | $(Co_{75}Fe_{25})_{84.5}Pt_{7.5}Cu_{7.5}Mn_{0.5}$ | $(Co_{75}Fe_{25})_{81.6}Pt_{7.2}Cu_{7.2}Mn_{4}$ |
|  |  | 350 | 38.9 |  |  |  |  | $(Co_{75}Fe_{25})_{84.2}Pt_{7.4}Cu_{7.4}Mn_{1}$ | $(Co_{75}Fe_{25})_{78.2}Pt_{6.9}Cu_{6.9}Mn_{8}$ |
|  |  | 400 | 41.3 |  |  |  |  |  |  |
| 54 | c) | r.t. | 15.8 | $Co_{90}Fe_{10}$ | $Co_{90}Fe_{10}$ | $Co_{90}Fe_{10}$ | $(Co_{75}Fe_{25})_{71}Pt_{14.5}Cu_{14.5}$ | $(Co_{75}Fe_{25})_{71}Pt_{14.5}Cu_{14.5}$ | $(Co_{75}Fe_{25})_{71}Pt_{14.5}Cu_{14.5}$ |
|  |  | 260 | 31.2 |  |  |  |  |  |  |
|  |  | 300 | 32.7 |  |  |  |  | $(Co_{75}Fe_{25})_{70.7}Pt_{14.4}Cu_{14.4}Mn_{0.5}$ | $(Co_{75}Fe_{25})_{68.2}Pt_{13.9}Cu_{13.9}Mn_{4}$ |
|  |  | 350 | 37.1 |  |  |  |  | $(Co_{75}Fe_{25})_{70.2}Pt_{14.4}Cu_{14.4}Mn_{1}$ | $(Co_{75}Fe_{25})_{65.4}Pt_{13.3}Cu_{13.3}Mn_{8}$ |
|  |  | 400 | 36.8 |  |  |  |  |  |  |
| 55 | c) | r.t. | 15.4 | $Co_{90}Fe_{10}$ | $Co_{90}Fe_{10}$ | $Co_{90}Fe_{10}$ | $(Co_{75}Fe_{25})_{41}Pt_{29.5}Cu_{29.5}$ | $(Co_{75}Fe_{25})_{41}Pt_{29.5}Cu_{29.5}$ | $(Co_{75}Fe_{25})_{41}Pt_{29.5}Cu_{29.5}$ |
|  |  | 260 | 31 |  |  |  |  |  |  |
|  |  | 300 | 32.6 |  |  |  |  | $(Co_{75}Fe_{25})_{40.8}Pt_{29.4}Cu_{29.3}Mn_{0.5}$ | $(Co_{75}Fe_{25})_{68.2}Pt_{13.9}Cu_{13.9}Mn_{4}$ |
|  |  | 350 | 35.1 |  |  |  |  | $(Co_{75}Fe_{25})_{40.6}Pt_{29.2}Cu_{29.2}Mn_{1}$ | $(Co_{75}Fe_{25})_{37.7}Pt_{27.2}Cu_{27.1}Mn_{8}$ |
|  |  | 400 | 33.8 |  |  |  |  |  |  |
| 56 | c) | r.t. | 11.8 | $Co_{90}Fe_{10}$ | $Co_{90}Fe_{10}$ | $Co_{90}Fe_{10}$ | $(Co_{75}Fe_{25})_{38}Pt_{31}Cu_{31}$ | $(Co_{75}Fe_{25})_{38}Pt_{31}Cu_{31}$ | $(Co_{75}Fe_{25})_{38}Pt_{31}Cu_{31}$ |
|  |  | 260 | 24.9 |  |  |  |  |  |  |
|  |  | 300 | 24.7 |  |  |  |  | $(Co_{75}Fe_{25})_{37.9}Pt_{30.8}Cu_{30.8}Mn_{0.5}$ | $(Co_{75}Fe_{25})_{36.4}Pt_{29.8}Cu_{29.8}Mn_{4}$ |
|  |  | 350 | 14.9 |  |  |  |  | $(Co_{75}Fe_{25})_{37.6}Pt_{30.7}Cu_{30.7}Mn_{1}$ | $(Co_{75}Fe_{25})_{35}Pt_{28.5}Cu_{28.5}Mn_{8}$ |
|  |  | 400 | 10.5 |  |  |  |  |  |  |

TABLE 5d)-1

| Sample No. | Element type | Heat treatment temperature (°C) | MR (%) | Composition 1 | Composition 2 | Composition 3 | Composition 4 | Composition 5 | Composition 6 |
|---|---|---|---|---|---|---|---|---|---|
| 57 | c) | r.t. | 12.7 | $Ni_{80}Fe_{20}$ | $Ni_{80}Fe_{20}$ | Fe | Fe | $Co_{75}Fe_{25}$ | $Co_{75}Fe_{25}$ |
| | | 260 | 28.4 | | | | | | |
| | | 300 | 29.3 | | | | | | |
| | | 350 | 18.9 | | | | | $(Co_{75}Fe_{25})_{99}Mn_1$ | $(Co_{75}Fe_{25})_{95}Mn_5$ |
| | | 400 | 15.1 | | | | $Fe_{99.8}Mn_{0.2}$ | $(Co_{75}Fe_{25})_{98}Mn_2$ | $(Co_{75}Fe_{25})_{90}Mn_{10}$ |
| 58 | c) | r.t. | 12.7 | $Ni_{80}Fe_{20}$ | $Ni_{80}Fe_{20}$ | $Fe_{99.8}Pt_{0.2}$ | $Fe_{99.8}Pt_{0.2}$ | $Co_{75}Fe_{25}$ | $Co_{75}Fe_{25}$ |
| | | 260 | 28.2 | | | | | | |
| | | 300 | 29.7 | | | | | | |
| | | 350 | 19.3 | | | | | $(Co_{75}Fe_{25})_{99}Mn_1$ | $(Co_{75}Fe_{25})_{95}Mn_5$ |
| | | 400 | 15.4 | | | | $Fe_{99.6}Pt_{0.2}Mn_{0.2}$ | $(Co_{75}Fe_{25})_{98}Mn_2$ | $(Co_{75}Fe_{25})_{90}Mn_{10}$ |
| 59 | c) | r.t. | 12.5 | $Ni_{80}Fe_{20}$ | $Ni_{80}Fe_{20}$ | $Fe_{99.7}Pt_{0.3}$ | $Fe_{99.7}Pt_{0.3}$ | $Co_{75}Fe_{25}$ | $Co_{75}Fe_{25}$ |
| | | 260 | 27.1 | | | | | | |
| | | 300 | 29.4 | | | | | | |
| | | 350 | 27.2 | | | | | $(Co_{75}Fe_{25})_{99}Mn_1$ | $(Co_{75}Fe_{25})_{95}Mn_5$ |
| | | 400 | 29 | | | | $Fe_{99.55}Pt_{0.3}Mn_{0.15}$ | $(Co_{75}Fe_{25})_{98}Mn_2$ | $(Co_{75}Fe_{25})_{90}Mn_{10}$ |
| 60 | c) | r.t. | 12.3 | $Ni_{80}Fe_{20}$ | $Ni_{80}Fe_{20}$ | $Fe_{97}Pt_3$ | $Fe_{97}Pt_3$ | $Co_{75}Fe_{25}$ | $Co_{75}Fe_{25}$ |
| | | 260 | 26.5 | | | | | | |
| | | 300 | 26.8 | | | | | | |
| | | 350 | 28.7 | | | | | $(Co_{75}Fe_{25})_{99}Mn_1$ | $(Co_{75}Fe_{25})_{95}Mn_5$ |
| | | 400 | 30 | | | | $Fe_{96.9}Pt_3Mn_{0.1}$ | $(Co_{75}Fe_{25})_{98}Mn_2$ | $(Co_{75}Fe_{25})_{90}Mn_{10}$ |

TABLE 5d)-2

| Sample No. | Element type | Heat treatment temperature (°C) | MR (%) | Composition 1 | Composition 2 | Composition 3 | Composition 4 | Composition 5 | Composition 6 |
|---|---|---|---|---|---|---|---|---|---|
| 61 | c) | r.t. | 12.4 | $Ni_{80}Fe_{20}$ | $Ni_{80}Fe_{20}$ | $Fe_{85}Pt_{15}$ | $Fe_{85}Pt_{15}$ | $Co_{75}Fe_{25}$ | $Co_{75}Fe_{25}$ |
|  |  | 260 | 23.9 |  |  |  |  |  |  |
|  |  | 300 | 25.1 |  |  |  |  |  |  |
|  |  | 350 | 30.4 |  |  |  |  | $(Co_{75}Fe_{25})_{99}Mn_1$ | $(Co_{75}Fe_{25})_{95}Mn_5$ |
|  |  | 400 | 37 |  |  |  |  | $(Co_{75}Fe_{25})_{98}Mn_2$ | $(Co_{75}Fe_{25})_{90}Mn_{10}$ |
| 62 | c) | r.t. | 11.9 | $Ni_{80}Fe_{20}$ | $Ni_{80}Fe_{20}$ | $Fe_{71}Pt_{29}$ | $Fe_{71}Pt_{29}$ | $Co_{75}Fe_{25}$ | $Co_{75}Fe_{25}$ |
|  |  | 260 | 25.1 |  |  |  |  |  |  |
|  |  | 300 | 27.8 |  |  |  |  |  |  |
|  |  | 350 | 29.1 |  |  |  |  | $(Co_{75}Fe_{25})_{99}Mn_1$ | $(Co_{75}Fe_{25})_{95}Mn_5$ |
|  |  | 400 | 33.4 |  |  |  |  | $(Co_{75}Fe_{25})_{98}Mn_2$ | $(Co_{75}Fe_{25})_{90}Mn_{10}$ |
| 63 | c) | r.t. | 11.5 | $Ni_{80}Fe_{20}$ | $Ni_{80}Fe_{20}$ | $Fe_{41}Pt_{59}$ | $Fe_{41}Pt_{59}$ | $Co_{75}Fe_{25}$ | $Co_{75}Fe_{25}$ |
|  |  | 260 | 24.9 |  |  |  |  |  |  |
|  |  | 300 | 27.4 |  |  |  |  |  |  |
|  |  | 350 | 27.6 |  |  |  |  | $(Co_{75}Fe_{25})_{99}Mn_1$ | $(Co_{75}Fe_{25})_{95}Mn_5$ |
|  |  | 400 | 29.4 |  |  |  |  | $(Co_{75}Fe_{25})_{98}Mn_2$ | $(Co_{75}Fe_{25})_{90}Mn_{10}$ |
| 64 | c) | r.t. | 10.3 | $Ni_{80}Fe_{20}$ | $Ni_{80}Fe_{20}$ | $Fe_{38}Pt_{62}$ | $Fe_{38}Pt_{62}$ | $Co_{75}Fe_{25}$ | $Co_{75}Fe_{25}$ |
|  |  | 260 | 21 |  |  |  |  |  |  |
|  |  | 300 | 22.1 |  |  |  |  |  |  |
|  |  | 350 | 18.5 |  |  |  |  | $(Co_{75}Fe_{25})_{99}Mn_1$ | $(Co_{75}Fe_{25})_{95}Mn_5$ |
|  |  | 400 | 15.9 |  |  |  |  | $(Co_{75}Fe_{25})_{98}Mn_2$ | $(Co_{75}Fe_{25})_{90}Mn_{10}$ |

TABLE 6a)-1

| Sample No. | Element type | Heat treatment temperature (°C) | MR (%) | Composition 1 | Composition 2 | Composition 3 | Composition 4 | Composition 5 | Composition 6 |
|---|---|---|---|---|---|---|---|---|---|
| 65 | c) | r.t. | 12.6 | $(Ni_{80}Fe_{20})_{99.8}Mn_{0.2}$ | $(Ni_{80}Fe_{20})_{99.8}Mn_{0.2}$ | $Fe_{99.8}Mn_{0.2}$ | $Fe_{99.8}Mn_{0.2}$ | $(Co_{75}Fe_{25})_{99.8}Mn_{0.2}$ | $(Co_{75}Fe_{25})_{99.8}Mn_{0.2}$ |
| | | 260 | 28.5 | | | | | | |
| | | 300 | 29.1 | | | | | | |
| | | 350 | 18.9 | | | | | $(Co_{75}Fe_{25})_{98.8}Mn_{1.2}$ | $(Co_{75}Fe_{25})_{94.8}Mn_{5.2}$ |
| | | 400 | 15.1 | | | | $Fe_{99.6}Mn_{0.4}$ | $(Co_{75}Fe_{25})_{97.8}Mn_{2.2}$ | $(Co_{75}Fe_{25})_{89.8}Mn_{10.2}$ |
| 66 | c) | r.t. | 12.8 | $(Ni_{80}Fe_{20})_{99.8}Mn_{0.2}$ | $(Ni_{80}Fe_{20})_{99.8}Mn_{0.2}$ | $Fe_{99.6}Pt_{0.2}Mn_{0.2}$ | $Fe_{99.6}Pt_{0.2}Mn_{0.2}$ | $(Co_{75}Fe_{25})_{99.8}Mn_{0.2}$ | $(Co_{75}Fe_{25})_{99.8}Mn_{0.2}$ |
| | | 260 | 28.4 | | | | | | |
| | | 300 | 29.1 | | | | | | |
| | | 350 | 19.5 | | | | | $(Co_{75}Fe_{25})_{98.8}Mn_{1.2}$ | $(Co_{75}Fe_{25})_{94.8}Mn_{5.2}$ |
| | | 400 | 15.6 | | | | $Fe_{99.4}Pt_{0.2}Mn_{0.4}$ | $(Co_{75}Fe_{25})_{97.8}Mn_{2.2}$ | $(Co_{75}Fe_{25})_{89.8}Mn_{10.2}$ |
| 67 | c) | r.t. | 12.7 | $(Ni_{80}Fe_{20})_{99.8}Mn_{0.2}$ | $(Ni_{80}Fe_{20})_{99.8}Mn_{0.2}$ | $Fe_{99.5}Pt_{0.3}Mn_{0.2}$ | $Fe_{99.5}Pt_{0.3}Mn_{0.2}$ | $(Co_{75}Fe_{25})_{99.8}Mn_{0.2}$ | $(Co_{75}Fe_{25})_{99.8}Mn_{0.2}$ |
| | | 260 | 27.4 | | | | | | |
| | | 300 | 30.1 | | | | | | |
| | | 350 | 29.5 | | | | | $(Co_{75}Fe_{25})_{98.8}Mn_{1.2}$ | $(Co_{75}Fe_{25})_{94.8}Mn_{5.2}$ |
| | | 400 | 33.4 | | | | $Fe_{99.35}Pt_{0.3}Mn_{0.35}$ | $(Co_{75}Fe_{25})_{97.8}Mn_{2.2}$ | $(Co_{75}Fe_{25})_{89.8}Mn_{10.2}$ |
| 68 | c) | r.t. | 12.5 | $(Ni_{80}Fe_{20})_{99.8}Mn_{0.2}$ | $(Ni_{80}Fe_{20})_{99.8}Mn_{0.2}$ | $Fe_{97}Pt_{2.8}Mn_{0.2}$ | $Fe_{97}Pt_{2.8}Mn_{0.2}$ | $(Co_{75}Fe_{25})_{99.8}Mn_{0.2}$ | $(Co_{75}Fe_{25})_{99.8}Mn_{0.2}$ |
| | | 260 | 27 | | | | | | |
| | | 300 | 28.9 | | | | | | |
| | | 350 | 33.6 | | | | | $(Co_{75}Fe_{25})_{98.8}Mn_{1.2}$ | $(Co_{75}Fe_{25})_{94.8}Mn_{5.2}$ |
| | | 400 | 36.7 | | | | $Fe_{96.9}Pt_{2.8}Mn_{0.3}$ | $(Co_{75}Fe_{25})_{97.8}Mn_{2.2}$ | $(Co_{75}Fe_{25})_{89.8}Mn_{10.2}$ |

EP 1 401 031 A1

TABLE 6a)-2

| Sample No. | Element type | Heat treatment temperature (°C) | MR (%) | Composition 1 | Composition 2 | Composition 3 | Composition 4 | Composition 5 | Composition 6 |
|---|---|---|---|---|---|---|---|---|---|
| 69 | c) | r.t. | 12.1 | $(Ni_{80}Fe_{20})_{99.8}Mn_{0.2}$ | $(Ni_{80}Fe_{20})_{99.8}Mn_{0.2}$ | $Fe_{85}Pt_{14.8}Mn_{0.2}$ | $Fe_{85}Pt_{14.8}Mn_{0.2}$ | $(Co_{75}Fe_{25})_{99.8}Mn_{0.2}$ | $(Co_{75}Fe_{25})_{99.8}Mn_{0.2}$ |
| | | 260 | 25.3 | | | | | | |
| | | 300 | 29.9 | | | | | | |
| | | 350 | 34.2 | | | | | $(Co_{75}Fe_{25})_{98.8}Mn_{1.2}$ | $(Co_{75}Fe_{25})_{94.8}Mn_{5.2}$ |
| | | 400 | 39.6 | | | | | $(Co_{75}Fe_{25})_{97.8}Mn_{2.2}$ | $(Co_{75}Fe_{25})_{89.8}Mn_{10.2}$ |
| 70 | c) | r.t. | 11.8 | $(Ni_{80}Fe_{20})_{99.8}Mn_{0.2}$ | $(Ni_{80}Fe_{20})_{99.8}Mn_{0.2}$ | $Fe_{71}Pt_{28.8}Mn_{0.2}$ | $Fe_{71}Pt_{28.8}Mn_{0.2}$ | $(Co_{75}Fe_{25})_{99.8}Mn_{0.2}$ | $(Co_{75}Fe_{25})_{99.8}Mn_{0.2}$ |
| | | 260 | 25.3 | | | | | | |
| | | 300 | 27.4 | | | | | | |
| | | 350 | 31.8 | | | | | $(Co_{75}Fe_{25})_{98.8}Mn_{1.2}$ | $(Co_{75}Fe_{25})_{94.8}Mn_{5.2}$ |
| | | 400 | 37.9 | | | | | $(Co_{75}Fe_{25})_{97.8}Mn_{2.2}$ | $(Co_{75}Fe_{25})_{89.8}Mn_{10.2}$ |
| 71 | c) | r.t. | 11.4 | $(Ni_{80}Fe_{20})_{99.8}Mn_{0.2}$ | $(Ni_{80}Fe_{20})_{99.8}Mn_{0.2}$ | $Fe_{41}Pt_{58.8}Mn_{0.2}$ | $Fe_{41}Pt_{58.8}Mn_{0.2}$ | $(Co_{75}Fe_{25})_{99.8}Mn_{0.2}$ | $(Co_{75}Fe_{25})_{99.8}Mn_{0.2}$ |
| | | 260 | 25.1 | | | | | | |
| | | 300 | 27.1 | | | | | | |
| | | 350 | 28.5 | | | | | $(Co_{75}Fe_{25})_{98.8}Mn_{1.2}$ | $(Co_{75}Fe_{25})_{94.8}Mn_{5.2}$ |
| | | 400 | 34.2 | | | | | $(Co_{75}Fe_{25})_{97.8}Mn_{2.2}$ | $(Co_{75}Fe_{25})_{89.8}Mn_{10.2}$ |
| 72 | c) | r.t. | 10.5 | $(Ni_{80}Fe_{20})_{99.8}Mn_{0.2}$ | $(Ni_{80}Fe_{20})_{99.8}Mn_{0.2}$ | $Fe_{38}Pt_{61.8}Mn_{0.2}$ | $Fe_{38}Pt_{61.8}Mn_{0.2}$ | $(Co_{75}Fe_{25})_{99.8}Mn_{0.2}$ | $(Co_{75}Fe_{25})_{99.8}Mn_{0.2}$ |
| | | 260 | 20.5 | | | | | | |
| | | 300 | 22.3 | | | | | | |
| | | 350 | 18.7 | | | | | $(Co_{75}Fe_{25})_{98.8}Mn_{1.2}$ | $(Co_{75}Fe_{25})_{94.8}Mn_{5.2}$ |
| | | 400 | 16 | | | | | $(Co_{75}Fe_{25})_{97.8}Mn_{2.2}$ | $(Co_{75}Fe_{25})_{89.8}Mn_{10.2}$ |

TABLE 6b)-1

| Sample No. | Element type | Heat treatment temperature (°C) | MR (%) | Composition 1 | Composition 2 | Composition 3 | Composition 4 | Composition 5 | Composition 6 |
|---|---|---|---|---|---|---|---|---|---|
| 73 | c) | r.t. | 12.8 | $(Ni_{80}Fe_{20})_{99.5}Mn_{0.5}$ | $(Ni_{80}Fe_{20})_{99.5}Mn_{0.5}$ | $Fe_{99.5}Mn_{0.5}$ | $Fe_{99.5}Mn_{0.5}$ | $(Co_{75}Fe_{25})_{99.5}Mn_{0.5}$ | $(Co_{75}Fe_{25})_{99.5}Mn_{0.5}$ |
| | | 260 | 28.6 | | | | | | |
| | | 300 | 28.9 | | | | | | |
| | | 350 | 19.5 | | | | | $(Co_{75}Fe_{25})_{98.5}Mn_{1.5}$ | $(Co_{75}Fe_{25})_{94.5}Mn_{5.5}$ |
| | | 400 | 15.6 | | | | $Fe_{99.3}Mn_{0.7}$ | $(Co_{75}Fe_{25})_{97.5}Mn_{2.5}$ | $(Co_{75}Fe_{25})_{89.6}Mn_{10.4}$ |
| 74 | c) | r.t. | 12.7 | $(Ni_{80}Fe_{20})_{99.5}Mn_{0.5}$ | $(Ni_{80}Fe_{20})_{99.5}Mn_{0.5}$ | $Fe_{99.3}Pt_{0.2}Mn_{0.5}$ | $Fe_{99.3}Pt_{0.2}Mn_{0.5}$ | $(Co_{75}Fe_{25})_{99.5}Mn_{0.5}$ | $(Co_{75}Fe_{25})_{99.5}Mn_{0.5}$ |
| | | 260 | 28.6 | | | | | | |
| | | 300 | 29.5 | | | | | | |
| | | 350 | 19.7 | | | | | $(Co_{75}Fe_{25})_{98.5}Mn_{1.5}$ | $(Co_{75}Fe_{25})_{94.5}Mn_{5.5}$ |
| | | 400 | 15.7 | | | | $Fe_{99.1}Pt_{0.2}Mn_{0.7}$ | $(Co_{75}Fe_{25})_{97.5}Mn_{2.5}$ | $(Co_{75}Fe_{25})_{89.6}Mn_{10.4}$ |
| 75 | c) | r.t. | 12.4 | $(Ni_{80}Fe_{20})_{99.5}Mn_{0.5}$ | $(Ni_{80}Fe_{20})_{99.5}Mn_{0.5}$ | $Fe_{99.2}Pt_{0.3}Mn_{0.5}$ | $Fe_{99.2}Pt_{0.3}Mn_{0.5}$ | $(Co_{75}Fe_{25})_{99.5}Mn_{0.5}$ | $(Co_{75}Fe_{25})_{99.5}Mn_{0.5}$ |
| | | 260 | 27.1 | | | | | | |
| | | 300 | 29.9 | | | | | | |
| | | 350 | 28.4 | | | | | $(Co_{75}Fe_{25})_{98.5}Mn_{1.5}$ | $(Co_{75}Fe_{25})_{94.5}Mn_{5.5}$ |
| | | 400 | 30.8 | | | | $Fe_{99}Pt_{0.3}Mn_{0.7}$ | $(Co_{75}Fe_{25})_{97.5}Mn_{2.5}$ | $(Co_{75}Fe_{25})_{89.6}Mn_{10.4}$ |
| 76 | c) | r.t. | 12.8 | $(Ni_{80}Fe_{20})_{99.5}Mn_{0.5}$ | $(Ni_{80}Fe_{20})_{99.5}Mn_{0.5}$ | $Fe_{97}Pt_{2.5}Mn_{0.5}$ | $Fe_{97}Pt_{2.5}Mn_{0.5}$ | $(Co_{75}Fe_{25})_{99.5}Mn_{0.5}$ | $(Co_{75}Fe_{25})_{99.5}Mn_{0.5}$ |
| | | 260 | 27.6 | | | | | | |
| | | 300 | 29.4 | | | | | | |
| | | 350 | 34.4 | | | | | $(Co_{75}Fe_{25})_{98.5}Mn_{1.5}$ | $(Co_{75}Fe_{25})_{94.5}Mn_{5.5}$ |
| | | 400 | 37.7 | | | | $Fe_{96.85}Pt_{2.5}Mn_{0.65}$ | $(Co_{75}Fe_{25})_{97.5}Mn_{2.5}$ | $(Co_{75}Fe_{25})_{89.6}Mn_{10.4}$ |

33

TABLE 6b)-2

| Sample No. | Element type | Heat treatment temperature (°C) | MR (%) | Composition 1 | Composition 2 | Composition 3 | Composition 4 | Composition 5 | Composition 6 |
|---|---|---|---|---|---|---|---|---|---|
| 77 | c) | r.t. | 13.1 | $(Ni_{80}Fe_{20})_{99.5}Mn_{0.5}$ | $(Ni_{80}Fe_{20})_{99.5}Mn_{0.5}$ | $Fe_{85}Pt_{14.5}Mn_{0.5}$ | $Fe_{85}Pt_{14.5}Mn_{0.5}$ | $(Co_{75}Fe_{25})_{99.5}Mn_{0.5}$ | $(Co_{75}Fe_{25})_{99.5}Mn_{0.5}$ |
| | | 260 | 26.7 | | | | | | |
| | | 300 | 31.2 | | | | | | |
| | | 350 | 38.4 | | | | | $(Co_{75}Fe_{25})_{98.5}Mn_{1.5}$ | $(Co_{75}Fe_{25})_{94.5}Mn_{5.5}$ |
| | | 400 | 42.4 | | | | $Fe_{84.9}Pt_{14.5}Mn_{0.6}$ | $(Co_{75}Fe_{25})_{97.5}Mn_{2.5}$ | $(Co_{75}Fe_{25})_{89.6}Mn_{10.4}$ |
| 78 | c) | r.t. | 12.1 | $(Ni_{80}Fe_{20})_{99.5}Mn_{0.5}$ | $(Ni_{80}Fe_{20})_{99.5}Mn_{0.5}$ | $Fe_{71}Pt_{28.5}Mn_{0.5}$ | $Fe_{71}Pt_{28.5}Mn_{0.5}$ | $(Co_{75}Fe_{25})_{99.5}Mn_{0.5}$ | $(Co_{75}Fe_{25})_{99.5}Mn_{0.5}$ |
| | | 260 | 25.5 | | | | | | |
| | | 300 | 27.1 | | | | | | |
| | | 350 | 37 | | | | | $(Co_{75}Fe_{25})_{98.5}Mn_{1.5}$ | $(Co_{75}Fe_{25})_{94.5}Mn_{5.5}$ |
| | | 400 | 42.1 | | | | | $(Co_{75}Fe_{25})_{97.5}Mn_{2.5}$ | $(Co_{75}Fe_{25})_{89.6}Mn_{10.4}$ |
| 79 | c) | r.t. | 11.6 | $(Ni_{80}Fe_{20})_{99.5}Mn_{0.5}$ | $(Ni_{80}Fe_{20})_{99.5}Mn_{0.5}$ | $Fe_{41}Pt_{58.5}Mn_{0.5}$ | $Fe_{41}Pt_{58.5}Mn_{0.5}$ | $(Co_{75}Fe_{25})_{99.5}Mn_{0.5}$ | $(Co_{75}Fe_{25})_{99.5}Mn_{0.5}$ |
| | | 260 | 24.9 | | | | | | |
| | | 300 | 26.8 | | | | | | |
| | | 350 | 33.8 | | | | | $(Co_{75}Fe_{25})_{98.5}Mn_{1.5}$ | $(Co_{75}Fe_{25})_{94.5}Mn_{5.5}$ |
| | | 400 | 39 | | | | | $(Co_{75}Fe_{25})_{97.5}Mn_{2.5}$ | $(Co_{75}Fe_{25})_{89.6}Mn_{10.4}$ |
| 80 | c) | r.t. | 10.4 | $(Ni_{80}Fe_{20})_{99.5}Mn_{0.5}$ | $(Ni_{80}Fe_{20})_{99.5}Mn_{0.5}$ | $Fe_{38}Pt_{61.5}Mn_{0.5}$ | $Fe_{38}Pt_{61.5}Mn_{0.5}$ | $(Co_{75}Fe_{25})_{99.5}Mn_{0.5}$ | $(Co_{75}Fe_{25})_{99.5}Mn_{0.5}$ |
| | | 260 | 19.9 | | | | | | |
| | | 300 | 22.5 | | | | | | |
| | | 350 | 19.5 | | | | | $(Co_{75}Fe_{25})_{98.5}Mn_{1.5}$ | $(Co_{75}Fe_{25})_{94.5}Mn_{5.5}$ |
| | | 400 | 16.5 | | | | | $(Co_{75}Fe_{25})_{97.5}Mn_{2.5}$ | $(Co_{75}Fe_{25})_{89.6}Mn_{10.4}$ |

34

TABLE 6c)-1

| Sample No. | Element type | Heat treatment temperature (°C) | MR (%) | Composition 1 | Composition 2 | Composition 3 | Composition 4 | Composition 5 | Composition 6 |
|---|---|---|---|---|---|---|---|---|---|
| 81 | c) | r.t. | 12.7 | $(Ni_{80}Fe_{20})_{99}Mn_1$ | $(Ni_{80}Fe_{20})_{99}Mn_1$ | $Fe_{99}Mn_1$ | $Fe_{99}Mn_1$ | $(Co_{75}Fe_{25})_{99}Mn_1$ | $(Co_{75}Fe_{25})_{99}Mn_1$ |
| | | 260 | 28.4 | | | | | | |
| | | 300 | 28.6 | | | | | | |
| | | 350 | 18.9 | | | | | $(Co_{75}Fe_{25})_{98}Mn_2$ | $(Co_{75}Fe_{25})_{94.1}Mn_{5.9}$ |
| | | 400 | 15.1 | | | | $Fe_{99.8}Mn_{1.2}$ | $(Co_{75}Fe_{25})_{97}Mn_3$ | $(Co_{75}Fe_{25})_{89.1}Mn_{10.9}$ |
| 82 | c) | r.t. | 12.5 | $(Ni_{80}Fe_{20})_{99}Mn_1$ | $(Ni_{80}Fe_{20})_{99}Mn_1$ | $Fe_{98.8}Pt_{0.2}Mn_1$ | $Fe_{98.8}Pt_{0.2}Mn_1$ | $(Co_{75}Fe_{25})_{99}Mn_1$ | $(Co_{75}Fe_{25})_{99}Mn_1$ |
| | | 260 | 28.3 | | | | | | |
| | | 300 | 29.6 | | | | | | |
| | | 350 | 19.09 | | | | | $(Co_{75}Fe_{25})_{98}Mn_2$ | $(Co_{75}Fe_{25})_{94.1}Mn_{5.9}$ |
| | | 400 | 15.3 | | | | $Fe_{98.6}Pt_{0.2}Mn_{1.2}$ | $(Co_{75}Fe_{25})_{97}Mn_3$ | $(Co_{75}Fe_{25})_{89.1}Mn_{10.9}$ |
| 83 | c) | r.t. | 12.1 | $(Ni_{80}Fe_{20})_{99}Mn_1$ | $(Ni_{80}Fe_{20})_{99}Mn_1$ | $Fe_{98.7}Pt_{0.3}Mn_1$ | $Fe_{98.7}Pt_{0.3}Mn_1$ | $(Co_{75}Fe_{25})_{99}Mn_1$ | $(Co_{75}Fe_{25})_{99}Mn_1$ |
| | | 260 | 26.9 | | | | | | |
| | | 300 | 29.5 | | | | | | |
| | | 350 | 27.4 | | | | | $(Co_{75}Fe_{25})_{98}Mn_2$ | $(Co_{75}Fe_{25})_{94.1}Mn_{5.9}$ |
| | | 400 | 28.8 | | | | $Fe_{98.6}Pt_{0.3}Mn_{1.2}$ | $(Co_{75}Fe_{25})_{97}Mn_3$ | $(Co_{75}Fe_{25})_{89.1}Mn_{10.9}$ |
| 84 | c) | r.t. | 12.5 | $(Ni_{80}Fe_{20})_{99}Mn_1$ | $(Ni_{80}Fe_{20})_{99}Mn_1$ | $Fe_{97}Pt_2Mn_1$ | $Fe_{97}Pt_2Mn_1$ | $(Co_{75}Fe_{25})_{99}Mn_1$ | $(Co_{75}Fe_{25})_{99}Mn_1$ |
| | | 260 | 27.4 | | | | | | |
| | | 300 | 29.6 | | | | | | |
| | | 350 | 33.3 | | | | | $(Co_{75}Fe_{25})_{98}Mn_2$ | $(Co_{75}Fe_{25})_{94.1}Mn_{5.9}$ |
| | | 400 | 36.2 | | | | $Fe_{96.85}Pt_2Mn_{1.15}$ | $(Co_{75}Fe_{25})_{97}Mn_3$ | $(Co_{75}Fe_{25})_{89.1}Mn_{10.9}$ |

TABLE 6c)-2

| Sample No. | Element type | Heat treatment temperature (°C) | MR (%) | Composition 1 | Composition 2 | Composition 3 | Composition 4 | Composition 5 | Composition 6 |
|---|---|---|---|---|---|---|---|---|---|
| 85 | c) | r.t. | 13.3 | $(Ni_{80}Fe_{20})_{99}Mn_1$ | $(Ni_{80}Fe_{20})_{99}Mn_1$ | $Fe_{86}Pt_{14}Mn_1$ | $Fe_{86}Pt_{14}Mn_1$ | $(Co_{75}Fe_{25})_{99}Mn_1$ | $(Co_{75}Fe_{25})_{99}Mn_1$ |
|  |  | 260 | 26.8 |  |  |  |  |  |  |
|  |  | 300 | 31.5 |  |  |  |  |  |  |
|  |  | 350 | 39.1 |  |  |  |  | $(Co_{75}Fe_{25})_{98}Mn_2$ | $(Co_{75}Fe_{25})_{94.1}Mn_{5.9}$ |
|  |  | 400 | 43.8 |  |  |  | $Fe_{84.9}Pt_{14}Mn_{1.1}$ | $(Co_{75}Fe_{25})_{97}Mn_3$ | $(Co_{75}Fe_{25})_{89.1}Mn_{10.9}$ |
| 86 | c) | r.t. | 12.1 | $(Ni_{80}Fe_{20})_{99}Mn_1$ | $(Ni_{80}Fe_{20})_{99}Mn_1$ | $Fe_{71}Pt_{28}Mn_1$ | $Fe_{71}Pt_{28}Mn_1$ | $(Co_{75}Fe_{25})_{99}Mn_1$ | $(Co_{75}Fe_{25})_{99}Mn_1$ |
|  |  | 260 | 25.6 |  |  |  |  |  |  |
|  |  | 300 | 27 |  |  |  |  |  |  |
|  |  | 350 | 37 |  |  |  |  | $(Co_{75}Fe_{25})_{98}Mn_2$ | $(Co_{75}Fe_{25})_{94.1}Mn_{5.9}$ |
|  |  | 400 | 42.4 |  |  |  |  | $(Co_{75}Fe_{25})_{97}Mn_3$ | $(Co_{75}Fe_{25})_{89.1}Mn_{10.9}$ |
| 87 | c) | r.t. | 11.7 | $(Ni_{80}Fe_{20})_{99}Mn_1$ | $(Ni_{80}Fe_{20})_{99}Mn_1$ | $Fe_{41}Pt_{58}Mn_1$ | $Fe_{41}Pt_{58}Mn_1$ | $(Co_{75}Fe_{25})_{99}Mn_1$ | $(Co_{75}Fe_{25})_{99}Mn_1$ |
|  |  | 260 | 25.1 |  |  |  |  |  |  |
|  |  | 300 | 26.9 |  |  |  |  |  |  |
|  |  | 350 | 34.8 |  |  |  |  | $(Co_{75}Fe_{25})_{98}Mn_2$ | $(Co_{75}Fe_{25})_{94.1}Mn_{5.9}$ |
|  |  | 400 | 39.4 |  |  |  |  | $(Co_{75}Fe_{25})_{97}Mn_3$ | $(Co_{75}Fe_{25})_{89.1}Mn_{10.9}$ |
| 88 | c) | r.t. | 10.5 | $(Ni_{80}Fe_{20})_{99}Mn_1$ | $(Ni_{80}Fe_{20})_{99}Mn_1$ | $Fe_{38}Pt_{61}Mn_1$ | $Fe_{38}Pt_{61}Mn_1$ | $(Co_{75}Fe_{25})_{99}Mn_1$ | $(Co_{75}Fe_{25})_{99}Mn_1$ |
|  |  | 260 | 19.8 |  |  |  |  |  |  |
|  |  | 300 | 22.6 |  |  |  |  |  |  |
|  |  | 350 | 19.7 |  |  |  |  | $(Co_{75}Fe_{25})_{98}Mn_2$ | $(Co_{75}Fe_{25})_{94.1}Mn_{5.9}$ |
|  |  | 400 | 16.6 |  |  |  |  | $(Co_{75}Fe_{25})_{97}Mn_3$ | $(Co_{75}Fe_{25})_{89.1}Mn_{10.9}$ |

TABLE 6d)-1

| Sample No. | Element type | Heat treatment temperature (°C) | MR (%) | Composition 1 | Composition 2 | Composition 3 | Composition 4 | Composition 5 | Composition 6 |
|---|---|---|---|---|---|---|---|---|---|
| 89 | c) | r.t. | 12.5 | $(Ni_{80}Fe_{20})_{98}Mn_2$ | $(Ni_{80}Fe_{20})_{98}Mn_2$ | $Fe_{98}Mn_2$ | $Fe_{98}Mn_2$ | $(Co_{75}Fe_{25})_{98}Mn_2$ | $(Co_{75}Fe_{25})_{98}Mn_2$ |
| | | 260 | 28.2 | | | | | | |
| | | 300 | 28.3 | | | | | | |
| | | 350 | 18.7 | | | | | $(Co_{75}Fe_{25})_{97}Mn_3$ | $(Co_{75}Fe_{25})_{93.1}Mn_{6.9}$ |
| | | 400 | 14.9 | | | | $Fe_{97.8}Mn_{2.2}$ | $(Co_{75}Fe_{25})_{96}Mn_4$ | $(Co_{75}Fe_{25})_{88.2}Mn_{11.8}$ |
| 90 | c) | r.t. | 12.4 | $(Ni_{80}Fe_{20})_{98}Mn_2$ | $(Ni_{80}Fe_{20})_{98}Mn_2$ | $Fe_{97.8}Pt_{0.2}Mn_2$ | $Fe_{97.8}Pt_{0.2}Mn_2$ | $(Co_{75}Fe_{25})_{98}Mn_2$ | $(Co_{75}Fe_{25})_{98}Mn_2$ |
| | | 260 | 28.1 | | | | | | |
| | | 300 | 29.1 | | | | | | |
| | | 350 | 18.9 | | | | | $(Co_{75}Fe_{25})_{97}Mn_3$ | $(Co_{75}Fe_{25})_{93.1}Mn_{6.9}$ |
| | | 400 | 15.1 | | | | $Fe_{97.6}Pt_{0.2}Mn_{2.2}$ | $(Co_{75}Fe_{25})_{96}Mn_4$ | $(Co_{75}Fe_{25})_{88.2}Mn_{11.8}$ |
| 91 | c) | r.t. | 11.9 | $(Ni_{80}Fe_{20})_{98}Mn_2$ | $(Ni_{80}Fe_{20})_{98}Mn_2$ | $Fe_{97.7}Pt_{0.3}Mn_2$ | $Fe_{97.7}Pt_{0.3}Mn_2$ | $(Co_{75}Fe_{25})_{98}Mn_2$ | $(Co_{75}Fe_{25})_{98}Mn_2$ |
| | | 260 | 26.6 | | | | | | |
| | | 300 | 29.1 | | | | | | |
| | | 350 | 27 | | | | | $(Co_{75}Fe_{25})_{97}Mn_3$ | $(Co_{75}Fe_{25})_{93.1}Mn_{6.9}$ |
| | | 400 | 28.4 | | | | $Fe_{97.55}Pt_{0.3}Mn_{2.15}$ | $(Co_{75}Fe_{25})_{96}Mn_4$ | $(Co_{75}Fe_{25})_{88.2}Mn_{11.8}$ |
| 92 | c) | r.t. | 12.6 | $(Ni_{80}Fe_{20})_{98}Mn_2$ | $(Ni_{80}Fe_{20})_{98}Mn_2$ | $Fe_{96}Pt_2Mn_2$ | $Fe_{96}Pt_2Mn_2$ | $(Co_{75}Fe_{25})_{98}Mn_2$ | $(Co_{75}Fe_{25})_{98}Mn_2$ |
| | | 260 | 27.7 | | | | | | |
| | | 300 | 30.2 | | | | | | |
| | | 350 | 32.9 | | | | | $(Co_{75}Fe_{25})_{97}Mn_3$ | $(Co_{75}Fe_{25})_{93.1}Mn_{6.9}$ |
| | | 400 | 35.8 | | | | $Fe_{95.9}Pt_2Mn_{2.1}$ | $(Co_{75}Fe_{25})_{96}Mn_4$ | $(Co_{75}Fe_{25})_{88.2}Mn_{11.8}$ |

37

TABLE 6d)-2

| Sample No. | Element type | Heat treatment temperature (°C) | MR (%) | Composition 1 | Composition 2 | Composition 3 | Composition 4 | Composition 5 | Composition 6 |
|---|---|---|---|---|---|---|---|---|---|
| 93 | c) | r.t. | 13.5 | $(Ni_{80}Fe_{20})_{98}Mn_2$ | $(Ni_{80}Fe_{20})_{98}Mn_2$ | $Fe_{85}Pt_{13}Mn_2$ | $Fe_{85}Pt_{13}Mn_2$ | $(Co_{75}Fe_{25})_{98}Mn_2$ | $(Co_{75}Fe_{25})_{98}Mn_2$ |
| | | 260 | 27.1 | | | | | | |
| | | 300 | 32.2 | | | | | | |
| | | 350 | 40.6 | | | | | $(Co_{75}Fe_{25})_{97}Mn_3$ | $(Co_{75}Fe_{25})_{93.1}Mn_{6.9}$ |
| | | 400 | 46.8 | | | | | $(Co_{75}Fe_{25})_{96}Mn_4$ | $(Co_{75}Fe_{25})_{88.2}Mn_{11.8}$ |
| 94 | c) | r.t. | 12.4 | $(Ni_{80}Fe_{20})_{98}Mn_2$ | $(Ni_{80}Fe_{20})_{98}Mn_2$ | $Fe_{71}Pt_{27}Mn_2$ | $Fe_{71}Pt_{27}Mn_2$ | $(Co_{75}Fe_{25})_{98}Mn_2$ | $(Co_{75}Fe_{25})_{98}Mn_2$ |
| | | 260 | 25.7 | | | | | | |
| | | 300 | 28.1 | | | | | | |
| | | 350 | 38.6 | | | | | $(Co_{75}Fe_{25})_{97}Mn_3$ | $(Co_{75}Fe_{25})_{93.1}Mn_{6.9}$ |
| | | 400 | 44.5 | | | | | $(Co_{75}Fe_{25})_{96}Mn_4$ | $(Co_{75}Fe_{25})_{88.2}Mn_{11.8}$ |
| 95 | c) | r.t. | 11.9 | $(Ni_{80}Fe_{20})_{98}Mn_2$ | $(Ni_{80}Fe_{20})_{98}Mn_2$ | $Fe_{41}Pt_{57}Mn_2$ | $Fe_{41}Pt_{57}Mn_2$ | $(Co_{75}Fe_{25})_{98}Mn_2$ | $(Co_{75}Fe_{25})_{98}Mn_2$ |
| | | 260 | 25.5 | | | | | | |
| | | 300 | 27.1 | | | | | | |
| | | 350 | 37 | | | | | $(Co_{75}Fe_{25})_{97}Mn_3$ | $(Co_{75}Fe_{25})_{93.1}Mn_{6.9}$ |
| | | 400 | 42 | | | | | $(Co_{75}Fe_{25})_{96}Mn_4$ | $(Co_{75}Fe_{25})_{88.2}Mn_{11.8}$ |
| 96 | c) | r.t. | 10.4 | $(Ni_{80}Fe_{20})_{98}Mn_2$ | $(Ni_{80}Fe_{20})_{98}Mn_2$ | $Fe_{38}Pt_{60}Mn_2$ | $Fe_{38}Pt_{60}Mn_2$ | $(Co_{75}Fe_{25})_{98}Mn_2$ | $(Co_{75}Fe_{25})_{98}Mn_2$ |
| | | 260 | 19.9 | | | | | | |
| | | 300 | 22.4 | | | | | | |
| | | 350 | 19.8 | | | | | $(Co_{75}Fe_{25})_{97}Mn_3$ | $(Co_{75}Fe_{25})_{93.1}Mn_{6.9}$ |
| | | 400 | 16.8 | | | | | $(Co_{75}Fe_{25})_{96}Mn_4$ | $(Co_{75}Fe_{25})_{88.2}Mn_{11.8}$ |

TABLE 7a)-1

| Sample No. | Element type | Heat treatment temperature (°C) | MR (%) | Composition 1 | Composition 2 | Composition 3 | Composition 4 | Composition 5 | Composition 6 |
|---|---|---|---|---|---|---|---|---|---|
| 97 | c) | r.t. | 12.4 | $(Ni_{80}Fe_{20})_{95}Mn_5$ | $(Ni_{80}Fe_{20})_{95}Mn_5$ | $Fe_{95}Mn_5$ | $Fe_{95}Mn_5$ | $(Co_{75}Fe_{25})_{95}Mn_5$ | $(Co_{75}Fe_{25})_{95}Mn_5$ |
| | | 260 | 28.3 | | | | | | |
| | | 300 | 28.4 | | | | | | |
| | | 350 | 18.5 | | | | | $(Co_{75}Fe_{25})_{94.1}Mn_{5.9}$ | $(Co_{75}Fe_{25})_{90.3}Mn_{9.7}$ |
| | | 400 | 14.8 | | | | $Fe_{94.8}Mn_{5.2}$ | $(Co_{75}Fe_{25})_{93.1}Mn_{6.9}$ | $(Co_{75}Fe_{25})_{85.5}Mn_{14.5}$ |
| 98 | c) | r.t. | 12.2 | $(Ni_{80}Fe_{20})_{95}Mn_5$ | $(Ni_{80}Fe_{20})_{95}Mn_5$ | $Fe_{94.8}Pt_{0.2}Mn_5$ | $Fe_{94.8}Pt_{0.2}Mn_5$ | $(Co_{75}Fe_{25})_{95}Mn_5$ | $(Co_{75}Fe_{25})_{95}Mn_5$ |
| | | 260 | 28 | | | | | | |
| | | 300 | 28.9 | | | | | | |
| | | 350 | 18.7 | | | | | $(Co_{75}Fe_{25})_{94.1}Mn_{5.9}$ | $(Co_{75}Fe_{25})_{90.3}Mn_{9.7}$ |
| | | 400 | 14.9 | | | | $Fe_{94.6}Pt_{0.2}Mn_{5.2}$ | $(Co_{75}Fe_{25})_{93.1}Mn_{6.9}$ | $(Co_{75}Fe_{25})_{85.5}Mn_{14.5}$ |
| 99 | c) | r.t. | 11.8 | $(Ni_{80}Fe_{20})_{95}Mn_5$ | $(Ni_{80}Fe_{20})_{95}Mn_5$ | $Fe_{94.7}Pt_{0.3}Mn_5$ | $Fe_{94.7}Pt_{0.3}Mn_5$ | $(Co_{75}Fe_{25})_{95}Mn_5$ | $(Co_{75}Fe_{25})_{95}Mn_5$ |
| | | 260 | 26.4 | | | | | | |
| | | 300 | 28.6 | | | | | | |
| | | 350 | 26.5 | | | | | $(Co_{75}Fe_{25})_{94.1}Mn_{5.9}$ | $(Co_{75}Fe_{25})_{90.3}Mn_{9.7}$ |
| | | 400 | 27.9 | | | | $Fe_{94.55}Pt_{0.3}Mn_{5.15}$ | $(Co_{75}Fe_{25})_{93.1}Mn_{6.9}$ | $(Co_{75}Fe_{25})_{85.5}Mn_{14.5}$ |
| 100 | c) | r.t. | 12.4 | $(Ni_{80}Fe_{20})_{95}Mn_5$ | $(Ni_{80}Fe_{20})_{95}Mn_5$ | $Fe_{93}Pt_2Mn_5$ | $Fe_{93}Pt_2Mn_5$ | $(Co_{75}Fe_{25})_{95}Mn_5$ | $(Co_{75}Fe_{25})_{95}Mn_5$ |
| | | 260 | 27.1 | | | | | | |
| | | 300 | 29.9 | | | | | | |
| | | 350 | 31.6 | | | | | $(Co_{75}Fe_{25})_{94.1}Mn_{5.9}$ | $(Co_{75}Fe_{25})_{90.3}Mn_{9.7}$ |
| | | 400 | 32.8 | | | | $Fe_{92.9}Pt_2Mn_{5.1}$ | $(Co_{75}Fe_{25})_{93.1}Mn_{6.9}$ | $(Co_{75}Fe_{25})_{85.5}Mn_{14.5}$ |

EP 1 401 031 A1

TABLE 7a)-2

| Sample No. | Element type | Heat treatment temperature (°C) | MR (%) | Composition 1 | Composition 2 | Composition 3 | Composition 4 | Composition 5 | Composition 6 |
|---|---|---|---|---|---|---|---|---|---|
| 101 | c) | r.t. | 13.3 | $(Ni_{80}Fe_{20})_{95}Mn_5$ | $(Ni_{80}Fe_{20})_{95}Mn_5$ | $Fe_{88}Pt_{10}Mn_5$ | $Fe_{88}Pt_{10}Mn_5$ | $(Co_{75}Fe_{25})_{95}Mn_5$ | $(Co_{75}Fe_{25})_{95}Mn_5$ |
| | | 260 | 26.9 | | | | | | |
| | | 300 | 31.8 | | | | | | |
| | | 350 | 40.1 | | | | | $(Co_{75}Fe_{25})_{94.1}Mn_{5.9}$ | $(Co_{75}Fe_{25})_{90.3}Mn_{9.7}$ |
| | | 400 | 45 | | | | | $(Co_{75}Fe_{25})_{93.1}Mn_{6.9}$ | $(Co_{75}Fe_{25})_{85.5}Mn_{14.5}$ |
| 102 | c) | r.t. | 12.2 | $(Ni_{80}Fe_{20})_{95}Mn_5$ | $(Ni_{80}Fe_{20})_{95}Mn_5$ | $Fe_{71}Pt_{24}Mn_5$ | $Fe_{71}Pt_{24}Mn_5$ | $(Co_{75}Fe_{25})_{95}Mn_5$ | $(Co_{75}Fe_{25})_{95}Mn_5$ |
| | | 260 | 25.8 | | | | | | |
| | | 300 | 27.9 | | | | | | |
| | | 350 | 36.7 | | | | | $(Co_{75}Fe_{25})_{94.1}Mn_{5.9}$ | $(Co_{75}Fe_{25})_{90.3}Mn_{9.7}$ |
| | | 400 | 43.2 | | | | | $(Co_{75}Fe_{25})_{93.1}Mn_{6.9}$ | $(Co_{75}Fe_{25})_{85.5}Mn_{14.5}$ |
| 103 | c) | r.t. | 11.7 | $(Ni_{80}Fe_{20})_{95}Mn_5$ | $(Ni_{80}Fe_{20})_{95}Mn_5$ | $Fe_{41}Pt_{54}Mn_5$ | $Fe_{41}Pt_{54}Mn_5$ | $(Co_{75}Fe_{25})_{95}Mn_5$ | $(Co_{75}Fe_{25})_{95}Mn_5$ |
| | | 260 | 25.3 | | | | | | |
| | | 300 | 26.9 | | | | | | |
| | | 350 | 34.4 | | | | | $(Co_{75}Fe_{25})_{94.1}Mn_{5.9}$ | $(Co_{75}Fe_{25})_{90.3}Mn_{9.7}$ |
| | | 400 | 40.5 | | | | | $(Co_{75}Fe_{25})_{93.1}Mn_{6.9}$ | $(Co_{75}Fe_{25})_{85.5}Mn_{14.5}$ |
| 104 | c) | r.t. | 10.3 | $(Ni_{80}Fe_{20})_{95}Mn_5$ | $(Ni_{80}Fe_{20})_{95}Mn_5$ | $Fe_{38}Pt_{57}Mn_5$ | $Fe_{38}Pt_{57}Mn_5$ | $(Co_{75}Fe_{25})_{95}Mn_5$ | $(Co_{75}Fe_{25})_{95}Mn_5$ |
| | | 260 | 19.9 | | | | | | |
| | | 300 | 22.2 | | | | | | |
| | | 350 | 19.5 | | | | | $(Co_{75}Fe_{25})_{94.1}Mn_{5.9}$ | $(Co_{75}Fe_{25})_{90.3}Mn_{9.7}$ |
| | | 400 | 16.5 | | | | | $(Co_{75}Fe_{25})_{93.1}Mn_{6.9}$ | $(Co_{75}Fe_{25})_{85.5}Mn_{14.5}$ |

TABLE 7b)-1

| Sample No. | Element type | Heat treatment temperature (°C) | MR (%) | Composition 1 | Composition 2 | Composition 3 | Composition 4 | Composition 5 | Composition 6 |
|---|---|---|---|---|---|---|---|---|---|
| 105 | c) | r.t. | 12.1 | $(Ni_{80}Fe_{20})_{92}Mn_8$ | $(Ni_{80}Fe_{20})_{92}Mn_8$ | $Fe_{92}Mn_8$ | $Fe_{92}Mn_8$ | $(Co_{75}Fe_{25})_{92}Mn_8$ | $(Co_{75}Fe_{25})_{92}Mn_8$ |
| | | 260 | 27.6 | | | | | | |
| | | 300 | 27.8 | | | | | $(Co_{75}Fe_{25})_{91.2}Mn_{8.8}$ | $(Co_{75}Fe_{25})_{87.9}Mn_{12.1}$ |
| | | 350 | 18 | | | | | | |
| | | 400 | 14.3 | | | | $Fe_{91.85}Mn_{8.15}$ | $(Co_{75}Fe_{25})_{90.3}Mn_{9.7}$ | $(Co_{75}Fe_{25})_{83.7}Mn_{16.3}$ |
| 106 | c) | r.t. | 12.2 | $(Ni_{80}Fe_{20})_{92}Mn_8$ | $(Ni_{80}Fe_{20})_{92}Mn_8$ | $Fe_{91.8}Pt_{0.2}Mn_8$ | $Fe_{91.8}Pt_{0.2}Mn_8$ | $(Co_{75}Fe_{25})_{92}Mn_8$ | $(Co_{75}Fe_{25})_{92}Mn_8$ |
| | | 260 | 27.9 | | | | | | |
| | | 300 | 28.2 | | | | | $(Co_{75}Fe_{25})_{91.2}Mn_{8.8}$ | $(Co_{75}Fe_{25})_{87.9}Mn_{12.1}$ |
| | | 350 | 18.1 | | | | | | |
| | | 400 | 14.5 | | | | $Fe_{91.65}Pt_{0.2}Mn_{8.15}$ | $(Co_{75}Fe_{25})_{90.3}Mn_{9.7}$ | $(Co_{75}Fe_{25})_{83.7}Mn_{16.3}$ |
| 107 | c) | r.t. | 11.6 | $(Ni_{80}Fe_{20})_{92}Mn_8$ | $(Ni_{80}Fe_{20})_{92}Mn_8$ | $Fe_{91.7}Pt_{0.3}Mn_8$ | $Fe_{91.7}Pt_{0.3}Mn_8$ | $(Co_{75}Fe_{25})_{92}Mn_8$ | $(Co_{75}Fe_{25})_{92}Mn_8$ |
| | | 260 | 25.9 | | | | | | |
| | | 300 | 28.1 | | | | | $(Co_{75}Fe_{25})_{91.2}Mn_{8.8}$ | $(Co_{75}Fe_{25})_{87.9}Mn_{12.1}$ |
| | | 350 | 24.9 | | | | | | |
| | | 400 | 25.8 | | | | $Fe_{91.6}Pt_{0.3}Mn_{8.1}$ | $(Co_{75}Fe_{25})_{90.3}Mn_{9.7}$ | $(Co_{75}Fe_{25})_{83.7}Mn_{16.3}$ |
| 108 | c) | r.t. | 12 | $(Ni_{80}Fe_{20})_{92}Mn_8$ | $(Ni_{80}Fe_{20})_{92}Mn_8$ | $Fe_{90}Pt_2Mn_8$ | $Fe_{90}Pt_2Mn_8$ | $(Co_{75}Fe_{25})_{92}Mn_8$ | $(Co_{75}Fe_{25})_{92}Mn_8$ |
| | | 260 | 26.8 | | | | | | |
| | | 300 | 29.7 | | | | | $(Co_{75}Fe_{25})_{91.2}Mn_{8.8}$ | $(Co_{75}Fe_{25})_{87.9}Mn_{12.1}$ |
| | | 350 | 28.7 | | | | | | |
| | | 400 | 30 | | | | $Fe_{89.95}Pt_2Mn_{8.05}$ | $(Co_{75}Fe_{25})_{90.3}Mn_{9.7}$ | $(Co_{75}Fe_{25})_{83.7}Mn_{16.3}$ |

EP 1 401 031 A1

TABLE 7b)-2

| Sample No. | Element type | Heat treatment temperature (°C) | MR (%) | Composition 1 | Composition 2 | Composition 3 | Composition 4 | Composition 5 | Composition 6 |
|---|---|---|---|---|---|---|---|---|---|
| 109 | c) | r.t. | 12.9 | $(Ni_{80}Fe_{20})_{92}Mn_8$ | $(Ni_{80}Fe_{20})_{92}Mn_8$ | $Fe_{85}Pt_7Mn_8$ | $Fe_{85}Pt_7Mn_8$ | $(Co_{75}Fe_{25})_{92}Mn_8$ | $(Co_{75}Fe_{25})_{92}Mn_8$ |
| | | 260 | 26.2 | | | | | | |
| | | 300 | 31.1 | | | | | | |
| | | 350 | 32.3 | | | | | $(Co_{75}Fe_{25})_{91.2}Mn_{8.8}$ | $(Co_{75}Fe_{25})_{87.9}Mn_{12.1}$ |
| | | 400 | 37.3 | | | | | $(Co_{75}Fe_{25})_{90.3}Mn_{9.7}$ | $(Co_{75}Fe_{25})_{83.7}Mn_{16.3}$ |
| 110 | c) | r.t. | 11 | $(Ni_{80}Fe_{20})_{92}Mn_8$ | $(Ni_{80}Fe_{20})_{92}Mn_8$ | $Fe_{71}Pt_{21}Mn_8$ | $Fe_{71}Pt_{21}Mn_8$ | $(Co_{75}Fe_{25})_{92}Mn_8$ | $(Co_{75}Fe_{25})_{92}Mn_8$ |
| | | 260 | 24.9 | | | | | | |
| | | 300 | 26.2 | | | | | | |
| | | 350 | 30.4 | | | | | $(Co_{75}Fe_{25})_{91.2}Mn_{8.8}$ | $(Co_{75}Fe_{25})_{87.9}Mn_{12.1}$ |
| | | 400 | 34.1 | | | | | $(Co_{75}Fe_{25})_{90.3}Mn_{9.7}$ | $(Co_{75}Fe_{25})_{83.7}Mn_{16.3}$ |
| 111 | c) | r.t. | 10.6 | $(Ni_{80}Fe_{20})_{92}Mn_8$ | $(Ni_{80}Fe_{20})_{92}Mn_8$ | $Fe_{41}Pt_{51}Mn_8$ | $Fe_{41}Pt_{51}Mn_8$ | $(Co_{75}Fe_{25})_{92}Mn_8$ | $(Co_{75}Fe_{25})_{92}Mn_8$ |
| | | 260 | 24.9 | | | | | | |
| | | 300 | 26.1 | | | | | | |
| | | 350 | 28.5 | | | | | $(Co_{75}Fe_{25})_{91.2}Mn_{8.8}$ | $(Co_{75}Fe_{25})_{87.9}Mn_{12.1}$ |
| | | 400 | 32.6 | | | | | $(Co_{75}Fe_{25})_{90.3}Mn_{9.7}$ | $(Co_{75}Fe_{25})_{83.7}Mn_{16.3}$ |
| 112 | c) | r.t. | 10.2 | $(Ni_{80}Fe_{20})_{92}Mn_8$ | $(Ni_{80}Fe_{20})_{92}Mn_8$ | $Fe_{38}Pt_{54}Mn_8$ | $Fe_{38}Pt_{54}Mn_8$ | $(Co_{75}Fe_{25})_{92}Mn_8$ | $(Co_{75}Fe_{25})_{92}Mn_8$ |
| | | 260 | 19.7 | | | | | | |
| | | 300 | 21.9 | | | | | | |
| | | 350 | 18.3 | | | | | $(Co_{75}Fe_{25})_{91.2}Mn_{8.8}$ | $(Co_{75}Fe_{25})_{87.9}Mn_{12.1}$ |
| | | 400 | 15.4 | | | | | $(Co_{75}Fe_{25})_{90.3}Mn_{9.7}$ | $(Co_{75}Fe_{25})_{83.7}Mn_{16.3}$ |

42

TABLE 7c)-1

| Sample No. | Element type | Heat treatment temperature (°C) | MR (%) | Composition 1 | Composition 2 | Composition 3 | Composition 4 | Composition 5 | Composition 6 |
|---|---|---|---|---|---|---|---|---|---|
| 113 | c) | r.t. | 11.6 | $(Ni_{80}Fe_{20})_{88}Mn_{12}$ | $(Ni_{80}Fe_{20})_{88}Mn_{12}$ | $Fe_{88}Mn_{12}$ | $Fe_{88}Mn_{12}$ | $(Co_{75}Fe_{25})_{88}Mn_{12}$ | $(Co_{75}Fe_{25})_{88}Mn_{12}$ |
|  |  | 260 | 26.1 |  |  |  |  |  |  |
|  |  | 300 | 26.5 |  |  |  |  |  |  |
|  |  | 350 | 17 |  |  |  |  | $(Co_{75}Fe_{25})_{87.3}Mn_{12.7}$ | $(Co_{75}Fe_{25})_{84.5}Mn_{15.5}$ |
|  |  | 400 | 13.6 |  |  |  | $Fe_{87.9}Mn_{12.1}$ | $(Co_{75}Fe_{25})_{86.6}Mn_{13.4}$ | $(Co_{75}Fe_{25})_{81}Mn_{19}$ |
| 114 | c) | r.t. | 11.8 | $(Ni_{80}Fe_{20})_{88}Mn_{12}$ | $(Ni_{80}Fe_{20})_{88}Mn_{12}$ | $Fe_{87.8}Pt_{0.2}Mn_{12}$ | $Fe_{87.8}Pt_{0.2}Mn_{12}$ | $(Co_{75}Fe_{25})_{88}Mn_{12}$ | $(Co_{75}Fe_{25})_{88}Mn_{12}$ |
|  |  | 260 | 26.5 |  |  |  |  |  |  |
|  |  | 300 | 26.9 |  |  |  |  |  |  |
|  |  | 350 | 17.2 |  |  |  |  | $(Co_{75}Fe_{25})_{87.3}Mn_{12.7}$ | $(Co_{75}Fe_{25})_{84.5}Mn_{15.5}$ |
|  |  | 400 | 13.7 |  |  |  | $Fe_{87.7}Pt_{0.2}Mn_{12.1}$ | $(Co_{75}Fe_{25})_{86.6}Mn_{13.4}$ | $(Co_{75}Fe_{25})_{81}Mn_{19}$ |
| 115 | c) | r.t. | 11.5 | $(Ni_{80}Fe_{20})_{88}Mn_{12}$ | $(Ni_{80}Fe_{20})_{88}Mn_{12}$ | $Fe_{87.7}Pt_{0.3}Mn_{12}$ | $Fe_{87.7}Pt_{0.3}Mn_{12}$ | $(Co_{75}Fe_{25})_{88}Mn_{12}$ | $(Co_{75}Fe_{25})_{88}Mn_{12}$ |
|  |  | 260 | 25.7 |  |  |  |  |  |  |
|  |  | 300 | 27.8 |  |  |  |  |  |  |
|  |  | 350 | 23.5 |  |  |  |  | $(Co_{75}Fe_{25})_{87.3}Mn_{12.7}$ | $(Co_{75}Fe_{25})_{84.5}Mn_{15.5}$ |
|  |  | 400 | 24 |  |  |  | $Fe_{87.65}Pt_{0.3}Mn_{12.05}$ | $(Co_{75}Fe_{25})_{86.6}Mn_{13.4}$ | $(Co_{75}Fe_{25})_{81}Mn_{19}$ |
| 116 | c) | r.t. | 11.8 | $(Ni_{80}Fe_{20})_{88}Mn_{12}$ | $(Ni_{80}Fe_{20})_{88}Mn_{12}$ | $Fe_{86}Pt_{2}Mn_{12}$ | $Fe_{86}Pt_{2}Mn_{12}$ | $(Co_{75}Fe_{25})_{88}Mn_{12}$ | $(Co_{75}Fe_{25})_{88}Mn_{12}$ |
|  |  | 260 | 26.6 |  |  |  |  |  |  |
|  |  | 300 | 27.9 |  |  |  |  |  |  |
|  |  | 350 | 25.7 |  |  |  |  | $(Co_{75}Fe_{25})_{87.3}Mn_{12.7}$ | $(Co_{75}Fe_{25})_{84.5}Mn_{15.5}$ |
|  |  | 400 | 27.2 |  |  |  |  | $(Co_{75}Fe_{25})_{86.6}Mn_{13.4}$ | $(Co_{75}Fe_{25})_{81}Mn_{19}$ |

43

TABLE 7c)-2

| Sample No. | Element type | Heat treatment temperature (°C) | MR (%) | Composition 1 | Composition 2 | Composition 3 | Composition 4 | Composition 5 | Composition 6 |
|---|---|---|---|---|---|---|---|---|---|
| 117 | c) | r.t. | 11.9 | $(Ni_{80}Fe_{20})_{88}Mn_{12}$ | $(Ni_{80}Fe_{20})_{88}Mn_{12}$ | $Fe_{81}Pt_7Mn_{12}$ | $Fe_{81}Pt_7Mn_{12}$ | $(Co_{75}Fe_{25})_{88}Mn_{12}$ | $(Co_{75}Fe_{25})_{88}Mn_{12}$ |
| | | 260 | 25.9 | | | | | | |
| | | 300 | 30.2 | | | | | | |
| | | 350 | 27.2 | | | | | $(Co_{75}Fe_{25})_{87.3}Mn_{12.7}$ | $(Co_{75}Fe_{25})_{84.5}Mn_{15.5}$ |
| | | 400 | 29.9 | | | | | $(Co_{75}Fe_{25})_{86.6}Mn_{13.4}$ | $(Co_{75}Fe_{25})_{81}Mn_{19}$ |
| 118 | c) | r.t. | 10.1 | $(Ni_{80}Fe_{20})_{88}Mn_{12}$ | $(Ni_{80}Fe_{20})_{88}Mn_{12}$ | $Fe_{71}Pt_{17}Mn_{12}$ | $Fe_{71}Pt_{17}Mn_{12}$ | $(Co_{75}Fe_{25})_{88}Mn_{12}$ | $(Co_{75}Fe_{25})_{88}Mn_{12}$ |
| | | 260 | 23.9 | | | | | | |
| | | 300 | 25.7 | | | | | | |
| | | 350 | 26.8 | | | | | $(Co_{75}Fe_{25})_{87.3}Mn_{12.7}$ | $(Co_{75}Fe_{25})_{84.5}Mn_{15.5}$ |
| | | 400 | 29.4 | | | | | $(Co_{75}Fe_{25})_{86.6}Mn_{13.4}$ | $(Co_{75}Fe_{25})_{81}Mn_{19}$ |
| 119 | c) | r.t. | 10.1 | $(Ni_{80}Fe_{20})_{88}Mn_{12}$ | $(Ni_{80}Fe_{20})_{88}Mn_{12}$ | $Fe_{41}Pt_{47}Mn_{12}$ | $Fe_{41}Pt_{47}Mn_{12}$ | $(Co_{75}Fe_{25})_{88}Mn_{12}$ | $(Co_{75}Fe_{25})_{88}Mn_{12}$ |
| | | 260 | 24.2 | | | | | | |
| | | 300 | 25.6 | | | | | | |
| | | 350 | 24.9 | | | | | $(Co_{75}Fe_{25})_{87.3}Mn_{12.7}$ | $(Co_{75}Fe_{25})_{84.5}Mn_{15.5}$ |
| | | 400 | 27.2 | | | | | $(Co_{75}Fe_{25})_{86.6}Mn_{13.4}$ | $(Co_{75}Fe_{25})_{81}Mn_{19}$ |
| 120 | c) | r.t. | 9.9 | $(Ni_{80}Fe_{20})_{88}Mn_{12}$ | $(Ni_{80}Fe_{20})_{88}Mn_{12}$ | $Fe_{38}Pt_{50}Mn_{12}$ | $Fe_{38}Pt_{50}Mn_{12}$ | $(Co_{75}Fe_{25})_{88}Mn_{12}$ | $(Co_{75}Fe_{25})_{88}Mn_{12}$ |
| | | 260 | 19.2 | | | | | | |
| | | 300 | 21.2 | | | | | | |
| | | 350 | 17 | | | | | $(Co_{75}Fe_{25})_{87.3}Mn_{12.7}$ | $(Co_{75}Fe_{25})_{84.5}Mn_{15.5}$ |
| | | 400 | 13.9 | | | | | $(Co_{75}Fe_{25})_{86.6}Mn_{13.4}$ | $(Co_{75}Fe_{25})_{81}Mn_{19}$ |

EP 1 401 031 A1

44

TABLE 7d)-1

| Sample No. | Element type | Heat treatment temperature (°C) | MR (%) | Composition 1 | Composition 2 | Composition 3 | Composition 4 | Composition 5 | Composition 6 |
|---|---|---|---|---|---|---|---|---|---|
| 121 | c) | r.t. | 10.9 | $(Ni_{80}Fe_{20})_{81}Mn_{19}$ | $(Ni_{80}Fe_{20})_{81}Mn_{19}$ | $Fe_{81}Mn_{19}$ | $Fe_{81}Mn_{19}$ | $(Co_{75}Fe_{25})_{81}Mn_{19}$ | $(Co_{75}Fe_{25})_{81}Mn_{19}$ |
|  |  | 260 | 24.2 |  |  |  |  |  |  |
|  |  | 300 | 24.7 |  |  |  |  |  |  |
|  |  | 350 | 16.1 |  |  |  |  | $(Co_{75}Fe_{25})_{80.5}Mn_{19.5}$ | $(Co_{75}Fe_{25})_{78.6}Mn_{21.4}$ |
|  |  | 400 | 12.8 |  |  |  | $Fe_{80.95}Mn_{19.05}$ | $(Co_{75}Fe_{25})_{80}Mn_{20}$ | $(Co_{75}Fe_{25})_{75.1}Mn_{23.9}$ |
| 122 | c) | r.t. | 11.2 | $(Ni_{80}Fe_{20})_{81}Mn_{19}$ | $(Ni_{80}Fe_{20})_{81}Mn_{19}$ | $Fe_{80.8}Pt_{0.2}Mn_{19}$ | $Fe_{80.8}Pt_{0.2}Mn_{19}$ | $(Co_{75}Fe_{25})_{81}Mn_{19}$ | $(Co_{75}Fe_{25})_{81}Mn_{19}$ |
|  |  | 260 | 25.1 |  |  |  |  |  |  |
|  |  | 300 | 25.3 |  |  |  |  |  |  |
|  |  | 350 | 16.1 |  |  |  |  | $(Co_{75}Fe_{25})_{80.5}Mn_{19.5}$ | $(Co_{75}Fe_{25})_{78.6}Mn_{21.4}$ |
|  |  | 400 | 12.8 |  |  |  | $Fe_{80.75}Pt_{0.2}Mn_{19.05}$ | $(Co_{75}Fe_{25})_{80}Mn_{20}$ | $(Co_{75}Fe_{25})_{75.1}Mn_{23.9}$ |
| 123 | c) | r.t. | 11.4 | $(Ni_{80}Fe_{20})_{81}Mn_{19}$ | $(Ni_{80}Fe_{20})_{81}Mn_{19}$ | $Fe_{80.7}Pt_{0.3}Mn_{19}$ | $Fe_{80.7}Pt_{0.3}Mn_{19}$ | $(Co_{75}Fe_{25})_{81}Mn_{19}$ | $(Co_{75}Fe_{25})_{81}Mn_{19}$ |
|  |  | 260 | 25.5 |  |  |  |  |  |  |
|  |  | 300 | 26.9 |  |  |  |  |  |  |
|  |  | 350 | 21.8 |  |  |  |  | $(Co_{75}Fe_{25})_{80.5}Mn_{19.5}$ | $(Co_{75}Fe_{25})_{78.6}Mn_{21.4}$ |
|  |  | 400 | 21.9 |  |  |  |  | $(Co_{75}Fe_{25})_{80}Mn_{20}$ | $(Co_{75}Fe_{25})_{75.1}Mn_{23.9}$ |
| 124 | c) | r.t. | 11.4 | $(Ni_{80}Fe_{20})_{81}Mn_{19}$ | $(Ni_{80}Fe_{20})_{81}Mn_{19}$ | $Fe_{79}Pt_{2}Mn_{19}$ | $Fe_{79}Pt_{2}Mn_{19}$ | $(Co_{75}Fe_{25})_{81}Mn_{19}$ | $(Co_{75}Fe_{25})_{81}Mn_{19}$ |
|  |  | 260 | 26.1 |  |  |  |  |  |  |
|  |  | 300 | 27.2 |  |  |  |  |  |  |
|  |  | 350 | 22.7 |  |  |  |  | $(Co_{75}Fe_{25})_{80.5}Mn_{19.5}$ | $(Co_{75}Fe_{25})_{78.6}Mn_{21.4}$ |
|  |  | 400 | 23.1 |  |  |  |  | $(Co_{75}Fe_{25})_{80}Mn_{20}$ | $(Co_{75}Fe_{25})_{75.1}Mn_{23.9}$ |

TABLE 7d)-2

| Sample No. | Element type | Heat treatment temperature (°C) | MR (%) | Composition 1 | Composition 2 | Composition 3 | Composition 4 | Composition 5 | Composition 6 |
|---|---|---|---|---|---|---|---|---|---|
| 125 | c) | r.t. | 11.6 | $(Ni_{80}Fe_{20})_{81}Mn_{19}$ | $(Ni_{80}Fe_{20})_{81}Mn_{19}$ | $Fe_{74}Pt_7Mn_{19}$ | $Fe_{74}Pt_7Mn_{19}$ | $(Co_{75}Fe_{25})_{81}Mn_{19}$ | $(Co_{75}Fe_{25})_{81}Mn_{19}$ |
| | | 260 | 25.8 | | | | | | |
| | | 300 | 28.9 | | | | | | |
| | | 350 | 24.4 | | | | | $(Co_{75}Fe_{25})_{80.5}Mn_{19.5}$ | $(Co_{75}Fe_{25})_{78.6}Mn_{21.4}$ |
| | | 400 | 25.1 | | | | | $(Co_{75}Fe_{25})_{80}Mn_{20}$ | $(Co_{75}Fe_{25})_{75.1}Mn_{23.9}$ |
| 126 | c) | r.t. | 9.9 | $(Ni_{80}Fe_{20})_{81}Mn_{19}$ | $(Ni_{80}Fe_{20})_{81}Mn_{19}$ | $Fe_{71}Pt_{10}Mn_{19}$ | $Fe_{71}Pt_{10}Mn_{19}$ | $(Co_{75}Fe_{25})_{81}Mn_{19}$ | $(Co_{75}Fe_{25})_{81}Mn_{19}$ |
| | | 260 | 22.1 | | | | | | |
| | | 300 | 24.2 | | | | | | |
| | | 350 | 23.1 | | | | | $(Co_{75}Fe_{25})_{80.5}Mn_{19.5}$ | $(Co_{75}Fe_{25})_{78.6}Mn_{21.4}$ |
| | | 400 | 24 | | | | | $(Co_{75}Fe_{25})_{80}Mn_{20}$ | $(Co_{75}Fe_{25})_{75.1}Mn_{23.9}$ |
| 127 | c) | r.t. | 9.8 | $(Ni_{80}Fe_{20})_{81}Mn_{19}$ | $(Ni_{80}Fe_{20})_{81}Mn_{19}$ | $Fe_{41}Pt_{40}Mn_{19}$ | $Fe_{41}Pt_{40}Mn_{19}$ | $(Co_{75}Fe_{25})_{81}Mn_{19}$ | $(Co_{75}Fe_{25})_{81}Mn_{19}$ |
| | | 260 | 23.9 | | | | | | |
| | | 300 | 24.2 | | | | | | |
| | | 350 | 21.4 | | | | | $(Co_{75}Fe_{25})_{80.5}Mn_{19.5}$ | $(Co_{75}Fe_{25})_{78.6}Mn_{21.4}$ |
| | | 400 | 21.9 | | | | | $(Co_{75}Fe_{25})_{80}Mn_{20}$ | $(Co_{75}Fe_{25})_{75.1}Mn_{23.9}$ |
| 128 | c) | r.t. | 9.5 | $(Ni_{80}Fe_{20})_{81}Mn_{19}$ | $(Ni_{80}Fe_{20})_{81}Mn_{19}$ | $Fe_{38}Pt_{43}Mn_{19}$ | $Fe_{38}Pt_{43}Mn_{19}$ | $(Co_{75}Fe_{25})_{81}Mn_{19}$ | $(Co_{75}Fe_{25})_{81}Mn_{19}$ |
| | | 260 | 18.2 | | | | | | |
| | | 300 | 20.1 | | | | | | |
| | | 350 | 15.1 | | | | | $(Co_{75}Fe_{25})_{80.5}Mn_{19.5}$ | $(Co_{75}Fe_{25})_{78.6}Mn_{21.4}$ |
| | | 400 | 12.7 | | | | | $(Co_{75}Fe_{25})_{80}Mn_{20}$ | $(Co_{75}Fe_{25})_{75.1}Mn_{23.9}$ |

TABLE 8a)-1

| Sample No. | Element type | Heat treatment temperature (°C) | MR (%) | Composition 1 | Composition 2 | Composition 3 | Composition 4 | Composition 5 | Composition 6 |
|---|---|---|---|---|---|---|---|---|---|
| 129 | c) | r.t. | 10.1 | $(Ni_{80}Fe_{20})_{78}Mn_{22}$ | $(Ni_{80}Fe_{20})_{78}Mn_{22}$ | $Fe_{78}Mn_{22}$ | $Fe_{78}Mn_{22}$ | $(Co_{75}Fe_{25})_{78}Mn_{22}$ | $(Co_{75}Fe_{25})_{78}Mn_{22}$ |
| | | 260 | 21.1 | | | | | | |
| | | 300 | 21.4 | | | | | | |
| | | 350 | 13.2 | | | | | $(Co_{75}Fe_{25})_{77.7}Mn_{22.3}$ | $(Co_{75}Fe_{25})_{76.4}Mn_{23.6}$ |
| | | 400 | 10.6 | | | | | $(Co_{75}Fe_{25})_{77.4}Mn_{22.6}$ | $(Co_{75}Fe_{25})_{74.9}Mn_{25.1}$ |
| 130 | c) | r.t. | 10.2 | $(Ni_{80}Fe_{20})_{78}Mn_{22}$ | $(Ni_{80}Fe_{20})_{78}Mn_{22}$ | $Fe_{77.8}Pt_{0.2}Mn_{22}$ | $Fe_{77.8}Pt_{0.2}Mn_{22}$ | $(Co_{75}Fe_{25})_{78}Mn_{22}$ | $(Co_{75}Fe_{25})_{78}Mn_{22}$ |
| | | 260 | 21.4 | | | | | | |
| | | 300 | 21.6 | | | | | | |
| | | 350 | 13 | | | | | $(Co_{75}Fe_{25})_{77.7}Mn_{22.3}$ | $(Co_{75}Fe_{25})_{76.4}Mn_{23.6}$ |
| | | 400 | 10.4 | | | | | $(Co_{75}Fe_{25})_{77.4}Mn_{22.6}$ | $(Co_{75}Fe_{25})_{74.9}Mn_{25.1}$ |
| 131 | c) | r.t. | 10.4 | $(Ni_{80}Fe_{20})_{78}Mn_{22}$ | $(Ni_{80}Fe_{20})_{78}Mn_{22}$ | $Fe_{77.7}Pt_{0.3}Mn_{22}$ | $Fe_{77.7}Pt_{0.3}Mn_{22}$ | $(Co_{75}Fe_{25})_{78}Mn_{22}$ | $(Co_{75}Fe_{25})_{78}Mn_{22}$ |
| | | 260 | 21.6 | | | | | | |
| | | 300 | 21.7 | | | | | | |
| | | 350 | 14.6 | | | | | $(Co_{75}Fe_{25})_{77.7}Mn_{22.3}$ | $(Co_{75}Fe_{25})_{76.4}Mn_{23.6}$ |
| | | 400 | 12.2 | | | | | $(Co_{75}Fe_{25})_{77.4}Mn_{22.6}$ | $(Co_{75}Fe_{25})_{74.9}Mn_{25.1}$ |
| 132 | c) | r.t. | 10.5 | $(Ni_{80}Fe_{20})_{78}Mn_{22}$ | $(Ni_{80}Fe_{20})_{78}Mn_{22}$ | $Fe_{76}Pt_{2}Mn_{22}$ | $Fe_{76}Pt_{2}Mn_{22}$ | $(Co_{75}Fe_{25})_{78}Mn_{22}$ | $(Co_{75}Fe_{25})_{78}Mn_{22}$ |
| | | 260 | 21.9 | | | | | | |
| | | 300 | 21.7 | | | | | | |
| | | 350 | 14.7 | | | | | $(Co_{75}Fe_{25})_{77.7}Mn_{22.3}$ | $(Co_{75}Fe_{25})_{76.4}Mn_{23.6}$ |
| | | 400 | 12.5 | | | | | $(Co_{75}Fe_{25})_{77.4}Mn_{22.6}$ | $(Co_{75}Fe_{25})_{74.9}Mn_{25.1}$ |

TABLE 8a)-2

| Sample No. | Element type | Heat treatment temperature (°C) | MR (%) | Composition 1 | Composition 2 | Composition 3 | Composition 4 | Composition 5 | Composition 6 |
|---|---|---|---|---|---|---|---|---|---|
| 133 | c) | r.t. | 10.7 | $(Ni_{80}Fe_{20})_{78}Mn_{22}$ | $(Ni_{80}Fe_{20})_{78}Mn_{22}$ | $Fe_{71}Pt_{7}Mn_{22}$ | $Fe_{71}Pt_{7}Mn_{22}$ | $(Co_{75}Fe_{25})_{78}Mn_{22}$ | $(Co_{75}Fe_{25})_{78}Mn_{22}$ |
| | | 260 | 22.1 | | | | | | |
| | | 300 | 22.3 | | | | | | |
| | | 350 | 14.9 | | | | | $(Co_{75}Fe_{25})_{77.7}Mn_{22.3}$ | $(Co_{75}Fe_{25})_{76.4}Mn_{23.6}$ |
| | | 400 | 12.8 | | | | | $(Co_{75}Fe_{25})_{77.4}Mn_{22.6}$ | $(Co_{75}Fe_{25})_{74.9}Mn_{25.1}$ |
| 134 | c) | r.t. | 9.6 | $(Ni_{80}Fe_{20})_{78}Mn_{22}$ | $(Ni_{80}Fe_{20})_{78}Mn_{22}$ | $Fe_{68}Pt_{10}Mn_{22}$ | $Fe_{68}Pt_{10}Mn_{22}$ | $(Co_{75}Fe_{25})_{78}Mn_{22}$ | $(Co_{75}Fe_{25})_{78}Mn_{22}$ |
| | | 260 | 18.2 | | | | | | |
| | | 300 | 19.9 | | | | | | |
| | | 350 | 14.6 | | | | | $(Co_{75}Fe_{25})_{77.7}Mn_{22.3}$ | $(Co_{75}Fe_{25})_{76.4}Mn_{23.6}$ |
| | | 400 | 12.7 | | | | | $(Co_{75}Fe_{25})_{77.4}Mn_{22.6}$ | $(Co_{75}Fe_{25})_{74.9}Mn_{25.1}$ |
| 135 | c) | r.t. | 9.5 | $(Ni_{80}Fe_{20})_{78}Mn_{22}$ | $(Ni_{80}Fe_{20})_{78}Mn_{22}$ | $Fe_{41}Pt_{37}Mn_{22}$ | $Fe_{41}Pt_{37}Mn_{22}$ | $(Co_{75}Fe_{25})_{78}Mn_{22}$ | $(Co_{75}Fe_{25})_{78}Mn_{22}$ |
| | | 260 | 17.6 | | | | | | |
| | | 300 | 18.1 | | | | | | |
| | | 350 | 13.4 | | | | | $(Co_{75}Fe_{25})_{77.7}Mn_{22.3}$ | $(Co_{75}Fe_{25})_{76.4}Mn_{23.6}$ |
| | | 400 | 10.4 | | | | | $(Co_{75}Fe_{25})_{77.4}Mn_{22.6}$ | $(Co_{75}Fe_{25})_{74.9}Mn_{25.1}$ |
| 136 | c) | r.t. | 8.1 | $(Ni_{80}Fe_{20})_{78}Mn_{22}$ | $(Ni_{80}Fe_{20})_{78}Mn_{22}$ | $Fe_{38}Pt_{40}Mn_{22}$ | $Fe_{38}Pt_{40}Mn_{22}$ | $(Co_{75}Fe_{25})_{78}Mn_{22}$ | $(Co_{75}Fe_{25})_{78}Mn_{22}$ |
| | | 260 | 16.2 | | | | | | |
| | | 300 | 16.9 | | | | | | |
| | | 350 | 11.3 | | | | | $(Co_{75}Fe_{25})_{77.7}Mn_{22.3}$ | $(Co_{75}Fe_{25})_{76.4}Mn_{23.6}$ |
| | | 400 | 10.7 | | | | | $(Co_{75}Fe_{25})_{77.4}Mn_{22.6}$ | $(Co_{75}Fe_{25})_{74.9}Mn_{25.1}$ |

TABLE 8b)-1

| Sample No. | Element type | Heat treatment temperature (°C) | MR (%) | Composition 1 | Composition 2 | Composition 3 |
|---|---|---|---|---|---|---|
| 137 | d) | r.t. | 18.9 | $Co_{50}Pt_{50}$ | $Co_{50}Pt_{50}$ | $Co_{75}Fe_{25}$ |
| | | 260 | 37.1 | | | |
| | | 300 | 36.5 | | | |
| | | 350 | 15.1 | | | |
| | | 400 | 9.9 | | | |
| 138 | d) | r.t. | 18.8 | $Co_{50}Pt_{50}$ | $Co_{50}Pt_{50}$ | $(Co_{75}Fe_{25})_{99.8}Rh_{0.2}$ |
| | | 260 | 35.6 | | | |
| | | 300 | 36.6 | | | |
| | | 350 | 15.4 | | | |
| | | 400 | 10.5 | | | |
| 139 | d) | r.t. | 18.5 | $Co_{50}Pt_{50}$ | $Co_{50}Pt_{50}$ | $(Co_{75}Fe_{25})_{99.7}Rh_{0.3}$ |
| | | 260 | 35.9 | | | |
| | | 300 | 36.6 | | | |
| | | 350 | 26.5 | | | |
| | | 400 | 25.9 | | | |
| 140 | d) | r.t. | 18.1 | $Co_{50}Pt_{50}$ | $Co_{50}Pt_{50}$ | $(Co_{75}Fe_{25})_{97}Rh_{3}$ |
| | | 260 | 36.2 | | | |
| | | 300 | 36.4 | | | |
| | | 350 | 35.6 | | | |
| | | 400 | 30.1 | | | |

TABLE 8b)-2

| Sample No. | Element type | Heat treatment temperature (°C) | MR (%) | Composition 4 | Composition 5 | Composition 6 | Composition 7 | Composition 8 | Composition 9 |
|---|---|---|---|---|---|---|---|---|---|
| 137 | d) | r.t. | 18.9 | $Co_{75}Fe_{25}$ | $Ni_{80}Fe_{20}$ | $Co_{75}Fe_{25}$ | $Co_{75}Fe_{25}$ | $Co_{50}Pt_{50}$ | $Co_{50}Pt_{50}$ |
| | | 260 | 37.1 | | | | | | |
| | | 300 | 36.5 | | | | | | |
| | | 350 | 15.1 | | | | | | |
| | | 400 | 9.9 | | | | | | |
| 138 | d) | r.t. | 18.8 | $(Co_{75}Fe_{25})_{99.8}Rh_{0.2}$ | $Ni_{80}Fe_{20}$ | $(Co_{75}Fe_{25})_{99.8}Rh_{0.2}$ | $(Co_{75}Fe_{25})_{99.8}Rh_{0.2}$ | $Co_{50}Pt_{50}$ | $Co_{50}Pt_{50}$ |
| | | 260 | 35.6 | | | | | | |
| | | 300 | 36.6 | | | | | | |
| | | 350 | 15.4 | | | | | | |
| | | 400 | 10.5 | | | | | | |
| 139 | d) | r.t. | 18.5 | $(Co_{75}Fe_{25})_{99.7}Rh_{0.3}$ | $Ni_{80}Fe_{20}$ | $(Co_{75}Fe_{25})_{99.7}Rh_{0.3}$ | $(Co_{75}Fe_{25})_{99.7}Rh_{0.3}$ | $Co_{50}Pt_{50}$ | $Co_{50}Pt_{50}$ |
| | | 260 | 35.9 | | | | | | |
| | | 300 | 36.6 | | | | | | |
| | | 350 | 26.5 | | | | | | |
| | | 400 | 25.9 | | | | | | |
| 140 | d) | r.t. | 18.1 | $(Co_{75}Fe_{25})_{97}Rh_{3}$ | $Ni_{80}Fe_{20}$ | $(Co_{75}Fe_{25})_{97}Rh_{3}$ | $(Co_{75}Fe_{25})_{97}Rh_{3}$ | $Co_{50}Pt_{50}$ | $Co_{50}Pt_{50}$ |
| | | 260 | 36.2 | | | | | | |
| | | 300 | 36.4 | | | | | | |
| | | 350 | 35.6 | | | | | | |
| | | 400 | 30.1 | | | | | | |

TABLE 8b)-3

| Sample No. | Element type | Heat treatment temperature (°C) | MR (%) | Composition 1 | Composition 2 | Composition 3 |
|---|---|---|---|---|---|---|
| 141 | d) | r.t. | 16.5 | $Co_{50}Pt_{50}$ | $Co_{50}Pt_{50}$ | $(Co_{75}Fe_{25})_{85}Rh_{15}$ |
| | | 260 | 32.1 | | | |
| | | 300 | 33.2 | | | |
| | | 350 | 34.2 | | | |
| | | 400 | 36.6 | | | |
| 142 | d) | r.t. | 16.1 | $Co_{50}Pt_{50}$ | $Co_{50}Pt_{50}$ | $(Co_{75}Fe_{25})_{71}Rh_{29}$ |
| | | 260 | 30.1 | | | |
| | | 300 | 32.4 | | | |
| | | 350 | 34.5 | | | |
| | | 400 | 34.3 | | | |
| 143 | d) | r.t. | 15.2 | $Co_{50}Pt_{50}$ | $Co_{50}Pt_{50}$ | $(Co_{75}Fe_{25})_{41}Rh_{59}$ |
| | | 260 | 25.7 | | | |
| | | 300 | 26.6 | | | |
| | | 350 | 30.3 | | | |
| | | 400 | 29.8 | | | |
| 144 | d) | r.t. | 10.3 | $Co_{50}Pt_{50}$ | $Co_{50}Pt_{50}$ | $(Co_{75}Fe_{25})_{38}Rh_{62}$ |
| | | 260 | 22.1 | | | |
| | | 300 | 23.5 | | | |
| | | 350 | 16.1 | | | |
| | | 400 | 11.2 | | | |

TABLE 8 b)-4

| Sample No. | Element type | Heat treatment temperature (°C) | MR (%) | Composition 4 | Composition 5 | Composition 6 | Composition 7 | Composition 8 | Composition 9 |
|---|---|---|---|---|---|---|---|---|---|
| 141 | d) | r.t. | 16.5 | $(Co_{75}Fe_{25})_{85}Rh_{15}$ | $Ni_{80}Fe_{20}$ | $(Co_{75}Fe_{25})_{85}Rh_{15}$ | $(Co_{75}Fe_{25})_{85}Rh_{15}$ | $Co_{50}Pt_{50}$ | $Co_{50}Pt_{50}$ |
| 141 | d) | 260 | 32.1 | | | | | | |
| 141 | d) | 300 | 33.2 | | | | | | |
| 141 | d) | 350 | 34.2 | | | | | | |
| 141 | d) | 400 | 36.6 | | | | | | |
| 142 | d) | r.t. | 16.1 | $(Co_{75}Fe_{25})_{71}Rh_{29}$ | $Ni_{80}Fe_{20}$ | $(Co_{75}Fe_{25})_{71}Rh_{29}$ | $(Co_{75}Fe_{25})_{71}Rh_{29}$ | $Co_{50}Pt_{50}$ | $Co_{50}Pt_{50}$ |
| 142 | d) | 260 | 30.1 | | | | | | |
| 142 | d) | 300 | 32.4 | | | | | | |
| 142 | d) | 350 | 34.5 | | | | | | |
| 142 | d) | 400 | 34.3 | | | | | | |
| 143 | d) | r.t. | 15.2 | $(Co_{75}Fe_{25})_{41}Rh_{59}$ | $Ni_{80}Fe_{20}$ | $(Co_{75}Fe_{25})_{41}Rh_{59}$ | $(Co_{75}Fe_{25})_{41}Rh_{59}$ | $Co_{50}Pt_{50}$ | $Co_{50}Pt_{50}$ |
| 143 | d) | 260 | 25.7 | | | | | | |
| 143 | d) | 300 | 26.6 | | | | | | |
| 143 | d) | 350 | 30.3 | | | | | | |
| 143 | d) | 400 | 29.8 | | | | | | |
| 144 | d) | r.t. | 10.3 | $(Co_{75}Fe_{25})_{38}Rh_{62}$ | $Ni_{80}Fe_{20}$ | $(Co_{75}Fe_{25})_{38}Rh_{62}$ | $(Co_{75}Fe_{25})_{38}Rh_{62}$ | $Co_{50}Pt_{50}$ | $Co_{50}Pt_{50}$ |
| 144 | d) | 260 | 22.1 | | | | | | |
| 144 | d) | 300 | 23.5 | | | | | | |
| 144 | d) | 350 | 16.1 | | | | | | |
| 144 | d) | 400 | 11.2 | | | | | | |

TABLE 8c)-1

| Sample No. | Element type | Heat treatment temperature (°C) | MR (%) | Composition 1 | Composition 2 | Composition 3 |
|---|---|---|---|---|---|---|
| 145 | d) | r.t. | 15.1 | $Co_{50}Fe_{50}$ | $Co_{50}Fe_{50}$ | $Co_{90}Fe_{10}$ |
| | | 260 | 32.1 | | | |
| | | 300 | 34.1 | | | |
| | | 350 | 10.1 | | | |
| | | 400 | 8.5 | | | |
| 146 | d) | r.t. | 15.3 | $(Co_{50}Fe_{50})_{99.8}Pt_{0.2}$ | $(Co_{50}Fe_{50})_{99.8}Pt_{0.2}$ | $(Co_{90}Fe_{10})_{99.9}Pt_{0.1}$ |
| | | 260 | 32.4 | | | |
| | | 300 | 34.3 | | | |
| | | 350 | 11.1 | | | $(Co_{90}Fe_{10})_{99.8}Pt_{0.1}Mn_{0.1}$ |
| | | 400 | 9.5 | | | $(Co_{90}Fe_{10})_{99.7}Pt_{0.2}Mn_{0.1}$ |
| 147 | d) | r.t. | 15.5 | $(Co_{50}Fe_{50})_{99.7}Pt_{0.3}$ | $(Co_{50}Fe_{50})_{99.7}Pt_{0.3}$ | $(Co_{90}Fe_{10})_{99.85}Mn_{0.15}$ |
| | | 260 | 33.1 | | | |
| | | 300 | 35.2 | | | |
| | | 350 | 28.4 | | | $(Co_{90}Fe_{10})_{99.7}Pt_{0.15}Mn_{0.15}$ |
| | | 400 | 24.6 | | | $(Co_{90}Fe_{10})_{99.55}Pt_{0.3}Mn_{0.15}$ |
| 148 | d) | r.t. | 16.3 | $(Co_{50}Fe_{50})_{97}Pt_{3}$ | $(Co_{50}Fe_{50})_{97}Pt_{3}$ | $(Co_{90}Fe_{10})_{99}Mn_{1}$ |
| | | 260 | 35.2 | | | |
| | | 300 | 36.7 | | | |
| | | 350 | 32.8 | | | $(Co_{90}Fe_{10})_{98}Pt_{1}Mn_{1}$ |
| | | 400 | 29.9 | | | $(Co_{90}Fe_{10})_{97}Pt_{2}Mn_{1}$ |

TABLE 8c)-2

| Sample No. | Element type | Heat treatment temperature (°C) | MR (%) | Composition 4 | Composition 5 | Composition 6 | Composition 7 | Composition 8 | Composition 9 |
|---|---|---|---|---|---|---|---|---|---|
| 145 | d) | r.t. | 15.1 | $Fe_{60}Ni_{40}$ | $Ni_{80}Fe_{20}$ | $Fe_{60}Ni_{40}$ | $Co_{90}Fe_{10}$ | $Co_{50}Fe_{50}$ | $Co_{50}Fe_{50}$ |
|  |  | 260 | 32.1 |  |  |  |  |  |  |
|  |  | 300 | 34.1 |  |  |  |  |  |  |
|  |  | 350 | 10.1 | $Fe_{57}Ni_{43}$ | $Ni_{78.9}Fe_{21.1}$ | $Fe_{57}Ni_{43}$ |  |  |  |
|  |  | 400 | 8.5 | $Fe_{54}Ni_{46}$ | $Ni_{77.8}Fe_{22.2}$ | $Fe_{54}Ni_{46}$ |  |  |  |
| 146 | d) | r.t. | 15.3 | $(Fe_{60}Ni_{40})_{99.8}Ir_{0.2}$ | $Ni_{80}Fe_{20}$ | $(Fe_{60}Ni_{40})_{99.8}Ir_{0.2}$ | $(Co_{90}Fe_{10})_{99.8}Mn_{0.1}$ | $(Co_{50}Fe_{50})_{99.8}Pt_{0.2}$ | $(Co_{50}Fe_{50})_{99.8}Pt_{0.2}$ |
|  |  | 260 | 32.4 |  |  |  |  |  |  |
|  |  | 300 | 34.3 |  |  |  |  |  |  |
|  |  | 350 | 11.1 | $(Fe_{57}Ni_{43})_{99.8}Ir_{0.2}$ | $Ni_{78.9}Fe_{21.1}$ | $(Fe_{57}Ni_{43})_{99.8}Ir_{0.2}$ | $(Co_{90}Fe_{10})_{99.8}Pt_{0.1}Mn_{0.1}$ |  |  |
|  |  | 400 | 9.5 | $(Fe_{54}Ni_{46})_{99.8}Ir_{0.2}$ | $Ni_{77.8}Fe_{22.2}$ | $(Fe_{54}Ni_{46})_{99.8}Ir_{0.2}$ | $(Co_{90}Fe_{10})_{99.7}Pt_{0.2}Mn_{0.1}$ |  |  |
| 147 | d) | r.t. | 15.5 | $(Fe_{60}Ni_{40})_{99.7}Ir_{0.3}$ | $Ni_{80}Fe_{20}$ | $(Fe_{60}Ni_{40})_{99.7}Ir_{0.3}$ | $(Co_{90}Fe_{10})_{99.85}Mn_{0.15}$ | $(Co_{50}Fe_{50})_{99.7}Pt_{0.3}$ | $(Co_{50}Fe_{50})_{99.7}Pt_{0.3}$ |
|  |  | 260 | 33.1 |  |  |  |  |  |  |
|  |  | 300 | 35.2 |  |  |  |  |  |  |
|  |  | 350 | 28.4 | $(Fe_{57}Ni_{43})_{99.7}Ir_{0.3}$ | $Ni_{78.9}Fe_{21.1}$ | $(Fe_{57}Ni_{43})_{99.8}Ir_{0.2}$ | $(Co_{90}Fe_{10})_{99.7}Pt_{0.15}Mn_{0.15}$ |  |  |
|  |  | 400 | 24.6 | $(Fe_{54}Ni_{46})_{99.7}Ir_{0.3}$ | $Ni_{77.8}Fe_{22.2}$ | $(Fe_{54}Ni_{46})_{99.8}Ir_{0.2}$ | $(Co_{90}Fe_{10})_{99.55}Pt_{0.3}Mn_{0.15}$ |  |  |
| 148 | d) | r.t. | 16.3 | $(Fe_{60}Ni_{40})_{97}Ir_{3}$ | $Ni_{80}Fe_{20}$ | $(Fe_{60}Ni_{40})_{97}Ir_{3}$ | $(Co_{90}Fe_{10})_{99}Mn_{1}$ | $(Co_{50}Fe_{50})_{97}Pt_{3}$ | $(Co_{50}Fe_{50})_{97}Pt_{3}$ |
|  |  | 260 | 35.2 |  |  |  |  |  |  |
|  |  | 300 | 36.7 |  |  |  |  |  |  |
|  |  | 350 | 32.8 | $(Fe_{56.9}Ni_{43.1})_{97.1}Ir_{2.9}$ | $Ni_{78.9}Fe_{21.1}$ | $(Fe_{56.9}Ni_{43.1})_{97.1}Ir_{2.9}$ | $(Co_{90}Fe_{10})_{98}Pt_{1}Mn_{1}$ |  |  |
|  |  | 400 | 29.9 | $(Fe_{53.8}Ni_{46.2})_{97.3}Ir_{2.7}$ | $Ni_{77.8}Fe_{22.2}$ | $(Fe_{53.8}Ni_{46.2})_{97.3}Ir_{2.7}$ | $(Co_{90}Fe_{10})_{97}Pt_{2}Mn_{1}$ |  |  |

54

TABLE 8c)-3

| Sample No. | Element type | Heat treatment temperature (°C) | MR (%) | Composition 1 | Composition 2 | Composition 3 |
|---|---|---|---|---|---|---|
| 149 | d) | r.t. | 17.5 | $(Co_{50}Fe_{50})_{85}Pt_{15}$ | $(Co_{50}Fe_{50})_{85}Pt_{15}$ | $(Co_{90}Fe_{10})_{95}Mn_5$ |
| | | 260 | 39.2 | | | |
| | | 300 | 42.4 | | | |
| | | 350 | 42.6 | | | $(Co_{90}Fe_{10})_{90}Pt_5Mn_5$ |
| | | 400 | 38.1 | | | $(Co_{90}Fe_{10})_{85}Pt_{10}Mn_5$ |
| 150 | d) | r.t. | 16.9 | $(Co_{50}Fe_{50})_{71}Pt_{29}$ | $(Co_{50}Fe_{50})_{71}Pt_{29}$ | $(Co_{90}Fe_{10})_{90.5}Mn_{9.5}$ |
| | | 260 | 37.8 | | | |
| | | 300 | 38.2 | | | |
| | | 350 | 38.1 | | | $(Co_{90}Fe_{10})_{81}Pt_{9.5}Mn_{9.5}$ |
| | | 400 | 37.9 | | | $(Co_{90}Fe_{10})_{71.5}Pt_{19}Mn_{9.5}$ |
| 151 | d) | r.t. | 15.2 | $(Co_{50}Fe_{50})_{41}Pt_{59}$ | $(Co_{50}Fe_{50})_{41}Pt_{59}$ | $(Co_{90}Fe_{10})_{80.5}Mn_{19.5}$ |
| | | 260 | 34.3 | | | |
| | | 300 | 34.5 | | | |
| | | 350 | 33.6 | | | $(Co_{90}Fe_{10})_{61}Pt_{19.5}Mn_{19.5}$ |
| | | 400 | 33.1 | | | $(Co_{90}Fe_{10})_{41.5}Pt_{39}Mn_{19.5}$ |
| 152 | d) | r.t. | 13.2 | $(Co_{50}Fe_{50})_{38}Pt_{62}$ | $(Co_{50}Fe_{50})_{38}Pt_{62}$ | $(Co_{90}Fe_{10})_{78}Mn_{21}$ |
| | | 260 | 25.9 | | | |
| | | 300 | 26.3 | | | |
| | | 350 | 14.2 | | | $(Co_{90}Fe_{10})_{58}Pt_{21}Mn_{21}$ |
| | | 400 | 12.5 | | | $(Co_{90}Fe_{10})_{37}Pt_{42}Mn_{21}$ |

TABLE 8c)-4

| Sample No. | Element type | Heat treatment temperature (°C) | MR (%) | Composition 4 | Composition 5 | Composition 6 | Composition 7 | Composition 8 | Composition 9 |
|---|---|---|---|---|---|---|---|---|---|
| 149 | d) | r.t. | 17.5 | $(Fe_{60}Ni_{40})_{85}Ir_{15}$ | $Ni_{80}Fe_{20}$ | $(Fe_{60}Ni_{40})_{85}Ir_{15}$ | $(Co_{90}Fe_{10})_{85}Mn_5$ | $(Co_{50}Fe_{50})_{85}Pt_{15}$ | $(Co_{50}Fe_{50})_{85}Pt_{15}$ |
| | | 260 | 39.2 | | | | | | |
| | | 300 | 42.4 | | | | | | |
| | | 350 | 42.6 | $(Fe_{56.5}Ni_{43.5})_{85.7}Ir_{14.3}$ | $Ni_{78.9}Fe_{21.1}$ | $(Fe_{56.5}Ni_{43.5})_{85.7}Ir_{14.3}$ | $(Co_{90}Fe_{10})_{90}Pt_1Mn_5$ | | |
| | | 400 | 38.1 | $(Fe_{53.1}Ni_{46.9})_{86.5}Ir_{13.5}$ | $Ni_{77.8}Fe_{22.2}$ | $(Fe_{53.1}Ni_{46.9})_{86.5}Ir_{13.5}$ | $(Co_{90}Fe_{10})_{85}Pt_{10}Mn_5$ | | |
| 150 | d) | r.t. | 16.9 | $(Fe_{60}Ni_{40})_{71}Ir_{29}$ | $Ni_{80}Fe_{20}$ | $(Fe_{60}Ni_{40})_{71}Ir_{29}$ | $(Co_{90}Fe_{10})_{90.5}Mn_{9.5}$ | $(Co_{50}Fe_{50})_{71}Pt_{29}$ | $(Co_{50}Fe_{50})_{71}Pt_{29}$ |
| | | 260 | 37.8 | | | | | | |
| | | 300 | 38.2 | | | | | | |
| | | 350 | 38.1 | $(Fe_{55.9}Ni_{44.1})_{72.4}Ir_{27.6}$ | $Ni_{78.9}Fe_{21.1}$ | $(Fe_{55.9}Ni_{44.1})_{72.4}Ir_{27.6}$ | $(Co_{90}Fe_{10})_{81}Pt_{9.5}Mn_{9.5}$ | | |
| | | 400 | 37.9 | $(Fe_{51.9}Ni_{48.1})_{73.9}Ir_{26.1}$ | $Ni_{77.8}Fe_{22.2}$ | $(Fe_{51.9}Ni_{48.1})_{73.9}Ir_{26.1}$ | $(Co_{90}Fe_{10})_{71.5}Pt_{19}Mn_{9.5}$ | | |
| 151 | d) | r.t. | 15.2 | $(Fe_{60}Ni_{40})_{41}Ir_{59}$ | $Ni_{80}Fe_{20}$ | $(Fe_{60}Ni_{40})_{41}Ir_{59}$ | $(Co_{90}Fe_{10})_{80.5}Mn_{19.5}$ | $(Co_{50}Fe_{50})_{41}Pt_{59}$ | $(Co_{50}Fe_{50})_{41}Pt_{59}$ |
| | | 260 | 34.3 | | | | | | |
| | | 300 | 34.5 | | | | | | |
| | | 350 | 33.6 | $(Fe_{53.2}Ni_{46.8})_{43.9}Ir_{56.1}$ | $Ni_{78.9}Fe_{21.1}$ | $(Fe_{53.2}Ni_{46.8})_{43.9}Ir_{56.1}$ | $(Co_{90}Fe_{10})_{81}Pt_{19.5}Mn_{19.5}$ | | |
| | | 400 | 33.1 | $(Fe_{47.2}Ni_{51.8})_{46.9}Ir_{53.1}$ | $Ni_{77.8}Fe_{22.2}$ | $(Fe_{47.2}Ni_{51.8})_{46.9}Ir_{53.1}$ | $(Co_{90}Fe_{10})_{41.5}Pt_{39}Mn_{19.5}$ | | |
| 152 | d) | r.t. | 13.2 | $(Fe_{60}Ni_{40})_{33}Ir_{67}$ | $Ni_{80}Fe_{20}$ | $(Fe_{60}Ni_{40})_{41}Ir_{59}$ | $(Co_{90}Fe_{10})_{79}Mn_{21}$ | $(Co_{50}Fe_{50})_{38}Pt_{62}$ | $(Co_{50}Fe_{50})_{38}Pt_{62}$ |
| | | 260 | 25.9 | | | | | | |
| | | 300 | 26.3 | | | | | | |
| | | 350 | 14.2 | $(Fe_{51.8}Ni_{48.2})_{36.3}Ir_{63.7}$ | $Ni_{78.9}Fe_{21.1}$ | $(Fe_{51.8}Ni_{48.2})_{36.3}Ir_{63.7}$ | $(Co_{90}Fe_{10})_{58}Pt_{21}Mn_{21}$ | | |
| | | 400 | 12.5 | $(Fe_{44.9}Ni_{55.1})_{39.7}Ir_{60.3}$ | $Ni_{77.8}Fe_{22.2}$ | $(Fe_{44.9}Ni_{55.1})_{39.7}Ir_{60.3}$ | $(Co_{90}Fe_{10})_{37}Pt_{42}Mn_{21}$ | | |

TABLE 8d)-1

| Sample No. | Element type | Heat treatment temperature (°C) | MR (%) | Composition 1 | Composition 2 | Composition 3 |
|---|---|---|---|---|---|---|
| 153 | c) | r.t. | 17.2 | $Co_{50}Fe_{50}$ | $Ni_{50}Fe_{50}$ | $Ni_{50}Fe_{50}$ |
| | | 260 | 30.4 | | | |
| | | 300 | 31.3 | | | |
| | | 350 | 16.7 | | | |
| | | 400 | 12.2 | | | |
| 154 | c) | r.t. | 17.3 | $Co_{50}Fe_{50}$ | $Ni_{50}Fe_{50}$ | $(Ni_{50}Fe_{50})_{99.8}Pt_{0.2}$ |
| | | 260 | 30.6 | | | |
| | | 300 | 31.1 | | | |
| | | 350 | 16.5 | | | |
| | | 400 | 13.1 | | | |
| 155 | c) | r.t. | 17.5 | $Co_{50}Fe_{50}$ | $Ni_{50}Fe_{50}$ | $(Ni_{50}Fe_{50})_{99.7}Pt_{0.3}$ |
| | | 260 | 31.2 | | | |
| | | 300 | 32.4 | | | |
| | | 350 | 27.6 | | | |
| | | 400 | 25.8 | | | |
| 156 | c) | r.t. | 18.2 | $Co_{50}Fe_{50}$ | $Ni_{50}Fe_{50}$ | $(Ni_{50}Fe_{50})_{97}Pt_{3}$ |
| | | 260 | 32.9 | | | |
| | | 300 | 33.4 | | | |
| | | 350 | 31.3 | | | |
| | | 400 | 31.1 | | | |

57

TABLE 8d)-2

| Sample No. | Element type | Heat treatment temperature (°C) | MR (%) | Composition 4 | Composition 5 | Composition 6 | Composition 7 | Composition 8 | Composition 9 |
|---|---|---|---|---|---|---|---|---|---|
| 153 | c) | r.t. | 17.2 | $Ni_{50}Fe_{50}$ | $Ni_{80}Fe_{20}$ | $Co_{75}Fe_{25}$ | $Co_{75}Pt_{25}$ | $Co_{75}Fe_{25}$ | $Co_{50}Pd_{50}$ |
| | | 260 | 30.4 | | | | | | |
| | | 300 | 31.3 | | | | | | |
| | | 350 | 16.7 | | | | | | |
| | | 400 | 12.2 | | | | | | |
| 154 | c) | r.t. | 17.3 | $Ni_{50}Fe_{50}$ | $Ni_{80}Fe_{20}$ | $Co_{75}Fe_{25}$ | $(Co_{75}Fe_{25})_{99.8}Pt_{0.14}Mn_{0.03}Cr_{0.03}$ | $Co_{75}Fe_{25}$ | $Co_{50}Pd_{50}$ |
| | | 260 | 30.6 | | | | | | |
| | | 300 | 31.1 | | | | | | |
| | | 350 | 16.5 | | | | | | |
| | | 400 | 13.1 | | | | | | |
| 155 | c) | r.t. | 17.5 | $Ni_{50}Fe_{50}$ | $Ni_{80}Fe_{20}$ | $Co_{75}Fe_{25}$ | $(Co_{75}Fe_{25})_{99.7}Pt_{0.2}Mn_{0.05}Cr_{0.05}$ | $Co_{75}Fe_{25}$ | $Co_{50}Pd_{50}$ |
| | | 260 | 31.2 | | | | | | |
| | | 300 | 32.4 | | | | | | |
| | | 350 | 27.6 | | | | | | |
| | | 400 | 25.8 | | | | | | |
| 156 | c) | r.t. | 18.2 | $Ni_{50}Fe_{50}$ | $Ni_{80}Fe_{20}$ | $Co_{75}Fe_{25}$ | $(Co_{75}Fe_{25})_{97}Pt_{2}Mn_{0.5}Cr_{0.5}$ | $Co_{75}Fe_{25}$ | $Co_{50}Pd_{50}$ |
| | | 260 | 32.9 | | | | | | |
| | | 300 | 33.4 | | | | | | |
| | | 350 | 31.3 | | | | | | |
| | | 400 | 31.1 | | | | | | |

TABLE 8d)-3

| Sample No. | Element type | Heat treatment temperature (°C) | MR (%) | Composition 1 | Composition 2 | Composition 3 |
|---|---|---|---|---|---|---|
| 157 | c) | r.t. | 17.9 | $Co_{50}Fe_{50}$ | $Ni_{50}Fe_{50}$ | $(Ni_{50}Fe_{50})_{85}Pt_{15}$ |
| | | 260 | 30.5 | | | |
| | | 300 | 31.1 | | | |
| | | 350 | 32.2 | | | |
| | | 400 | 32.7 | | | |
| 158 | c) | r.t. | 17.5 | $Co_{50}Fe_{50}$ | $Ni_{50}Fe_{50}$ | $(Ni_{50}Fe_{50})_{71}Pt_{29}$ |
| | | 260 | 29.3 | | | |
| | | 300 | 29.7 | | | |
| | | 350 | 31.3 | | | |
| | | 400 | 31.5 | | | |
| 159 | c) | r.t. | 15.6 | $Co_{50}Fe_{50}$ | $Ni_{50}Fe_{50}$ | $(Ni_{50}Fe_{50})_{41}Pt_{59}$ |
| | | 260 | 25.4 | | | |
| | | 300 | 26 | | | |
| | | 350 | 27.9 | | | |
| | | 400 | 26.1 | | | |
| 160 | c) | r.t. | 12.1 | $Co_{50}Fe_{50}$ | $Ni_{50}Fe_{50}$ | $(Ni_{50}Fe_{50})_{38}Pt_{62}$ |
| | | 260 | 20.4 | | | |
| | | 300 | 21.7 | | | |
| | | 350 | 17.2 | | | |
| | | 400 | 13.5 | | | |

TABLE 8d)-4

| Sample No. | Element type | Heat treatment temperature (°C) | MR (%) | Composition 4 | Composition 5 | Composition 6 | Composition 7 | Composition 8 | Composition 9 |
|---|---|---|---|---|---|---|---|---|---|
| 157 | c) | r.t. | 17.9 | $Ni_{50}Fe_{50}$ | $Ni_{80}Fe_{20}$ | $Co_{75}Fe_{25}$ | $(Co_{75}Fe_{25})_{85}Pt_{10}Mn_{2.5}Cr_{2.5}$ | $Co_{75}Fe_{25}$ | $Co_{50}Pd_{50}$ |
| | | 260 | 30.5 | | | | | | |
| | | 300 | 31.1 | | | | | | |
| | | 350 | 32.2 | | | | | | |
| | | 400 | 32.7 | | | | | | |
| 158 | c) | r.t. | 17.5 | $Ni_{50}Fe_{50}$ | $Ni_{80}Fe_{20}$ | $Co_{75}Fe_{25}$ | $(Co_{75}Fe_{25})_{71}Pt_{19}Mn_5Cr_5$ | $Co_{75}Fe_{25}$ | $Co_{50}Pd_{50}$ |
| | | 260 | 29.3 | | | | | | |
| | | 300 | 29.7 | | | | | | |
| | | 350 | 31.3 | | | | | | |
| | | 400 | 31.5 | | | | | | |
| 159 | c) | r.t. | 15.6 | $Ni_{50}Fe_{50}$ | $Ni_{80}Fe_{20}$ | $Co_{75}Fe_{25}$ | $(Co_{75}Fe_{25})_{41}Pt_{39}Mn_{10}Cr_{10}$ | $Co_{75}Fe_{25}$ | $Co_{50}Pd_{50}$ |
| | | 260 | 25.4 | | | | | | |
| | | 300 | 26 | | | | | | |
| | | 350 | 27.9 | | | | | | |
| | | 400 | 26.1 | | | | | | |
| 160 | c) | r.t. | 12.1 | $Ni_{50}Fe_{50}$ | $Ni_{80}Fe_{20}$ | $Co_{75}Fe_{25}$ | $(Co_{75}Fe_{25})_{38}Pt_{41}Mn_{10.5}Cr_{10.5}$ | $Co_{75}Fe_{25}$ | $Co_{50}Pd_{50}$ |
| | | 260 | 20.4 | | | | | | |
| | | 300 | 21.7 | | | | | | |
| | | 350 | 17.2 | | | | | | |
| | | 400 | 13.5 | | | | | | |

In the samples shown in Table 5a), Re is added to the vicinity of each of the interfaces of the non-magnetic layer. According to Table 5a), it is preferable that Re has a concentration of 3 to 30 at%. However, the Mn diffusion is not suppressed here. One of the reasons for this is that Re is not added to the vicinity of the interface with the antiferromagnetic layer. The same tendency can be obtained by replacing Re with Ru, Os, Rh, Ir, Pd, Pt, Cu, Au or the like. Moreover, the same tendency can be obtained by modifying the ferromagnetic layers to the above compositions.

In the samples shown in Table 5b), another element is added to both sides of the non-magnetic layer. This can provide the same effect as well. Moreover, the same effect can be obtained by replacing Ru in Table 5b) with Tc, Re, Rh, Ir, Pd, Pt, Ag or Au and replacing Os with Tc, Re, Rh, Ir, Pd, Pt, Cu or Au. The modification of the ferromagnetic layers to the above compositions also can provide the same tendency.

In the samples shown in Table 5c), Pt and Cu are added only to one of the interfaces of the non-magnetic layer. This can provide the same tendency as well. Moreover, the same tendency can be obtained by replacing (Pt, Cu) in Table 5c) with Tc, Re, Rh, Ir, Pd, Pt, Ag, Au, (Ru, Ir), (Pt, Pd), (Pt, Au), (Ir, Rh), (Ru, Pd), (Tc, Re, Ag), (Ru, Os, Ir), (Rh, Ir, Pt), (Pd, Pt, Cu), (Cu, Ag, Au), (Re, Ru, Os), (Ru, Rh, Pd), (Ir, Pt, Cu) or (Re, Ir, Ag). The modification of the ferromagnetic layers to the above compositions also can provide the same tendency.

Tables 5d) to 8a) show the results obtained when Mn and Pt are added. Table 5d) corresponds to the addition of Mn in an amount of zero at%. Tables 6a) to 8a) show the results of a change in amount of Pt according to the addition of Mn in an amount of 0.2, 0.5, 1, 2, 5, 8, 12, 19 or 22 at%.

There is a little Mn, which is diffused from the antiferromagnetic layer, at the interface in a region containing a small amount of Pt. However, the diffusion can be suppressed by adding Pt.

Tables 8b) to 8d) show the measurements on elements, each having a plurality of non-magnetic layers. Even if a plurality of barriers are present due to the non-magnetic layers, the MR characteristics after heat treatment can be improved by controlling the composition in the vicinity of either of the interfaces of at least one of the non-magnetic layers.

Table 9a) shows the ratios of MR ratios of each sample including Mn and Pt after heat treatment at 350°C and 400°C to MR ratios of a sample to which neither Mn nor Pt is added (i.e., the sample 57).

In Table 9a), the amounts of Pt and (Pt + Mn) correspond to the amount of each element in the composition 4 of a sample before heat treatment.

Table 9b) shows the ratios of MR ratios of each sample to MR ratios of a sample in which the amount of Pt is zero for each addition of Mn.

Favorable characteristics were obtained when the amount of addition of Pt was 0.3 to 60 at% and that of Mn was not more than 20 at%, particularly in the range of Mn < Pt. It was confirmed that the characteristics might be improved more by simultaneously adding Mn and Pt than by adding Pt alone in a region where Mn was 8 to 5 at% or less and Mn < Pt. The same tendency was obtained by an element to which Cr or (Mn, Cr) was added in a ratio from 1 : 0.01 to 1 : 100 instead of Mn. Moreover, the same tendency was obtained by adding the elements used in Tables 4a) to 5c) instead of Pt. Further, the same tendency was obtained by using the ferromagnetic layers in Table 4.

Some elements (not shown in Tables 4a) to 9b)), each having a composition falling between those of the samples shown in Tables, were produced. These elements also had the same tendency.

Tables 4a) to 9b) show the results of heat treatment up to 400°C. However, some samples were heat-treated at 400°C to 540°C in increments of 10°C, thus measuring the MR characteristics. Consequently, the magnetoresistive element that included the additional element $M^1$ such as Pt in an amount of 0.3 to 60 at% had excellent MR characteristics after heat treatment up to 450°C as compared with the element that did not include the element $M^1$. In particular, when the amount of addition was 3 to 30 at%, excellent MR characteristics were obtained after heat treatment up to 500°C as compared with the element that did not include the element $M^1$.

The same measurement was performed on the element to which Mn and Cr (the additional element $M^2$) were added simultaneously with $M^1$. Consequently, the magnetoresistive element that included 0.3 to 60 at% of $M^1$ and achieved $M^2 < M^1$ had relatively excellent MR characteristics after heat treatment up to 450°C. Moreover, the element that included 3 to 30 at% of $M^1$ and less than 8 at% of $M^2$ and achieved $M^2 < M^1$ had relatively excellent MR characteristics after heat treatment up to 500°C as compared with the element that included neither $M^1$ and $M^2$.

The above description shows the results obtained when an AlOx film formed by natural oxidation is used as the non-magnetic layer. However, the same tendency can be obtained by using the following films as the non-magnetic layer: AlO with plasma oxidation; AlO with ion radical oxidation; AlO with reactive evaporation, AlN with natural nitridation; AlN with plasma nitridation; AlN with reactive evaporation; BN with plasma nitridation or reactive evaporation, TaO with thermal oxidation, plasma oxidation, or ion radical oxidation; AlSiO with thermal oxidation, natural oxidation, or plasma oxidation; and AlON with natural oxynitridation, plasma oxynitridation, or reactive sputtering.

The same tendency can be obtained by using FeMn, NiMn, IrMn, PtMn, RhMn, CrMnPt, CrAl, CrRu, CrRh, CrOs, CrIr, CrPt, or TbCo as the antiferromagnetic layer instead of PdPtMn.

The same tendency can be obtained by using Rh (thickness: 0.4 to 1.9 nm), Ir (0.3 to 1.4 nm), or Cr (0.9 to 1.4 nm) as the non-magnetic metal instead of Ru (0.7 to 0.9 nm).

Basically the same tendency can be obtained from each of the elements having the configurations shown in the drawings.

Example 3

In this example, magnetoresistive elements were produced by the same methods of film forming and processing as those in Examples 1 and 2. The composition was measured in the same manner as that in Example 2.

An AlON film (thickness: 1.0 to 2 nm) was used as the non-magnetic layer. The AlON film was produced by oxynitriding an Al film in a chamber filled with a mixed gas of pure oxygen and high purity nitrogen with a radio of 1 : 1. Rh (1.4 to 1.9 nm) was used as the non-magnetic metal film, and PtMn (20 to 30 nm) was used as the antiferromagnetic layer.

The element configuration and the ferromagnetic layers were the same as those of the samples shown in Tables 5d) to 8a). In this example, the effect of adding Ta and N was measured in addition to Pt and Mn.

Like Example 2, the characteristics after heat treatment up to 540°C were examined. Here, the measurements at 350°C and 400°C, both indicating distinctive features, were described. In this example, a coercive force of the free layer was measured as the magnetic characteristics. Tables 10 to 22 report the coercive force relative to the composition of elements present at each of the interfaces.

The magnetic characteristics of the samples whose coercive forces are not shown in Tables cannot be measured. The addition of Ta and N improves the soft magnetic characteristics. However, when the amount of non-magnetic additives is not less than about 70 at%, it is impossible to measure the magnetic characteristics.

The MR characteristics of the samples in Tables 10, 11, 12, 15, 16, 19 and 20 are within ± 10% after heat treatment, compared with the element that does not include Ta and N. The MR characteristics of the samples in Tables 13, 17 and 21 are degraded by about 10 to 20%, and those of the samples in Tables 14, 18 and 22 are degraded by about 50 to 60%.

The same tendency can be obtained by replacing Ta with Ti, Zr, Hf, V, Nb, Mo, W, Al, Si, Ga, Ge, In or Sn. Moreover, the same tendency can be obtained by replacing N with B, C or O.

Example 4

In this example, magnetoresistive elements were produced by the same method of film forming and processing as those in Examples 1 and 2. The composition was measured in the same manner as that in Example 2.

An AlOx film (thickness: 1.0 to 2 nm) was used as the non-magnetic layer. The AlOx film was produced by oxidizing an Al film with an ion radical source of O. Ir (1.2 to 1.4 nm) was used as the non-magnetic metal layer, and NiMn (30 to 40 nm) was used as the antiferromagnetic layer.

The element configuration and the ferromagnetic layers were the same as those of the samples shown in Tables 4 to 8. In this example, Pt, Pr and Au were added to examine the MR characteristics after each of the heat treatments and the stability of solid solution.

The solid solution was evaluated in the following manner. First, the elements were heat-treated at different temperatures of 350°C, 400°C, 450°C and 500°C. Then, the composition at the interfaces of the non-magnetic layer of each of the elements was determined, e.g., by XPS analysis after AES depth profile, SIMS, and milling. Next, alloy samples having the composition thus determined were produced separately, which then were heat-treated in the atmosphere of a reduced pressure ($10^{-5}$ Pa) at 350°C, 400°C, 450°C and 500°C for 24 hours. The surfaces of the alloy samples were etched chemically and observed with a metallurgical microscope. After etching, ion milling was performed in the atmosphere of a reduced pressure, followed by structural observation with a scanning electron microscope (SEM) and in-plane composition analysis with EDX. Finally, whether the alloy samples had a single phase was evaluated based on the measurements.

When composition distribution and a plurality of phases were observed in the alloy sample whose heat treatment temperature and composition corresponded to those of the magnetoresistive element, the MR characteristics of this element were improved by about 30 to 100%, compared with the element that did not include $M^1$ or the like. When the alloy sample showed a single phase, the MR characteristics of the corresponding element were improved by about 80 to 200%, compared with the element that included no additional element. The element that corresponded to the alloy sample having a stable single phase provided even more favorable MR characteristics after heat treatment.

Example 5

Using the samples in Tables 4d), 5a), 5c), and 5d) of Example 2, the diffusion effect of Mn observed after heat treatment was controlled by appropriately changing the distance between the interface of antiferromagnetic layer/ferromagnetic layer and the interface of ferromagnetic layer/non-magnetic layer and heat treatment temperatures. Here, the heat treatment temperature was 300°C or more. This control was performed so that Mn at the interfaces of the non-magnetic layer was 20 to 0.5 at% after heat treatment. When the distance was less than 3 nm, the content of the magnetic elements (Fe, Co, Ni) was reduced to 40 at% or less after heat treatment even with the addition of Pt or the like, resulting in a significant degradation of the MR characteristics. When the distance was more than 50 nm, heat treatment at 400°C or more was required only for increasing the content of Mn at the interfaces by 0.5 at%. Since the distance was too long, a sufficient effect of fixing the magnetization directions of the ferromagnetic layers was not obtained from the antiferromagnetic layer, resulting in a significant degradation of the MR characteristics after heat treatment.

## TABLE 9a)

| | Amount of Mn | | 1 | 2 | 3 | 4 | 5 | 6 | 7 | 8 |
|---|---|---|---|---|---|---|---|---|---|---|---|
| TABLE 5d) | 0 | Amount of Pt | 0 | 0.2 | 0.3 | 3 | 15 | 29 | 59 | 62 |
| | | Amount of Pt+Mn | 0 | 0.2 | 0.3 | 3 | 15 | 29 | 59 | 62 |
| | | 350°C | 1 | 1.02 | 1.44 | 1.52 | 1.61 | 1.54 | 1.46 | 0.98 |
| | | 400°C | 1 | 1.02 | 1.92 | 1.99 | 2.45 | 2.21 | 1.95 | 1.05 |
| TABLE 6a) | 0.2 | Amount of Pt | 0 | 0.2 | 0.3 | 2.8 | 14.8 | 28.8 | 58.8 | 61.8 |
| | | Amount of Pt+Mn | 0.2 | 0.4 | 0.5 | 3 | 15 | 29 | 59 | 62 |
| | | 350°C | 1 | 1.03 | 1.56 | 1.78 | 1.81 | 1.68 | 1.51 | 0.99 |
| | | 400°C | 1 | 1.03 | 2.21 | 2.43 | 2.62 | 2.51 | 2.27 | 1.06 |
| TABLE 6b) | 0.5 | Amount of Pt | 0 | 0.2 | 0.3 | 2.5 | 14.5 | 28.5 | 58.5 | 61.5 |
| | | Amount of Pt+Mn | 0.5 | 0.7 | 0.8 | 3 | 15 | 29 | 59 | 62 |
| | | 350°C | 1 | 1.01 | 1.46 | 1.77 | 1.97 | 1.9 | 1.74 | 1 |
| | | 400°C | 1 | 1.01 | 1.98 | 2.42 | 2.73 | 2.71 | 2.5 | 1.06 |
| TABLE 6c) | 1 | Amount of Pt | 0 | 0.2 | 0.3 | 2 | 14 | 28 | 58 | 61 |
| | | Amount of Pt+Mn | 1 | 1.2 | 1.3 | 3 | 15 | 29 | 59 | 62 |
| | | 350°C | 1 | 1.01 | 1.45 | 1.76 | 2.07 | 1.96 | 1.84 | 1.04 |
| | | 400°C | 1 | 1.01 | 1.91 | 2.4 | 2.9 | 2.81 | 2.61 | 1.1 |
| TABLE 6d) | 2 | Amount of Pt | 0 | 0.2 | 0.3 | 2 | 13 | 27 | 57 | 60 |
| | | Amount of Pt+Mn | 2 | 2.2 | 2.3 | 4 | 15 | 29 | 59 | 62 |
| | | 350°C | 1 | 1.01 | 1.44 | 1.76 | 2.17 | 2.06 | 1.98 | 1.06 |
| | | 400°C | 1 | 1.01 | 1.9 | 2.39 | 3.13 | 2.98 | 2.81 | 1.12 |
| TABLE 7a) | 5 | Amount of Pt | 0 | 0.2 | 0.3 | 2 | 10 | 24 | 54 | 57 |
| | | Amount of Pt+Mn | 5 | 5.2 | 5.3 | 7 | 15 | 29 | 59 | 62 |
| | | 350°C | 1 | 1.01 | 1.43 | 1.7 | 2.16 | 1.98 | 1.86 | 1.05 |
| | | 400°C | 1 | 1.01 | 1.89 | 2.21 | 3.04 | 2.92 | 2.73 | 1.11 |
| TABLE 7b) | 8 | Amount of Pt | 0 | 0.2 | 0.3 | 2 | 7 | 21 | 51 | 54 |
| | | Amount of Pt+Mn | 8 | 8.2 | 8.3 | 10 | 15 | 29 | 59 | 62 |
| | | 350°C | 1 | 1.01 | 1.39 | 1.6 | 1.8 | 1.69 | 1.59 | 1.02 |
| | | 400°C | 1 | 1.01 | 1.8 | 2.09 | 2.6 | 2.38 | 2.27 | 1.07 |
| TABLE 7c) | 12 | Amount of Pt | 0 | 0.2 | 0.3 | 2 | 7 | 17 | 47 | 50 |
| | | Amount of Pt+Mn | 12 | 12.2 | 12.3 | 14 | 19 | 29 | 59 | 62 |
| | | 350°C | 1 | 1.01 | 1.38 | 1.51 | 1.6 | 1.58 | 1.47 | 1 |
| | | 400°C | 1 | 1.01 | 1.77 | 2 | 2.2 | 2.17 | 2 | 1.02 |
| TABLE 7d) | 19 | Amount of Pt | 0 | 0.2 | 0.3 | 2 | 7 | 10 | 40 | 43 |
| | | Amount of Pt+Mn | 19 | 19.2 | 19.3 | 21 | 26 | 29 | 59 | 62 |
| | | 350°C | 1 | 1 | 1.36 | 1.41 | 1.52 | 1.44 | 1.33 | 0.94 |
| | | 400°C | 1 | 1 | 1.71 | 1.8 | 1.95 | 1.87 | 1.71 | 0.99 |
| TABLE 8a) | 22 | Amount of Pt | 0 | 0.2 | 0.3 | 2 | 7 | 10 | 37 | 40 |
| | | Amount of Pt+Mn | 22 | 22.2 | 22.3 | 24 | 29 | 32 | 59 | 62 |
| | | 350°C | 1 | 0.99 | 1.1 | 1.11 | 1.13 | 1.1 | 1.01 | 0.86 |
| | | 400°C | 1 | 0.99 | 1.16 | 1.19 | 1.21 | 1.2 | 0.99 | 1.01 |

## TABLE 9b)

| | | Amount of Mn | 1 | 2 | 3 | 4 | 5 | 6 | 7 | 8 |
|---|---|---|---|---|---|---|---|---|---|---|
| TABLE 5d) | 0 | Amount of Pt | 0 | 0.2 | 0.3 | 3 | 15 | 29 | 59 | 62 |
| | | Amount of Pt+Mn | 0 | 0.2 | 0.3 | 3 | 15 | 29 | 59 | 62 |
| | | 350°C | 1 | 1.02 | 1.44 | 1.52 | 1.61 | 1.54 | 1.46 | 0.98 |
| | | 400°C | 1 | 1.02 | 1.92 | 1.99 | 2.45 | 2.21 | 1.95 | 1.05 |
| TABLE 6a) | 0.2 | Amount of Pt | 0 | 0.2 | 0.3 | 2.8 | 14.8 | 28.8 | 58.8 | 61.8 |
| | | Amount of Pt+Mn | 0.2 | 0.4 | 0.5 | 3 | 15 | 29 | 59 | 62 |
| | | 350°C | 1 | 1.03 | 1.56 | 1.78 | 1.81 | 1.68 | 1.51 | 0.99 |
| | | 400°C | 1 | 1.03 | 2.21 | 2.43 | 2.62 | 2.51 | 2.27 | 1.06 |
| TABLE 6b) | 0.5 | Amount of Pt | 0 | 0.2 | 0.3 | 2.5 | 14.5 | 28.5 | 58.5 | 61.5 |
| | | Amount of Pt+Mn | 0.5 | 0.7 | 0.8 | 3 | 15 | 29 | 59 | 62 |
| | | 350°C | 1 | 1.01 | 1.46 | 1.77 | 1.97 | 1.9 | 1.74 | 1 |
| | | 400°C | 1 | 1.01 | 1.98 | 2.42 | 2.73 | 2.71 | 2.5 | 1.06 |
| TABLE 6c) | 1 | Amount of Pt | 0 | 0.2 | 0.3 | 2 | 14 | 28 | 58 | 61 |
| | | Amount of Pt+Mn | 1 | 1.2 | 1.3 | 3 | 15 | 29 | 59 | 62 |
| | | 350°C | 1 | 1.01 | 1.45 | 1.76 | 2.07 | 1.96 | 1.84 | 1.04 |
| | | 400°C | 1 | 1.01 | 1.91 | 2.4 | 2.9 | 2.81 | 2.61 | 1.1 |
| TABLE 6d) | 2 | Amount of Pt | 0 | 0.2 | 0.3 | 2 | 13 | 27 | 57 | 60 |
| | | Amount of Pt+Mn | 2 | 2.2 | 2.3 | 4 | 15 | 29 | 59 | 62 |
| | | 350°C | 1 | 1.01 | 1.44 | 1.76 | 2.17 | 2.06 | 1.98 | 1.06 |
| | | 400°C | 1 | 1.01 | 1.9 | 2.39 | 3.13 | 2.98 | 2.81 | 1.12 |
| TABLE 7a) | 5 | Amount of Pt | 0 | 0.2 | 0.3 | 2 | 10 | 24 | 54 | 57 |
| | | Amount of Pt+Mn | 5 | 5.2 | 5.3 | 7 | 15 | 29 | 59 | 62 |
| | | 350°C | 1 | 1.01 | 1.43 | 1.7 | 2.16 | 1.98 | 1.86 | 1.05 |
| | | 400°C | 1 | 1.01 | 1.89 | 2.21 | 3.04 | 2.92 | 2.73 | 1.11 |
| TABLE 7b) | 8 | Amount of Pt | 0 | 0.2 | 0.3 | 2 | 7 | 21 | 51 | 54 |
| | | Amount of Pt+Mn | 8 | 8.2 | 8.3 | 10 | 15 | 29 | 59 | 62 |
| | | 350°C | 1 | 1.01 | 1.39 | 1.6 | 1.8 | 1.69 | 1.59 | 1.02 |
| | | 400°C | 1 | 1.01 | 1.8 | 2.09 | 2.6 | 2.38 | 2.27 | 1.07 |
| TABLE 7c) | 12 | Amount of Pt | 0 | 0.2 | 0.3 | 2 | 7 | 17 | 47 | 50 |
| | | Amount of Pt+Mn | 12 | 12.2 | 12.3 | 14 | 19 | 29 | 59 | 62 |
| | | 350°C | 1 | 1.01 | 1.38 | 1.51 | 1.6 | 1.58 | 1.47 | 1 |
| | | 400°C | 1 | 1.01 | 1.77 | 2 | 2.2 | 2.17 | 2 | 1.02 |
| TABLE 7d) | 19 | Amount of Pt | 0 | 0.2 | 0.3 | 2 | 7 | 10 | 40 | 43 |
| | | Amount of Pt+Mn | 19 | 19.2 | 19.3 | 21 | 26 | 29 | 59 | 62 |
| | | 350°C | 1 | 1 | 1.36 | 1.41 | 1.52 | 1.44 | 1.33 | 0.94 |
| | | 400°C | 1 | 1 | 1.71 | 1.8 | 1.95 | 1.87 | 1.71 | 0.99 |
| TABLE 8a) | 22 | Amount of Pt | 0 | 0.2 | 0.3 | 2 | 7 | 10 | 37 | 40 |
| | | Amount of Pt+Mn | 22 | 22.2 | 22.3 | 24 | 29 | 32 | 59 | 62 |
| | | 350°C | 1 | 0.99 | 1.1 | 1.11 | 1.13 | 1.1 | 1.01 | 0.86 |
| | | 400°C | 1 | 0.99 | 1.16 | 1.19 | 1.21 | 1.2 | 0.99 | 1.01 |

TABLE 10

| (Ta = 0, N = 0) | | | | | | | | | |
|---|---|---|---|---|---|---|---|---|---|
| Amount of Mn | | | | | | | | | |
| 0 | Amount of Pt | 0 | 0.2 | 0.3 | 3 | 15 | 29 | 59 | 62 |
| | Total amount of additional elements | 0 | 0.2 | 0.3 | 3 | 15 | 29 | 59 | 62 |
| | 350°C | 98 | 98 | 99 | 113 | 127 | 147 | 196 | 196 |
| | 400°C | 88 | 88 | 89 | 101 | 115 | 132 | 176 | 176 |
| 0.5 | Amount of Pt | 0 | 0.2 | 0.3 | 2.5 | 14.5 | 28.5 | 58.5 | 61.5 |
| | Total amount of additional elements | 0.5 | 0.7 | 0.8 | 3 | 15 | 29 | 59 | 62 |
| | 350°C | 97 | 97 | 98 | 112 | 126 | 146 | 194 | 194 |
| | 400°C | 87 | 87 | 88 | 100 | 114 | 131 | 175 | 175 |
| 1 | Amount of Pt | 0 | 0.2 | 0.3 | 2 | 14 | 28 | 58 | 61 |
| | Total amount of additional elements | 1 | 1.2 | 1.3 | 3 | 15 | 29 | 59 | 62 |
| | 350°C | 93 | 93 | 94 | 107 | 121 | 140 | 186 | 186 |
| | 400°C | 84 | 84 | 85 | 96 | 109 | 126 | 168 | 168 |
| 5 | Amount of Pt | 0 | 0.2 | 0.3 | 2 | 10 | 24 | 54 | 57 |
| | Total amount of additional elements | 5 | 5.2 | 5.3 | 7 | 15 | 29 | 59 | 62 |
| | 350°C | 88 | 88 | 89 | 101 | 115 | 132 | 176 | 176 |
| | 400°C | 79 | 79 | 80 | 91 | 103 | 119 | 159 | 159 |
| 8 | Amount of Pt | 0 | 0.2 | 0.3 | 2 | 7 | 21 | 51 | 54 |
| | Total amount of additional elements | 8 | 8.2 | 8.3 | 10 | 15 | 29 | 59 | 62 |
| | 350°C | 93 | 93 | 94 | 107 | 121 | 140 | 186 | 186 |
| | 400°C | 84 | 84 | 85 | 96 | 109 | 126 | 168 | 168 |
| 19 | Amount of Pt | 0 | 0.2 | 0.3 | 2 | 7 | 10 | 40 | 43 |
| | Total amount of additional elements | 19 | 19.2 | 19.3 | 21 | 26 | 29 | 59 | 62 |
| | 350°C | 96 | 96 | 97 | 110 | 125 | 144 | 192 | 192 |
| | 400°C | 86 | 86 | 87 | 99 | 112 | 130 | 173 | 173 |
| 22 | Amount of Pt | 0 | 0.2 | 0.3 | 2 | 7 | 10 | 37 | 40 |
| | Total amount of additional elements | 22 | 22.2 | 22.3 | 24 | 29 | 32 | 59 | 62 |
| | 350°C | 100 | 100 | 101 | 115 | 130 | 150 | 200 | 200 |
| | 400°C | 90 | 90 | 91 | 103 | 117 | 135 | 180 | 180 |

TABLE 11

| (Ta = 1, N = 0) | | | | | | | | | |
|---|---|---|---|---|---|---|---|---|---|
| Amount of Mn | | | | | | | | | |
| 0 | Amount of Pt | 0 | 0.2 | 0.3 | 3 | 15 | 29 | 59 | 62 |
| | Total amount of additional elements | 1 | 1.2 | 1.3 | 4 | 16 | 30 | 60 | 63 |
| | 350°C | 99 | 99 | 100 | 114 | 129 | 149 | 198 | 198 |
| | 400°C | 89 | 89 | 90 | 102 | 116 | 134 | 178 | 178 |
| 0.5 | Amount of Pt | 0 | 0.2 | 0.3 | 2.5 | 14.5 | 28.5 | 58.5 | 61.5 |
| | Total amount of additional elements | 1.5 | 1.7 | 1.8 | 4 | 16 | 30 | 60 | 63 |
| | 350°C | 98 | 98 | 99 | 113 | 127 | 147 | 196 | 196 |
| | 400°C | 88 | 88 | 89 | 101 | 115 | 132 | 176 | 176 |
| 1 | Amount of Pt | 0 | 0.2 | 0.3 | 2 | 14 | 28 | 58 | 61 |
| | Total amount of additional elements | 2 | 2.2 | 2.3 | 4 | 16 | 30 | 60 | 63 |
| | 350°C | 94 | 94 | 95 | 108 | 122 | 141 | 188 | 188 |
| | 400°C | 85 | 85 | 85 | 97 | 110 | 127 | 169 | 169 |
| 5 | Amount of Pt | 0 | 0.2 | 0.3 | 2 | 10 | 24 | 54 | 57 |
| | Total amount of additional elements | 6 | 6.2 | 6.3 | 8 | 16 | 30 | 60 | 63 |
| | 350°C | 89 | 89 | 90 | 102 | 116 | 134 | 178 | 178 |
| | 400°C | 80 | 80 | 81 | 92 | 104 | 120 | 160 | 160 |
| 8 | Amount of Pt | 0 | 0.2 | 0.3 | 2 | 7 | 21 | 51 | 54 |
| | Total amount of additional elements | 9 | 9.2 | 9.3 | 11 | 16 | 30 | 60 | 63 |
| | 350°C | 94 | 94 | 95 | 108 | 122 | 141 | 188 | 188 |
| | 400°C | 85 | 85 | 85 | 97 | 110 | 127 | 169 | 169 |
| 19 | Amount of Pt | 0 | 0.2 | 0.3 | 2 | 7 | 10 | 40 | 43 |
| | Total amount of additional elements | 20 | 20.2 | 20.3 | 22 | 27 | 30 | 60 | 63 |
| | 350°C | 97 | 97 | 98 | 112 | 126 | 146 | 194 | 194 |
| | 400°C | 87 | 87 | 88 | 100 | 114 | 131 | 175 | 175 |
| 22 | Amount of Pt | 0 | 0.2 | 0.3 | 2 | 7 | 10 | 37 | 40 |
| | Total amount of additional elements | 23 | 23.2 | 23.3 | 25 | 30 | 33 | 60 | 63 |
| | 350°C | 101 | 101 | 102 | 116 | 131 | 151 | 202 | 202 |
| | 400°C | 91 | 91 | 92 | 105 | 118 | 136 | 182 | 182 |

TABLE 12

| (Ta = 15, N = 0) | | | | | | | | | |
|---|---|---|---|---|---|---|---|---|---|
| Amount of Mn | | | | | | | | | |
| 0 | Amount of Pt | 0 | 0.2 | 0.3 | 3 | 15 | 29 | 59 | 62 |
| | Total amount of additional elements | 15 | 15.2 | 15.3 | 18 | 30 | 44 | 74 | 77 |
| | 350°C | 58 | 58 | 59 | 67 | 75 | 87 | - | - |
| | 400°C | 52 | 52 | 53 | 60 | 68 | 78 | - | - |
| 0.5 | Amount of Pt | 0 | 0.2 | 0.3 | 2.5 | 14.5 | 28.5. | 58.5 | 61.5 |
| | Total amount of additional elements | 15.5 | 15.7 | 15.8 | 18 | 30 | 44 | 74 | 77 |
| | 350°C | 57 | 57 | 58 | 66 | 75 | 86 | - | - |
| | 400°C | 52 | 52 | 52 | 59 | 67 | 78 | - | - |
| 1 | Amount of Pt | 0 | 0.2 | 0.3 | 2 | 14 | 28 | 58 | 61 |
| | Total amount of additional elements | 16 | 16.2 | 16.3 | 18 | 30 | 44 | 74 | 77 |
| | 350°C | 55 | 55 | 56 | 63 | 72 | 83 | - | - |
| | 400°C | 50 | 50 | 50 | 57 | 64 | 74 | - | - |
| 5 | Amount of Pt | 0 | 0.2 | 0.3 | 2 | 10 | 24 | 54 | 57 |
| | Total amount of additional elements | 20 | 20.2 | 20.3 | 22 | 30 | 44 | 74 | 77 |
| | 350°C | 52 | 52 | 53 | 60 | 68 | 78 | - | - |
| | 400°C | 47 | 47 | 47 | 54 | 61 | 70 | - | - |
| 8 | Amount of Pt | 0 | 0.2 | 0.3 | 2 | 7 | 21 | 51 | 54 |
| | Total amount of additional elements | 23 | 23.2 | 23.3 | 25 | 30 | 44 | 74 | 77 |
| | 350°C | 55 | 55 | 56 | 63 | 72 | 83 | - | - |
| | 400°C | 50 | 50 | 50 | 57 | 64 | 74 | - | - |
| 19 | Amount of Pt | 0 | 0.2 | 0.3 | 2 | 7 | 10 | 40 | 43 |
| | Total amount of additional elements | 34 | 34.2 | 34.3 | 36 | 41 | 44 | 74 | 77 |
| | 350°C | 57 | 57 | 57 | 65 | 74 | 85 | - | - |
| | 400°C | 51 | 51 | 52 | 59 | 67 | 77 | - | - |
| 22 | Amount of Pt | 0 | 0.2 | 0.3 | 2 | 7 | 10 | 37 | 40 |
| | Total amount of additional elements | 37 | 37.2 | 37.3 | 39 | 44 | 47 | 74 | 77 |
| | 350°C | 59 | 59 | 60 | 68 | 77 | 89 | - | - |
| | 400°C | 53 | 53 | 54 | 61 | 69 | 80 | - | - |

TABLE 13

| (Ta = 29, N = 0) | | | | | | | | | |
|---|---|---|---|---|---|---|---|---|---|
| Amount of Mn | | | | | | | | | |
| 0 | Amount of Pt | 0 | 0.2 | 0.3 | 3 | 15 | 29 | 59 | 62 |
| | Total amount of additional elements | 29 | 29.2 | 29.3 | 32 | 44 | 58 | 88 | 91 |
| | 350°C | 22 | 22 | 22 | 25 | 29 | 33 | - | - |
| | 400°C | 20 | 20 | 20 | 23 | 26 | 30 | - | - |
| 0.5 | Amount of Pt | 0 | 0.2 | 0.3 | 2.5 | 14.5 | 28.5 | 58.5 | 61.5 |
| | Total amount of additional elements | 29.5 | 29.7 | 29.8 | 32 | 44 | 58 | 88 | 91 |
| | 350°C | 22 | 22 | 22 | 25 | 28 | 33 | - | - |
| | 400°C | 20 | 20 | 20 | 23 | 25 | 29 | - | - |
| 1 | Amount of Pt | 0 | 0.2 | 0.3 | 2 | 14 | 28 | 58 | 61 |
| | Total amount of additional elements | 30 | 30.2 | 30.3 | 32 | 44 | 58 | 88 | 91 |
| | 350°C | 21 | 21 | 21 | 24 | 27 | 31 | - | - |
| | 400°C | 19 | 19 | 19 | 22 | 24 | 28 | - | - |
| 5 | Amount of Pt | 0 | 0.2 | 0.3 | 2 | 10 | 24 | 54 | 57 |
| | Total amount of additional elements | 34 | 34.2 | 34.3 | 36 | 44 | 58 | 88 | 91 |
| | 350°C | 20 | 20 | 20 | 23 | 26 | 30 | - | - |
| | 400°C | 18 | 18 | 18 | 20 | 23 | 27 | - | - |
| 8 | Amount of Pt | 0 | 0.2 | 0.3 | 2 | 7 | 21 | 51 | 54 |
| | Total amount of additional elements | 37 | 37.2 | 37.3 | 39 | 44 | 58 | 88 | 91 |
| | 350°C | 21 | 21 | 21 | 24 | 27 | 31 | - | - |
| | 400°C | 19 | 19 | 19 | 22 | 24 | 28 | - | - |
| 19 | Amount of Pt | 0 | 0.2 | 0.3 | 2 | 7 | 10 | 40 | 43 |
| | Total amount of additional elements | 48 | 48.2 | 48.3 | 50 | 55 | 58 | 88 | 91 |
| | 350°C | 22 | 22 | 22 | 25 | 28 | 32 | - | - |
| | 400°C | 19 | 19 | 20 | 22 | 25 | 29 | - | - |
| 22 | Amount of Pt | 0 | 0.2 | 0.3 | 2 | 7 | 10 | 37 | 40 |
| | Total amount of additional elements | 51 | 51.2 | 51.3 | 53 | 58 | 61 | 88 | 91 |
| | 350°C | 22 | 22 | 23 | 26 | 29 | 34 | - | - |
| | 400°C | 20 | 20 | 20 | 23 | 26 | 30 | - | - |

TABLE 14

| (Ta = 31, N = 0) | | | | | | | | | |
|---|---|---|---|---|---|---|---|---|---|
| Amount of Mn | | | | | | | | | |
| 0 | Amount of Pt | 0 | 0.2 | 0.3 | 3 | 15 | 29 | 59 | 62 |
| | Total amount of additional elements | 31 | 31.2 | 31.3 | 34 | 46 | 60 | 90 | 93 |
| | 350°C | 18 | 18 | 18 | 21 | 23 | 27 | - | - |
| | 400°C | 16 | 16 | 16 | 19 | 21 | 24 | - | - |
| 0.5 | Amount of Pt | 0 | 0.2 | 0.3 | 2.5 | 14.5 | 28.5 | 58.5 | 61.5 |
| | Total amount of additional elements | 31.5 | 31.7 | 31.8 | 34 | 46 | 60 | 90 | 93 |
| | 350°C | 18 | 18 | 18 | 20 | 23 | 27 | - | - |
| | 400°C | 16 | 16 | 16 | 18 | 21 | 24 | - | - |
| 1 | Amount of Pt | 0 | 0.2 | 0.3 | 2 | 14 | 28 | 58 | 61 |
| | Total amount of additional elements | 32 | 322 | 32.3 | 34 | 46 | 60 | 90 | 93 |
| | 350°C | 17 | 17 | 17 | 20 | 22 | 26 | - | - |
| | 400°C | 15 | 15 | 16 | 18 | 20 | 23 | - | - |
| 5 | Amount of Pt | 0 | 0.2 | 0.3 | 2 | 10 | 24 | 54 | 57 |
| | Total amount of additional elements | 36 | 36.2 | 36.3 | 38 | 46 | 60 | 90 | 93 |
| | 350°C | 16 | 16 | 16 | 19 | 21 | 24 | - | - |
| | 400°C | 15 | 15 | 15 | 17 | 19 | 22 | - | - |
| 8 | Amount of Pt | 0 | 0.2 | 0.3 | 2 | 7 | 21 | 51 | 54 |
| | Total amount of additional elements | 39 | 39.2 | 39.3 | 41 | 46 | 60 | 90 | 93 |
| | 350°C | 17 | 17 | 17 | 20 | 22 | 26 | - | - |
| | 400°C | 15 | 15 | 16 | 18 | 20 | 23 | - | - |
| 19 | Amount of Pt | 0 | 0.2 | 0.3 | 2 | 7 | 10 | 40 | 43 |
| | Total amount of additional elements | 50 | 50.2 | 50.3 | 52 | 57 | 60 | 90 | 93 |
| | 350°C | 18 | 18 | 18 | 20 | 23 | 26 | - | - |
| | 400°C | 16 | 16 | 16 | 18 | 21 | 24 | - | - |
| 22 | Amount of Pt | 0 | 0.2 | 0.3 | 2 | 7 | 10 | 37 | 40 |
| | Total amount of additional elements | 53 | 53.2 | 53.3 | 55 | 60 | 63 | 90 | 93 |
| | 350°C | 18 | 18 | 19 | 21 | 24 | 28 | - | - |
| | 400°C | 17 | 17 | 17 | 19 | 21 | 25 | - | - |

TABLE 15

| (Ta = 0, N = 1) | | | | | | | | | |
|---|---|---|---|---|---|---|---|---|---|
| Amount of Mn | | | | | | | | | |
| 0 | Amount of Pt | 0 | 0.2 | 0.3 | 3 | 15 | 29 | 59 | 62 |
| | Total amount of additional elements | 1 | 1.2 | 1.3 | 4 | 16 | 30 | 60 | 63 |
| | 350°C | 101 | 101 | 102 | 116 | 131 | 152 | 202 | 202 |
| | 400°C | 91 | 91 | 92 | 105 | 118 | 136 | 182 | 182 |
| 0.5 | Amount of Pt | 0 | 0.2 | 0.3 | 2.5 | 14.5 | 28.5 | 58.5 | 61.5 |
| | Total amount of additional elements | 1.5 | 1.7 | 1.8 | 4 | 16 | 30 | 60 | 63 |
| | 350°C | 100 | 100 | 101 | 115 | 130 | 150 | 200 | 200 |
| | 400°C | 90 | 90 | 91 | 103 | 117 | 135 | 180 | 180 |
| 1 | Amount of Pt | 0 | 0.2 | 0.3 | 2 | 14 | 28 | 58 | 61 |
| | Total amount of additional elements | 2 | 2.2 | 2.3 | 4 | 16 | 30 | 60 | 63 |
| | 350°C | 96 | 96 | 97 | 110 | 125 | 144 | 192 | 192 |
| | 400°C | 86 | 86 | 87 | 99 | 112 | 130 | 173 | 173 |
| 5 | Amount of Pt | 0 | 0.2 | 0.3 | 2 | 10 | 24 | 54 | 57 |
| | Total amount of additional elements | 6 | 62 | 6.3 | 8 | 16 | 30 | 60 | 63 |
| | 350°C | 91 | 91 | 92 | 105 | 118 | 136 | 182 | 182 |
| | 400°C | 82 | 82 | 83 | 94 | 106 | 123 | 164 | 164 |
| 8 | Amount of Pt | 0 | 0.2 | 0.3 | 2 | 7 | 21 | 51 | 54 |
| | Total amount of additional elements | 9 | 9.2 | 9.3 | 11 | 16 | 30 | 60 | 63 |
| | 350°C | 96 | 96 | 97 | 110 | 125 | 144 | 192 | 192 |
| | 400°C | 86 | 86 | 87 | 99 | 112 | 130 | 173 | 173 |
| 19 | Amount of Pt | 0 | 0.2 | 0.3 | 2 | 7 | 10 | 40 | 43 |
| | Total amount of additional elements | 20 | 20.2 | 20.3 | 22 | 27 | 30 | 60 | 63 |
| | 350°C | 99 | 99 | 100 | 114 | 129 | 148 | 198 | 198 |
| | 400°C | 89 | 89 | 90 | 102 | 116 | 134 | 178 | 178 |
| 22 | Amount of Pt | 0 | 0.2 | 0.3 | 2 | 7 | 10 | 37 | 40 |
| | Total amount of additional elements | 23 | 23.2 | 23.3 | 25 | 30 | 33 | 60 | 63 |
| | 350°C | 103 | 103 | 104 | 118 | 134 | 155 | 206 | 206 |
| | 400°C | 93 | 93 | 94 | 107 | 121 | 139 | 185 | 185 |

TABLE 16

| (Ta = 0, N = 10) | | | | | | | | | |
|---|---|---|---|---|---|---|---|---|---|
| Amount of Mn | | | | | | | | | |
| 0 | Amount of Pt | 0 | 0.2 | 0.3 | 3 | 15 | 29 | 59 | 62 |
| | Total amount of additional elements | 10 | 10.2 | 10.3 | 13 | 25 | 39 | 69 | 72 |
| | 350°C | 62 | 62 | 63 | 71 | 81 | 93 | - | - |
| | 400°C | 56 | 56 | 56 | 64 | 73 | 84 | - | - |
| 0.5 | Amount of Pt | 0 | 0.2 | 0.3 | 2.5 | 14.5 | 28.5 | 58.5 | 61.5 |
| | Total amount of additional elements | 10.5 | 10.7 | 10.8 | 13 | 25 | 39 | 69 | 72 |
| | 350°C | 61 | 61 | 62 | 71 | 80 | 92 | - | - |
| | 400°C | 55 | 55 | 56 | 64 | 72 | 83 | - | - |
| 1 | Amount of Pt | 0 | 0.2 | 0.3 | 2 | 14 | 28 | 58 | 61 |
| | Total amount of additional elements | 11 | 11.2 | 11.3 | 13 | 25 | 39 | 69 | 72 |
| | 350°C | 59 | 59 | 59 | 68 | 77 | 88 | - | - |
| | 400°C | 53 | 53 | 54 | 61 | 69 | 80 | - | - |
| 5 | Amount of Pt | 0 | 0.2 | 0.3 | 2 | 10 | 24 | 54 | 57 |
| | Total amount of additional elements | 15 | 15.2 | 15.3 | 17 | 25 | 39 | 69 | 72 |
| | 350°C | 56 | 56 | 56 | 64 | 73 | 84 | - | - |
| | 400°C | 50 | 50 | 51 | 58 | 65 | 75 | - | - |
| 8 | Amount of Pt | 0 | 0.2 | 0.3 | 2 | 7 | 21 | 51 | 54 |
| | Total amount of additional elements | 18 | 18.2 | 18.3 | 20 | 25 | 39 | 69 | 72 |
| | 350°C | 59 | 59 | 59 | 68 | 77 | 88 | - | - |
| | 400°C | 53 | 53 | 54 | 61 | 69 | 80 | - | - |
| 19 | Amount of Pt | 0 | 0.2 | 0.3 | 2 | 7 | 10 | 40 | 43 |
| | Total amount of additional elements | 29 | 29.2 | 29.3 | 31 | 36 | 39 | 69 | 72 |
| | 350°C | 61 | 61 | 61 | 70 | 79 | 91 | - | - |
| | 400°C | 55 | 55 | 55 | 63 | 71 | 82 | - | - |
| 22 | Amount of Pt | 0 | 0.2 | 0.3 | 2 | 7 | 10 | 37 | 40 |
| | Total amount of additional elements | 32 | 32.2 | 32.3 | 34 | 39 | 42 | 69 | 72 |
| | 350°C | 63 | 63 | 64 | 73 | 82 | 95 | - | - |
| | 400°C | 57 | 57 | 57 | 65 | 74 | 85 | - | - |

TABLE 17

| (Ta = 0, N = 19) | | | | | | | | | |
|---|---|---|---|---|---|---|---|---|---|
| Amount of Mn | | | | | | | | | |
| 0 | Amount of Pt | 0 | 0.2 | 0.3 | 3 | 15 | 29 | 59 | 62 |
| | Total amount of additional elements | 19 | 19.2 | 19.3 | 22 | 34 | 48 | 78 | 81 |
| | 350°C | 25 | 25 | 25 | 29 | 33 | 38 | - | - |
| | 400°C | 23 | 23 | 23 | 26 | 29 | 34 | - | - |
| 0.5 | Amount of Pt | 0 | 0.2 | 0.3 | 2.5 | 14.5 | 28.5 | 58.5 | 61.5 |
| | Total amount of additional elements | 19.5 | 19.7 | 19.8 | 22 | 34 | 48 | 78 | 81 |
| | 350°C | 25 | 25 | 25 | 28 | 32 | 37 | - | - |
| | 400°C | 22 | 22 | 22 | 26 | 29 | 33 | - | - |
| 1 | Amount of Pt | 0 | 0.2 | 0.3 | 2 | 14 | 28 | 58 | 61 |
| | Total amount of additional elements | 20 | 20.2 | 20.3 | 22 | 34 | 48 | 78 | 81 |
| | 350°C | 24 | 24 | 24 | 27 | 31 | 36 | - | - |
| | 400°C | 21 | 21 | 22 | 25 | 28 | 32 | - | - |
| 5 | Amount of Pt | 0 | 0.2 | 0.3 | 2 | 10 | 24 | 54 | 57 |
| | Total amount of additional elements | 24 | 24.2 | 24.3 | 26 | 34 | 48 | 78 | 81 |
| | 350°C | 23 | 23 | 23 | 26 | 29 | 34 | - | - |
| | 400°C | 20 | 20 | 20 | 23 | 26 | 30 | - | - |
| 8 | Amount of Pt | 0 | 0.2 | 0.3 | 2 | 7 | 21 | 51 | 54 |
| | Total amount of additional elements | 27 | 27.2 | 27.3 | 29 | 34 | 48 | 78 | 81 |
| | 350°C | 24 | 24 | 24 | 27 | 31 | 36 | - | - |
| | 400°C | 21 | 21 | 22 | 25 | 28 | 32 | - | - |
| 19 | Amount of Pt | 0 | 0.2 | 0.3 | 2 | 7 | 10 | 40 | 43 |
| | Total amount of additional elements | 38 | 38.2 | 38.3 | 40 | 45 | 48 | 78 | 81 |
| | 350°C | 25 | 25 | 25 | 28 | 32 | 37 | - | - |
| | 400°C | 22 | 22 | 22 | 25 | 29 | 33 | - | - |
| 22 | Amount of Pt | 0 | 0.2 | 0.3 | 2 | 7 | 10 | 37 | 40 |
| | Total amount of additional elements | 41 | 41.2 | 41.3 | 43 | 48 | 51 | 78 | 81 |
| | 350°C | 26 | 26 | 26 | 29 | 33 | 38 | - | - |
| | 400°C | 23 | 23 | 23 | 26 | 30 | 34 | - | - |

TABLE 18

| (Ta = 0, N = 21) | | | | | | | | | |
|---|---|---|---|---|---|---|---|---|---|
| Amount of Mn | | | | | | | | | |
| 0 | Amount of Pt | 0 | 0.2 | 0.3 | 3 | 15 | 29 | 59 | 62 |
| | Total amount of additional elements | 21 | 21.2 | 21.3 | 24 | 36 | 50 | 80 | 83 |
| | 350°C | 21 | 21 | 21 | 24 | 27 | 32 | - | - |
| | 400°C | 19 | 19 | 19 | 22 | 25 | 28 | - | - |
| 0.5 | Amount of Pt | 0 | 0.2 | 0.3 | 2.5 | 14.5 | 28.5 | 58.5 | 61.5 |
| | Total amount of additional elements | 21.5 | 21.7 | 21.8 | 24 | 36 | 50 | 80 | 83 |
| | 350°C | 21 | 21 | 21 | 24 | 27 | 31 | - | - |
| | 400°C | 19 | 19 | 19 | 22 | 24 | 28 | - | - |
| 1 | Amount of Pt | 0 | 0.2 | 0.3 | 2 | 14 | 28 | 58 | 61 |
| | Total amount of additional elements | 22 | 22.2 | 22.3 | 24 | 36 | 50 | 80 | 83 |
| | 350°C | 20 | 20 | 20 | 23 | 26 | 30 | - | - |
| | 400°C | 18 | 18 | 18 | 21 | 23 | 27 | - | - |
| 5 | Amount of Pt | 0 | 0.2 | 0.3 | 2 | 10 | 24 | 54 | 57 |
| | Total amount of additional elements | 26 | 26.2 | 26.3 | 28 | 36 | 50 | 80 | 83 |
| | 350°C | 19 | 19 | 19 | 22 | 25 | 28 | - | - |
| | 400°C | 17 | 17 | 17 | 20 | 22 | 26 | - | - |
| 8 | Amount of Pt | 0 | 0.2 | 0.3 | 2 | 7 | 21 | 51 | 54 |
| | Total amount of additional elements | 29 | 29.2 | 29.3 | 31 | 36 | 50 | 80 | 83 |
| | 350°C | 20 | 20 | 20 | 23 | 26 | 30 | - | - |
| | 400°C | 18 | 18 | 18 | 21 | 23 | 27 | - | - |
| 19 | Amount of Pt | 0 | 0.2 | 0.3 | 2 | 7 | 10 | 40 | 43 |
| | Total amount of additional elements | 40 | 40.2 | 40.3 | 42 | 47 | 50 | 80 | 83 |
| | 350°C | 21 | 21 | 21 | 24 | 27 | 31 | - | - |
| | 400°C | 19 | 19 | 19 | 21 | 24 | 28 | - | - |
| 22 | Amount of Pt | 0 | 0.2 | 0.3 | 2 | 7 | 10 | 37 | 40 |
| | Total amount of additional elements | 43 | 43.2 | 43.3 | 45 | 50 | 53 | 80 | 83 |
| | 350°C | 21 | 21 | 22 | 25 | 28 | 32 | - | - |
| | 400°C | 19 | 19 | 19 | 22 | 25 | 29 | - | - |

TABLE 19

| (Ta = 3, N = 2) | | | | | | | | | |
|---|---|---|---|---|---|---|---|---|---|
| Amount of Mn | | | | | | | | | |
| 0 | Amount of Pt | 0 | 0.2 | 0.3 | 3 | 15 | 29 | 59 | 62 |
| | Total amount of additional elements | 5 | 5.2 | 5.3 | 8 | 20 | 34 | 64 | 67 |
| | 350°C | 79 | 79 | 80 | 91 | 103 | 119 | 158 | 158 |
| | 400°C | 71 | 71 | 72 | 82 | 92 | 107 | 142 | 142 |
| 0.5 | Amount of Pt | 0 | 0.2 | 0.3 | 2.5 | 14.5 | 28.5 | 58.5 | 61.5 |
| | Total amount of additional elements | 5.5 | 5.7 | 5.8 | 8 | 20 | 34 | 64 | 67 |
| | 350°C | 78 | 78 | 79 | 90 | 102 | 117 | 156 | 156 |
| | 400°C | 70 | 70 | 71 | 81 | 92 | 106 | 141 | 141 |
| 1 | Amount of Pt | 0 | 0.2 | 0.3 | 2 | 14 | 28 | 58 | 61 |
| | Total amount of additional elements | 6 | 6.2 | 6.3 | 8 | 20 | 34 | 64 | 67 |
| | 350°C | 75 | 75 | 76 | 86 | 98 | 113 | 150 | 150 |
| | 400°C | 68 | 68 | 68 | 78 | 88 | 101 | 135 | 135 |
| 5 | Amount of Pt | 0 | 0.2 | 0.3 | 2 | 10 | 24 | 54 | 57 |
| | Total amount of additional elements | 10 | 10.2 | 10.3 | 12 | 20 | 34 | 64 | 67 |
| | 350°C | 71 | 71 | 72 | 82 | 92 | 107 | 142 | 142 |
| | 400°C | 64 | 64 | 65 | 74 | 83 | 96 | 128 | 128 |
| 8 | Amount of Pt | 0 | 0.2 | 0.3 | 2 | 7 | 21 | 51 | 54 |
| | Total amount of additional elements | 13 | 13.2 | 13.3 | 15 | 20 | 34 | 64 | 67 |
| | 350°C | 75 | 75 | 76 | 86 | 98 | 113 | 150 | 150 |
| | 400°C | 68 | 68 | 68 | 78 | 88 | 101 | 135 | 135 |
| 19 | Amount of Pt | 0 | 0.2 | 0.3 | 2 | 7 | 10 | 40 | 43 |
| | Total amount of additional elements | 24 | 24.2 | 24.3 | 26 | 31 | 34 | 64 | 67 |
| | 350°C | 77 | 77 | 78 | 89 | 101 | 116 | 155 | 155 |
| | 400°C | 70 | 70 | 70 | 80 | 91 | 105 | 139 | 139 |
| 22 | Amount of Pt | 0 | 0.2 | 0.3 | 2 | 7 | 10 | 37 | 40 |
| | Total amount of additional elements | 27 | 27.2 | 27.3 | 29 | 34 | 37 | 64 | 67 |
| | 350°C | 81 | 81 | 81 | 93 | 105 | 121 | 161 | 161 |
| | 400°C | 73 | 73 | 73 | 83 | 94 | 109 | 145 | 145 |

TABLE 20

| (Ta = 14, N = 7) | | | | | | | | | |
|---|---|---|---|---|---|---|---|---|---|
| Amount of Mn | | | | | | | | | |
| 0 | Amount of Pt | 0 | 0.2 | 0.3 | 3 | 15 | 29 | 59 | 62 |
| | Total amount of additional elements | 21 | 21.2 | 21.3 | 24 | 36 | 50 | 80 | 83 |
| | 350°C | 38 | 38 | 38 | 44 | 49 | 57 | - | - |
| | 400°C | 34 | 34 | 35 | 39 | 44 | 51 | - | - |
| 0.5 | Amount of Pt | 0 | 0.2 | 0.3 | 2.5 | 14.5 | 28.5 | 58.5 | 61.5 |
| | Total amount of additional elements | 21.5 | 21.7 | 21.8 | 24 | 36 | 50 | 80 | 83 |
| | 350°C | 38 | 38 | 38 | 43 | 49 | 56 | - | - |
| | 400°C | 34 | 34 | 34 | 39 | 44 | 51 | - | - |
| 1 | Amount of Pt | 0 | 0.2 | 0.3 | 2 | 14 | 28 | 58 | 61 |
| | Total amount of additional elements | 22 | 22.2 | 22.3 | 24 | 36 | 50 | 80 | 83 |
| | 350°C | 36 | 36 | 36 | 42 | 47 | 54 | - | - |
| | 400°C | 32 | 32 | 33 | 37 | 42 | 49 | - | - |
| 5 | Amount of Pt | 0 | 0.2 | 0.3 | 2 | 10 | 24 | 54 | 57 |
| | Total amount of additional elements | 26 | 26.2 | 26.3 | 28 | 36 | 50 | 80 | 83 |
| | 350°C | 34 | 34 | 35 | 39 | 44 | 51 | - | - |
| | 400°C | 31 | 31 | 31 | 35 | 40 | 46 | - | - |
| 8 | Amount of Pt | 0 | 0.2 | 0.3 | 2 | 7 | 21 | 51 | 54 |
| | Total amount of additional elements | 29 | 29.2 | 29.3 | 31 | 36 | 50 | 80 | 83 |
| | 350°C | 36 | 36 | 36 | 42 | 47 | 54 | - | - |
| | 400°C | 32 | 32 | 33 | 37 | 42 | 49 | - | - |
| 19 | Amount of Pt | 0 | 0.2 | 0.3 | 2 | 7 | 10 | 40 | 43 |
| | Total amount of additional elements | 40 | 40.2 | 40.3 | 42 | 47 | 50 | 80 | 83 |
| | 350°C | 37 | 37 | 38 | 43 | 48 | 56 | - | - |
| | 400°C | 34 | 34 | 34 | 39 | 44 | 50 | - | - |
| 22 | Amount of Pt | 0 | 0.2 | 0.3 | 2 | 7 | 10 | 37 | 40 |
| | Total amount of additional elements | 43 | 43.2 | 43.3 | 45 | 50 | 53 | 80 | 83 |
| | 350°C | 39 | 39 | 39 | 45 | 50 | 58 | - | - |
| | 400°C | 35 | 35 | 35 | 40 | 45 | 52 | - | - |

TABLE 21

| (Ta = 29, N = 19) | | | | | | | | | |
|---|---|---|---|---|---|---|---|---|---|
| Amount of Mn | | | | | | | | | |
| 0 | Amount of Pt | 0 | 0.2 | 0.3 | 3 | 15 | 29 | 59 | 62 |
| | Total amount of additional elements | 48 | 48.2 | 48.3 | 51 | 63 | 77 | 107 | 110 |
| | 350°C | 5 | 5 | 5 | 6 | 7 | - | - | - |
| | 400°C | 5 | 5 | 5 | 5 | 6 | - | - | - |
| 0.5 | Amount of Pt | 0 | 0.2 | 0.3 | 2.5 | 14.5 | 28.5 | 58.5 | 61.5 |
| | Total amount of additional elements | 48.5 | 48.7 | 48.8 | 51 | 63 | 77 | 107 | 110 |
| | 350°C | 5 | 5 | 5 | 6 | 6 | - | - | - |
| | 400°C | 4 | 4 | 4 | 5 | 6 | - | - | - |
| 1 | Amount of Pt | 0 | 0.2 | 0.3 | 2 | 14 | 28 | 58 | 61 |
| | Total amount of additional elements | 49 | 49.2 | 49.3 | 51 | 63 | 77 | 107 | 110 |
| | 350°C | 5 | 5 | 5 | 5 | 6 | - | - | - |
| | 400°C | 4 | 4 | 4 | 5 | 6 | - | - | - |
| 5 | Amount of Pt | 0 | 0.2 | 0.3 | 2 | 10 | 24 | 54 | 57 |
| | Total amount of additional elements | 53 | 53.2 | 53.3 | 55 | 63 | 77 | 107 | 110 |
| | 350°C | 5 | 5 | 5 | 5 | 6 | - | - | - |
| | 400°C | 4 | 4 | 4 | 5 | 5 | - | - | - |
| 8 | Amount of Pt | 0 | 0.2 | 0.3 | 2 | 7 | 21 | 51 | 54 |
| | Total amount of additional elements | 56 | 56.2 | 56.3 | 58 | 63 | 77 | 107 | 110 |
| | 350°C | 5 | 5 | 5 | 5 | 6 | - | - | - |
| | 400°C | 4 | 4 | 4 | 5 | 6 | - | - | - |
| 19 | Amount of Pt | 0 | 0.2 | 0.3 | 2 | 7 | 10 | 40 | 43 |
| | Total amount of additional elements | 67 | 67.2 | 67.3 | 69 | 74 | 77 | 107 | 110 |
| | 350°C | 5 | 5 | 5 | 6 | - | - | - | - |
| | 400°C | 4 | 4 | 4 | 5 | - | - | - | - |
| 22 | Amount of Pt | 0 | 0.2 | 0.3 | 2 | 7 | 10 | 37 | 40 |
| | Total amount of additional elements | 70 | 70.2 | 70.3 | 72 | 77 | 80 | 107 | 110 |
| | 350°C | 5 | 5 | 5 | - | - | - | - | - |
| | 400°C | 5 | 5 | 5 | - | - | - | - | - |

TABLE 22

| (Ta = 31, N = 21) | | | | | | | | | |
|---|---|---|---|---|---|---|---|---|---|
| Amount of Mn | | | | | | | | | |
| 0 | Amount of Pt | 0 | 0.2 | 0.3 | 3 | 15 | 29 | 59 | 62 |
| | Total amount of additional elements | 52 | 52.2 | 52.3 | 55 | 67 | 81 | 111 | 114 |
| | 350°C | 5 | 5 | 5 | 5 | 6 | - | - | — |
| | 400°C | 4 | 4 | 4 | 5 | 5 | - | — | — |
| 0.5 | Amount of Pt | 0 | 0.2 | 0.3 | 2.5 | 14.5 | 28.5 | 58.5 | 61.5 |
| | Total amount of additional elements | 52.5 | 52.7 | 52.8 | 55 | 67 | 81 | 111 | 114 |
| | 350°C | 4 | 4 | 4 | 5 | 6 | - | - | - |
| | 400°C | 4 | 4 | 4 | 5 | 5 | - | - | - |
| 1 | Amount of Pt | 0 | 0.2 | 0.3 | 2 | 14 | 28 | 58 | 61 |
| | Total amount of additional elements | 53 | 53.2 | 53.3 | 55 | 67 | 81 | 111 | 114 |
| | 350°C | 4 | 4 | 4 | 5 | 6 | - | - | - |
| | 400°C | 4 | 4 | 4 | 4 | 5 | - | | |
| 5 | Amount of Pt | 0 | 0.2 | 0.3 | 2 | 10 | 24 | 54 | 57 |
| | Total amount of additional elements | 57 | 57.2 | 57.3 | 59 | 67 | 81 | 111 | 114 |
| | 350°C | 4 | 4 | 4 | 5 | 5 | - | - | - |
| | 400°C | 4 | 4 | 4 | 4 | 5 | - | - | - |
| 8 | Amount of Pt | 0 | 0.2 | 0.3 | 2 | 7 | 21 | 51 | 54 |
| | Total amount of additional elements | 60 | 60.2 | 60.3 | 62 | 67 | 81 | 111 | 114 |
| | 350°C | 4 | 4 | 4 | 5 | 6 | - | - | - |
| | 400°C | 4 | 4 | 4 | 4 | 5 | - | - | - |
| 19 | Amount of Pt | 0 | 0.2 | 0.3 | 2 | 7 | 10 | 40 | 43 |
| | Total amount of additional elements | 71 | 71.2 | 71.3 | 73 | 78 | 81 | 111 | 114 |
| | 350°C | - | - | - | - | - | - | - | - |
| | 400°C | - | - | - | - | - | - | - | - |
| 22 | Amount of Pt | 0 | 0.2 | 0.3 | 2 | 7 | 10 | 37 | 40 |
| | Total amount of additional elements | 74 | 74.2 | 74.3 | 76 | 81 | 84 | 111 | 114 |
| | 350°C | - | - | - | - | - | - | - | - |
| | 400°C | - | - | - | - | - | - | - | - |

**Claims**

1.  A magnetoresistive element comprising:

    a substrate; and
    a multi-layer film formed on the substrate,
    the multi-layer film comprising a pair of ferromagnetic layers and a non-magnetic layer sandwiched between the pair of ferromagnetic layers,

    wherein a resistance value depends on a relative angle formed by magnetization directions of the pair of ferromagnetic layers,
    wherein the magnetoresistive element is produced by a method comprising heat treatment of the substrate and the multi-layer film at 330°C or more, and
    wherein when a centerline is defined so as to divide the non-magnetic layer into equal parts in a thickness direction, the longest distance from the centerline to interfaces between the pair of ferromagnetic layers and the non-magnetic layer is not more than 20 nm,
    where the longest distance is determined by defining ten centerlines, each of which has a length of 50 nm, measuring distances from the ten centerlines to the interfaces so as to find the longest distance for each of the ten centerlines, taking eight values excluding the maximum and the minimum values from the ten longest distances, and calculating an average of the eight values.

2.  The magnetoresistive element according to claim 1, wherein the substrate is a single-crystal substrate.

3.  The magnetoresistive element according to claim 1, wherein the non-magnetic layer is a tunnel insulating layer.

4.  The magnetoresistive element according to claim 1, the multi-layer film further comprises a pair of electrodes that are arranged so as to sandwich the pair of ferromagnetic layers.

5.  The magnetoresistive element according to claim 1, wherein the longest distance is not more than 3 nm.

6.  The magnetoresistive element according to claim 1, wherein a composition in a range that extends by 2 nm from at least one of the interfaces in a direction opposite to the non-magnetic layer is expressed by

$$(Fe_xCo_yNi_z)_pM^1_qM^2_rM^3_sA_t$$

where $M^1$ is at least one element selected from the group consisting of Tc, Re, Ru, Os, Rh, Ir, Pd, Pt, Cu, Ag and Au, $M^2$ is at least one element selected from the group consisting of Mn and Cr, $M^3$ is at least one element selected from the group consisting of Ti, Zr, Hf, V, Nb, Ta, Mo, W, Al, Si, Ga, Ge, In and Sn, A is at least one element selected from the group consisting of B, C, N, O, P and S, and x, y, z, p, q, r, s, and t satisfy the following formulas:

$$0 \leq x \leq 100,$$

$$0 \leq y \leq 100,$$

$$0 \leq z \leq 100,$$

$$x + y + z = 100,$$

$$40 \leq p \leq 99.7,$$

$$0.3 \leq q \leq 60,$$

$$0 \leq r \leq 20,$$

$$0 \leq s \leq 30,$$

$$0 \leq t \leq 20,$$

and

$$p + q + r + s + t = 100.$$

**7.** The magnetoresistive element according to claim 6, wherein p, q, and r satisfy $p + q + r = 100$.

**8.** The magnetoresistive element according to claim 7, wherein p and q satisfy $p + q = 100$.

**9.** The magnetoresistive element according to claim 1, wherein the multi-layer film further comprises an antiferromagnetic layer.

**10.** The magnetoresistive element according to claim 9, wherein a distance between the non-magnetic layer and the antiferromagnetic layer is 3 nm to 50 nm.

**11.** A magnetoresistive element comprising:

a substrate; and
a multi-layer film formed on the substrate,
the multi-layer film comprising a pair of ferromagnetic layers and a non-magnetic layer sandwiched between the pair of ferromagnetic layers,

wherein a resistance value depends on a relative angle formed by magnetization directions of the pair of ferromagnetic layers,
wherein the magnetoresistive element is produced by a method comprising heat treatment of the substrate and the multi-layer film at 330°C or more, and
wherein a composition in a range that extends by 2 nm from at least one of interfaces between the pair of ferromagnetic layers and the non-magnetic layer in a direction opposite to the non-magnetic layer is expressed by

$$(Fe_xCo_yNi_z)pM^1qM^2rM^3sAt$$

where $M^1$ is at least one element selected from the group consisting of Tc, Re, Ru, Os, Rh, Ir, Pd, Pt, Cu, Ag and Au, $M^2$ is at least one element selected from the group consisting of Mn and Cr, $M^3$ is at least one element selected from the group consisting of Ti, Zr, Hf, V, Nb, Ta, Mo, W, Al, Si, Ga, Ge, In and Sn, A is at least one element selected from the group consisting of B, C, N, O, P and S, and x, y, z, p, q, r, s, and t satisfy the following formulas:

$$0 \leq x \leq 100,$$

$$0 \leq y \leq 100,$$

$$0 \leq z \leq 100,$$

$$x + y + z = 100,$$

$$40 \leq p \leq 99.7,$$

$$0.3 \leq q \leq 60,$$

$$0 \leq r \leq 20,$$

$$0 \leq s \leq 30,$$

$$0 \leq t \leq 20,$$

and

$$p + q + r + s + t = 100.$$

**12.** A method for manufacturing a magnetoresistive element,
the magnetoresistive element comprising a substrate and a multi-layer film formed on the substrate, the multi-layer film comprising a pair of ferromagnetic layers and a non-magnetic layer sandwiched between the pair of ferromagnetic layers, wherein a resistance value depends on a relative angle formed by magnetization directions of the pair of ferromagnetic layers,
the method comprising:

forming a part of the multi-layer film other than the ferromagnetic layers and the non-magnetic layer on the substrate as an underlying film;
heat-treating the underlying film at 400°C or more;
decreasing roughness of a surface of the underlying film by irradiating the surface with an ion beam;
forming the remaining part of the multi-layer film including the ferromagnetic layers and the non-magnetic layer on the surface; and
heat-treating the substrate and the multi-layer film at 330°C or more.

**13.** The method according to claim 12, wherein the surface of the underlying film is irradiated with the ion beam so that an angle of incidence of the ion beam at the surface is 5° to 25°.

**14.** The method according to claim 12, wherein a lower electrode and an upper electrode are formed as a portion of the multi-layer film, and the lower electrode is included in the underlying film.

FIG. 1A

R

21

15

14

13

50nm

22

FIG. 1B

10    21

15

14

13

50nm

22

FIG. 1C

21

15

10    Qi    L

Pi                14

20

Ri

13

22

FIG. 2

FIG. 3

FIG. 4

FIG. 5

FIG. 6

FIG. 7

FIG. 8

FIG. 9

FIG. 10

FIG. 11

(a)

Composition 1 — 5
Composition 2
Composition 3
Composition 4 — 4
Composition 5 — 3
Composition 6

FIG. 12A

(b)

Composition 1 — 5
Composition 2
Composition 3
Composition 4 — 4
Composition 5 — 3
Composition 6
— 8

FIG. 12B

(c)

Composition 1 — 5
Composition 2
Composition 3
Composition 4 — 4
Composition 5 — 53
— 52 } 3
Composition 6 — 51
— 8

FIG. 12C

(d)

Composition 1 — 5
Composition 2
Composition 3
Composition 4 — 4
Composition 5 — 3
Composition 6
Composition 7 — 34
Composition 8 — 3
Composition 9

FIG. 12D

<table>
<tr><td colspan="2"><strong>INTERNATIONAL SEARCH REPORT</strong></td><td>International application No.<br>PCT/JP02/06344</td></tr>
</table>

**A. CLASSIFICATION OF SUBJECT MATTER**
Int.Cl⁷  H01L43/08, H01L43/12, G11B5/39, G01R33/09 H01F10/16,
H01F10/30, H01F10/32

According to International Patent Classification (IPC) or to both national classification and IPC

**B. FIELDS SEARCHED**

Minimum documentation searched (classification system followed by classification symbols)
Int.Cl⁷  H01L43/08, H01L43/12, G11B5/39, G01R33/09 H01F10/16,
H01F10/30, H01F10/32

Documentation searched other than minimum documentation to the extent that such documents are included in the fields searched

| | | | |
|---|---|---|---|
| Jitsuyo Shinan Koho | 1922–1996 | Jitsuyo Shinan Toroku Koho | 1996–2002 |
| Kokai Jitsuyo Shinan Koho | 1971–2002 | Toroku Jitsuyo Shinan Koho | 1994–2002 |

Electronic data base consulted during the international search (name of data base and, where practicable, search terms used)
JICST FILE

**C. DOCUMENTS CONSIDERED TO BE RELEVANT**

| Category* | Citation of document, with indication, where appropriate, of the relevant passages | Relevant to claim No. |
|---|---|---|
| X<br>Y<br>A | JP 9-23031 A  (Alps Electric Co., Ltd.),<br>21 January, 1997 (21.01.97),<br>Full text<br>(Family: none) | 1,2,5,8<br>3,4,9,10<br>6,7,11,12 |
| Y | JP 2000-101164 A  (NEC Corp.),<br>07 April, 2000 (07.04.00),<br>Full text<br>(Family: none) | 3,4,10 |
| A | JP 2000-91665 A  (NEC Corp.),<br>31 March, 2000 (31.03.00),<br>Full text<br>(Family: none) | 1-12 |

☐ Further documents are listed in the continuation of Box C.  ☐ See patent family annex.

| | |
|---|---|
| * Special categories of cited documents:<br>"A" document defining the general state of the art which is not considered to be of particular relevance<br>"E" earlier document but published on or after the international filing date<br>"L" document which may throw doubts on priority claim(s) or which is cited to establish the publication date of another citation or other special reason (as specified)<br>"O" document referring to an oral disclosure, use, exhibition or other means<br>"P" document published prior to the international filing date but later than the priority date claimed | "T" later document published after the international filing date or priority date and not in conflict with the application but cited to understand the principle or theory underlying the invention<br>"X" document of particular relevance; the claimed invention cannot be considered novel or cannot be considered to involve an inventive step when the document is taken alone<br>"Y" document of particular relevance; the claimed invention cannot be considered to involve an inventive step when the document is combined with one or more other such documents, such combination being obvious to a person skilled in the art<br>"&" document member of the same patent family |

| Date of the actual completion of the international search<br>07 October, 2002 (07.10.02) | Date of mailing of the international search report<br>22 October, 2002 (22.10.02) |
|---|---|
| Name and mailing address of the ISA/<br>Japanese Patent Office | Authorized officer |
| Facsimile No. | Telephone No. |

Form PCT/ISA/210 (second sheet) (July 1998)